# EUROPEAN PATENT APPLICATION

(11) **EP 4 137 497 A1**
(43) Date of publication of application: **22.02.2023**
(21) Application number: 21789006.0
(22) Date of filing: 13.04.2021
(51) Int. Cl.: C07F 5/02, H01L 51/00, H01L 51/50, H01L 51/52, H01L 27/32

(54) **NOVEL BORON COMPOUND AND ORGANIC LIGHT-EMITTING ELEMENT COMPRISING SAME**

(30) Priority: 16.04.2020 KR 20200046225
(71) Applicant: SFC Co., Ltd., Cheongju-si, Chungcheongbuk-do 28122 (KR)
(72) Inventor: KIM, Myeong-Jun, Cheongju-si Chungcheongbuk-do 28122 (KR); LEE, Se-Jin, Cheongju-si Chungcheongbuk-do 28122 (KR); CHOI, Yeong-Tae, Cheongju-si Chungcheongbuk-do 28122 (KR); KIM, Ji-Yung, Cheongju-si Chungcheongbuk-do 28122 (KR); KIM, Kyungtae, Cheongju-si Chungcheongbuk-do 28122 (KR); KIM, Kyeong-Hyeon, Cheongju-si Chungcheongbuk-do 28122 (KR)
(74) Representative: Epping - Hermann - Fischer
(86) International application number: PCT/KR2021/004654
(87) International publication number: WO 2021/210894

(57) **Abstract**

The present disclosure relates to a boron compound useful in an organic light-emitting diode and an organic light-emitting diode comprising same and, more particularly, to a boron compound represented by any one of [Chemical Formula A] to [Chemical Formula E], wherein [Chemical Formula A] to [Chemical Formula E] is as defined in the description.

## Description

### Technical Field

The present disclosure relates to a novel boron compound useful for an organic light-emitting diode and an organic light-emitting diode including same and, more particularly, to a novel boron compound that can be used as a dopant material in an organic light-emitting diode and allow for excellent diode characteristics including high luminous efficiency and low driving voltage, and an organic light-emitting diode including the boron compound.

### Background Art

Organic light-emitting diodes (OLEDs), based on self-luminescence, are used to create digital displays with the advantage of having a wide viewing angle and being able to be made thinner and lighter than liquid crystal displays. In addition, an OLED display exhibits a very fast response time. Accordingly, OLEDs find applications in the full color display field or the illumination field.

In general, the term "organic light-emitting phenomenon" refers to a phenomenon in which electrical energy is converted to light energy by means of an organic material. An organic light-emitting diode using the organic light-emitting phenomenon has a structure usually including an anode, a cathode, and an organic material layer interposed therebetween. In this regard, the organic material layer may have, for the most part, a multilayer structure consisting of different materials, for example, a hole injection layer, a hole transport layer, a light-emitting layer, an electron transport layer, and an electron injection layer in order to enhance the efficiency and stability of the organic light-emitting diode. In the organic light-emitting diode having such a structure, application of a voltage between the two electrodes injects a hole from the anode and an electron from the cathode to the organic layer. In the luminescent zone, the hole and the electron recombine to produce an exciton. When the exciton returns to the ground state from the excited state, the molecule of the organic layer emits light. Such an organic light-emitting diode is known to have characteristics such as self-luminescence, high luminance, high efficiency, low driving voltage, a wide viewing angle, high contrast, and high-speed response.

Materials used as organic layers in OLEDs may be divided according to functions into luminescent materials and charge transport materials, for example, a hole injection material, a hole transport material, an electron transport material, and an electron injection material.

As for the luminescent materials, there are two main families of OLED: those based on small molecules and those employing polymers. The light-emitting mechanism forms the basis of classification of luminescent materials as fluorescent and phosphorescent materials, which use excitons in singlet and triplet states, respectively.

When a single material is employed as the luminescent material, intermolecular actions cause the maximum luminescence wavelength to shift toward a longer wavelength, resulting in a reduction in color purity and luminous efficiency due to light attenuation. In this regard, a host-dopant system may be used as a luminescent material so as to increase the color purity and the luminous efficiency through energy transfer.

This is based on the principle whereby, when a dopant which is smaller in energy band gap than a host forming a light-emitting layer is added in a small amount to the light-emitting layer, excitons are generated from the light-emitting layer and transported to the dopant, emitting light at high efficiency. Here, light with desired wavelengths can be obtained depending on the kind of the dopant because the wavelength of the host moves to the wavelength range of the dopant.

Meanwhile, studies have been made to use boron compounds as dopant compounds. With regard to related art pertaining to the use of boron compounds, reference may be made to Korean Patent No. 10-2016-0119683 A (Oct. 14, 2016), which discloses an organic light-emitting diode employing a novel polycyclic aromatic compound in which multiple aromatic rings are connected via boron and oxygen atoms. In addition, International Patent No. WO 2017/188111 (Nov. 02, 2017) disclosed an organic light emitting diode in which a compound structured to connect multiple polycondensed aromatic rings via boron and nitrogen atoms is used as a dopant in a light emitting layer while an anthracene derivative is used as a host.

Despite a variety of kinds of compounds prepared for use in light emitting layers in organic light emitting diodes including the related arts, there is still a continuing need to develop a novel compound that allows an OLED to be stably driven at a lower voltage and exhibits high efficiency, and an OLED including the same.

### Disclosure

### Technical Problem

Therefore, an aspect of the present disclosure is to provide a boron compound having a novel structure which can be used as a dopant material in a light-emitting layer of an organic light-emitting diode.

In addition, another aspect of the present disclosure is to provide an organic light-emitting diode (OLED) having the boron compound applied as a dopant material therein and exhibiting excellent diode characteristics including high luminous efficiency and low-voltage driving.

### Technical Solution

In order to accomplish the purposes, the present disclosure provides a boron compound represented by any one of the following Chemical Formulas A to E: 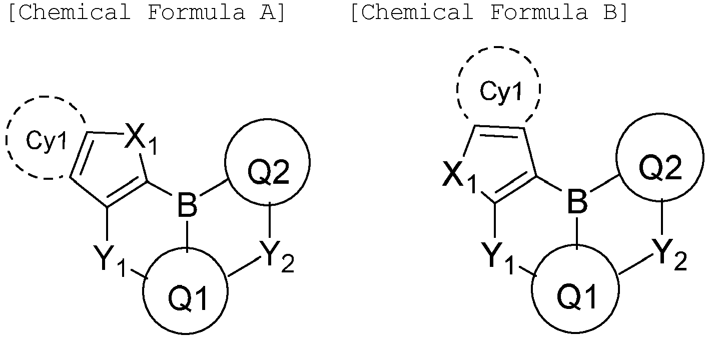 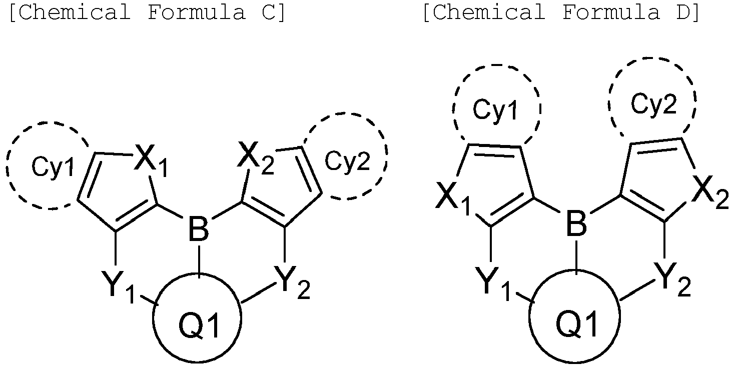 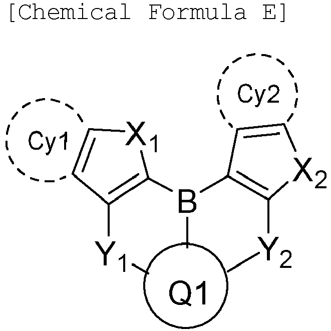 wherein,
X₁ is O, S, or NR₁,
X₂ is O, S, or NR₂,
Y₁ is any one selected from O, S, Se, NR₃, and CR₄R₅,
Y₂ is any one selected from O, S, Se, NR₆, and CR₇R₈,
Q₁ and Q₂, which may be same or different, are each independently a substituted or unsubstituted aromatic hydrocarbon ring of 6 to 50 carbon atoms, or a substituted or unsubstituted heteroaromatic ring of 2 to 50 carbon atoms,
the Q1 ring moiety having no amine radicals as substituents or including one amine radical represented by - NR₉R₁₀ as one substituent thereon,
the Q2 ring moiety having no amine radicals as substituents thereon or including one amine radical represented by -NR₁₁R₁₂ as a substituent thereon,
R₁ to R₈, which may be same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted cycloalkyl of 3 to 30 carbon atoms, a substituted or unsubstituted heteroaryl of 2 to 50 carbon atoms, a substituted or unsubstituted alkoxy of 1 to 30 carbon atoms, a substituted or unsubstituted aryloxy of 6 to 30 carbon atoms, a substituted or unsubstituted alkylthio of 1 to 30 carbon atoms, a substituted or unsubstituted arylthio of 5 to 30 carbon atoms, a substituted or unsubstituted alkylamine of 1 to 30 carbon atoms, a substituted or unsubstituted arylamine of 5 to 30 carbon atoms, a substituted or unsubstituted alkylsilyl of 1 to 30 carbon atoms, a substituted or unsubstituted arylsilyl of 5 to 30 carbon atoms, a nitro, a cyano, and a halogen,
R₉ to R₁₂, which may be same or different, are each independently selected from a Hydrogen atom, a deuterium atom, a substituted or unsubstituted alkyl of 1 to 30 carbon atoms, a substituted or unsubstituted aryl of 6 to 50 carbon atoms, a substituted or unsubstituted cycloalkyl of 3 to 30 carbon atoms, and a substituted or unsubstituted heteroaryl of 2 to 50 carbon atoms,
R₉ and R₁₀ may be bonded to each other to additionally form an aliphatic or aromatic mono- or polycyclic ring, and R₁₁ and R₁₂ may be bonded to each other to additionally form an aliphatic or aromatic mono- or polycyclic ring,
R₃ to R₅ and R₆ to R₈ may each independently bonded to the Q1 ring moiety to additionally form an aliphatic or aromatic mono- or polycyclic ring,
R₄ and R₅ may be boned to each other to additionally form an aliphatic or aromatic mono- or polycyclic ring,
R₇ and R₈ may be bonded to each other to additionally an aliphatic or aromatic mono- or polycyclic ring,
the ring accounted for by Cy1 includes a substituted or unsubstituted alkylene of 1 to 10 carbon atoms as a ring constituent except for the two carbon atoms as ring members of the unsaturated pentagonal ring bearing X₁,
the ring accounted for by Cy2 includes a substituted or unsubstituted alkylene of 1 to 10 carbon atoms as a ring constituent except for the two carbon atoms as ring members of the unsaturated pentagonal ring bearing X₂, and
R₆ to R₈ in Chemical Formulas A and Chemical Formula B may be bonded to the Q2 ring moiety to additionally form an aliphatic or aromatic mono- or polycyclic ring,
wherein, the term "substituted" in the expression "substituted or unsubstituted" used for the compound of Chemical Formulas A to E means having at least one substituent selected from the group consisting of a deuterium atom, a cyano, a halogen, a hydroxy, a thiol, a nitro, an alkyl of 1 to 24 carbon atoms, a halogenated alkyl of 1 to 24 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 2 to 24 carbon atoms, an alkoxy of 1 to 24 carbon atoms, an alkylamino of 1 to 24 carbon atoms, a diarylamino of 12 to 24 carbon atoms, a diheteroarylamino of 2 to 24 carbon atoms, an aryl(heteroaryl)amino of 7 to 24 carbon atoms, an alkylsilyl of 1 to 24 carbon atoms, an arylsilyl of 6 to 24 carbon atoms, an aryloxy of 6 to 24 carbon atoms, and an arylthionyl of 6 to 24 carbon atoms.

### Advantageous Effects

When used as a dopant material, the novel boron compound according to the present disclosure allows for the provision of an organic light-emitting diode that can be driven at a lower voltage with improved luminous efficiency, compared to conventional organic light-emitting diodes.

### Brief Description of the Drawings

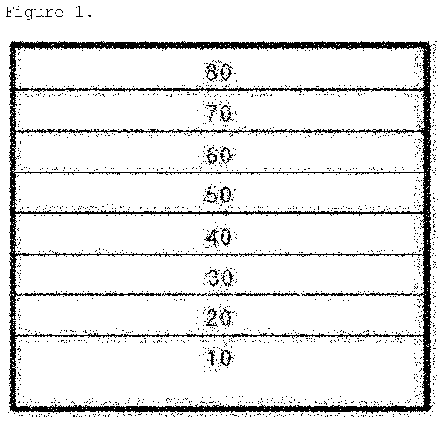

FIG. 1 is a schematic diagram of an organic light-emitting diode according to some embodiments of the present disclosure.

### Best Mode for Carrying out the Invention

Below, a detailed description will be given of the present disclosure. In each drawing of the present disclosure, sizes or scales of components may be enlarged or reduced from their actual sizes or scales for better illustration, and known components may not be depicted therein to clearly show features of the present disclosure. Therefore, the present disclosure is not limited to the drawings. When describing the principle of the embodiments of the present disclosure in detail, details of well-known functions and features may be omitted to avoid unnecessarily obscuring the presented embodiments.

In the drawing, for convenience of description, sizes of components may be exaggerated for clarity. For example, since sizes and thicknesses of components in drawings are arbitrarily shown for convenience of description, the sizes and thicknesses are not limited thereto. Furthermore, throughout the description, the terms "on" and "over" are used to refer to the relative positioning, and mean not only that one component or layer is directly disposed on another component or layer but also that one component or layer is indirectly disposed on another component or layer with a further component or layer being interposed therebetween. Also, spatially relative terms, such as "below", "beneath", "lower", and "between" may be used herein for ease of description to refer to the relative positioning.

Throughout the specification, when a portion may "include" a certain constituent element, unless explicitly described to the contrary, it may not be construed to exclude another constituent element but may be construed to further include other constituent elements. Further, throughout the specification, the word "on" means positioning on or below the object portion, but does not essentially mean positioning on the lower side of the object portion based on a gravity direction.

The present disclosure provides a boron compound represented by any one of the following Chemical Formulas A to E: 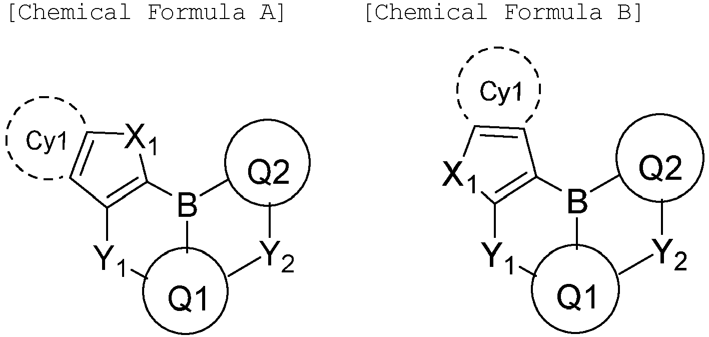 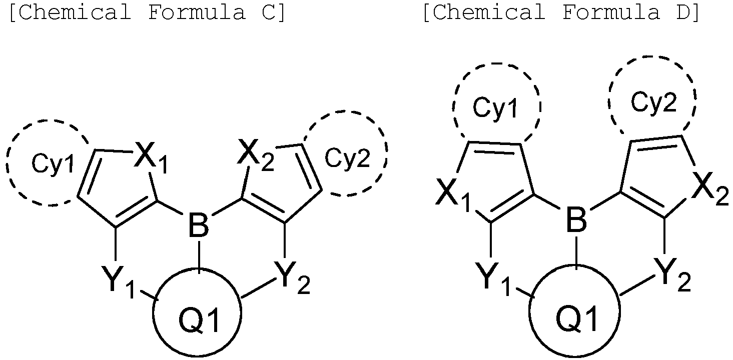 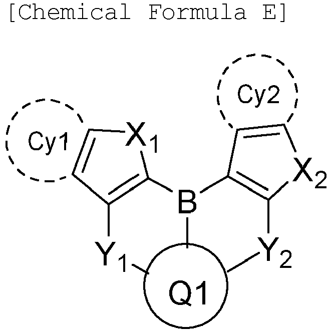 wherein,
X₁ is O, S, or NR₁,
X₂ is O, S, or NR₂,
Y₁ is any one selected from O, S, Se, NR₃, and CR₄R₅,
Y₂ is any one selected from O, S, Se, NR₆, and CR₇R₈,
Q₁ and Q₂, which may be same or different, are each independently a substituted or unsubstituted aromatic hydrocarbon ring of 6 to 50 carbon atoms, or a substituted or unsubstituted heteroaromatic ring of 2 to 50 carbon atoms,
the Q1 ring moiety having no amine radicals as substituents or including one amine radical represented by - NR₉R₁₀ as one substituent thereon,
the Q2 ring moiety having no amine radicals as substituents thereon or including one amine radical represented by -NR₁₁R₁₂ as a substituent thereon,
R₁ to R₈, which may be same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted cycloalkyl of 3 to 30 carbon atoms, a substituted or unsubstituted heteroaryl of 2 to 50 carbon atoms, a substituted or unsubstituted alkoxy of 1 to 30 carbon atoms, a substituted or unsubstituted aryloxy of 6 to 30 carbon atoms, a substituted or unsubstituted alkylthio of 1 to 30 carbon atoms, a substituted or unsubstituted arylthio of 5 to 30 carbon atoms, a substituted or unsubstituted alkylamine of 1 to 30 carbon atoms, a substituted or unsubstituted arylamine of 5 to 30 carbon atoms, a substituted or unsubstituted alkylsilyl of 1 to 30 carbon atoms, a substituted or unsubstituted arylsilyl of 5 to 30 carbon atoms, a nitro, a cyano, and a halogen,
R₉ to R₁₂, which may be same or different, are each independently selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted cycloalkyl of 3 to 30 carbon atoms, and a substituted or unsubstituted heteroaryl of 2 to 50 carbon atoms,
R₉ and R₁₀ may be bonded to each other to additionally form an aliphatic or aromatic mono- or polycyclic ring, and R₁₁ and R₁₂ may be bonded to each other to additionally form an aliphatic or aromatic mono- or polycyclic ring,
R₃ to R₅ and R₆ to R₈ may each independently bonded to the Q1 ring moiety to additionally form an aliphatic or aromatic mono- or polycyclic ring,
R₄ and R₅ may be boned to each other to additionally form an aliphatic or aromatic mono- or polycyclic ring,
R₇ and R₈ may be bonded to each other to additionally an aliphatic or aromatic mono- or polycyclic ring,
the ring accounted for by Cy1 includes a substituted or unsubstituted alkylene of 1 to 10 carbon atoms as a ring constituent except for the two carbon atoms as ring members of the unsaturated pentagonal ring bearing X₁,
the ring accounted for by Cy2 includes a substituted or unsubstituted alkylene of 1 to 10 carbon atoms as a ring constituent except for the two carbon atoms as ring members of the unsaturated pentagonal ring bearing X₂, and
R₆ to R₈ in Chemical Formulas A and Chemical Formula B may be bonded to the Q2 ring moiety to additionally form an aliphatic or aromatic mono- or polycyclic ring,
wherein, the term "substituted" in the expression "substituted or unsubstituted" used for the compound of Chemical Formulas A to E means having at least one substituent selected from the group consisting of a deuterium atom, a cyano, a halogen, a hydroxy, a thiol, a nitro, an alkyl of 1 to 24 carbon atoms, a halogenated alkyl of 1 to 24 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 2 to 24 carbon atoms, an alkoxy of 1 to 24 carbon atoms, an alkylamino of 1 to 24 carbon atoms, a diarylamino of 12 to 24 carbon atoms, a diheteroarylamino of 2 to 24 carbon atoms, an aryl(heteroaryl)amino of 7 to 24 carbon atoms, an alkylsilyl of 1 to 24 carbon atoms, an arylsilyl of 6 to 24 carbon atoms, an aryloxy of 6 to 24 carbon atoms, and an arylthionyl of 6 to 24 carbon atoms.

The expression indicating the number of carbon atoms, such as "a substituted or unsubstituted alkyl of 1 to 30 carbon atoms", "a substituted or unsubstituted aryl of 5 to 50 carbon atoms", etc. means the total number of carbon atoms of, for example, the alkyl or aryl radical or moiety alone, exclusive of the number of carbon atoms of substituents attached thereto. For instance, a phenyl group with a butyl at the para position falls within the scope of an aryl of 6 carbon atoms, even though it is substituted with a butyl radical of 4 carbon atoms.

As used herein, the term "aryl" means an organic radical derived from an aromatic hydrocarbon by removing one hydrogen that is bonded to the aromatic hydrocarbon. The aromatic system may include a fused ring that is formed by adjacent substituents on the aryl radical.

Concrete examples of the aryl include phenyl, o-biphenyl, m-biphenyl, p-biphenyl, o-terphenyl, m-terphenyl, p-terphenyl, naphthyl, anthryl, phenanthryl, pyrenyl, indenyl, fluorenyl, tetrahydronaphthyl, perylenyl, chrysenyl, naphthacenyl, and fluoranthenyl. At least one hydrogen atom of the aryl may be substituted by a deuterium atom, a halogen atom, a hydroxy, a nitro, a cyano, a silyl, an amino (-NH₂, -NH(R), -N(R') (R") wherein R' and R" are each independently an alkyl of 1 to 10 carbon atoms, in this case, called "alkylamino"), an amidino, a hydrazine, a hydrazone, a carboxyl, a sulfonic acid, a phosphoric acid, an alkyl of 1 to 24 carbon atoms, a halogenated alkyl of 1 to 24 carbon atoms, an alkenyl of 1 to 24 carbon atoms, an alkynyl of 1 to 24 carbon atoms, a heteroalkyl of 1 to 24 carbon atoms, an aryl of 6 to 24 carbon atoms, an arylalkyl of 6 to 24 carbon atoms, a heteroaryl of 2 to 24 carbon atoms, or a heteroarylalkyl of 2 to 24 carbon atoms.

The substituent "heteroaryl" used in the compound of the present disclosure means a hetero aromatic radical of 2 to 24 carbon atoms, bearing one to three heteroatoms selected from among N, O, P, Si, S, Ge, Se, and Te. In the aromatic radical, two or more rings may be fused. One or more hydrogen atoms on the heteroaryl may be substituted by the same substituents as on the aryl.

In addition, the term "heteroaromatic ring", as used herein, refers to an aromatic hydrocarbon ring bearing at least one heteroatom as aromatic ring member. In the heteroaromatic ring, one to three carbon atoms of the aromatic hydrocarbon may be substituted by at least one selected particularly from N, O, P, Si, S, Ge, Se, and Te.

As used herein, the term "alkyl" refers to an alkane missing one hydrogen atom and includes linear or branched structures. Examples of the alkyl substituent useful in the present disclosure include methyl, ethyl, propyl, isopropyl, isobutyl, sec-butyl, tert-butyl, pentyl, iso-amyl, hexyl, and the like. At least one hydrogen atom of the alkyl may be substituted by the same substituent as in the aryl.

The term "cyclo" as used in substituents of the compounds of the present disclosure, such as cycloalkyl, etc., refers to a structure responsible for a mono- or polycyclic ring of saturated hydrocarbons. Concrete examples of cycloalkyl radicals include cyclopropyl, cyclobutyl, cyclopentyl, cyclohexyl, methylcyclopentyl, methylcyclohexyl, ethylcyclopentyl, ethylcyclohexyl, adamantyl, dicyclopentadienyl, decahydronaphthyl, norbornyl, bornyl, isobornyl, and so on. One or more hydrogen atoms on the cycloalkyl may be substituted by the same substituents as on the aryl.

The term "alkoxy" as used in the compounds of the present disclosure refers to an alkyl or cycloalkyl singularly bonded to oxygen. Concrete examples of the alkoxy include methoxy, ethoxy, propoxy, isobutoxy, sec-butoxy, pentoxy, iso-amyloxy, hexyloxy, cyclobutyloxy, cyclopentyloxy, adamantyloxy, dicyclopentyloxy, bornyloxy, isobornyloxy, and the like. One or more hydrogen atoms on the alkoxy may be substituted by the same substituents as on the aryl.

Concrete examples of the arylalkyl used in the compounds of the present disclosure include phenylmethyl (benzyl), phenylethyl, phenylpropyl, naphthylmethyl, naphthylethyl, and the like. One or more hydrogen atoms on the arylalkyl may be substituted by the same substituents as on the aryl.

Concrete examples of the silyl radicals used in the compounds of the present disclosure include trimethylsilyl, triethylsilyl, triphenylsilyl, trimethoxysilyl, dimethoxyphenylsilyl, diphenylmethylsilyl, diphenylvinlysilyl, methylcyclobutylsilyl, and dimethyl furylsilyl. One or more hydrogen atoms on the silyl may be substituted by the same substituents as on the aryl.

As used herein, the term "alkenyl" refers to a hydrocarbon group containing a carbon-carbon double bond and the term "alkynyl" refers to a hydrocarbon group containing a carbon-carbon triple bond.

As used herein, the term "alkylene" refers to an organic radical regarded as derived from an alkane by removal two hydrogen atoms from one carbon atom for methylene or different carbon atoms for ethylene or higher, such as propylene, isopropylene, isobutylene, sec-butylene, tert-butylene, pentylene, iso-amylene, hexylene, and the like. One or more hydrogen atoms on the alkylene may be substituted by the same substituents as on the aryl.

As used herein, the term "diarylamino" refers to an amine group having aforementioned, two identical or different aryl radicals bonded to the nitrogen atom thereof, the term "diheteroarylamino" to an amine group having two identical or different heteroaryl radicals bonded to the nitrogen atom thereof, and the term "aryl(heteroaryl)amino" to an amine group having the aryl radical and the heteroaryl radical each bonded to the nitrogen atom thereof.

In a specific embodiment of the present disclosure, the term "substituted" in the expression "substituted or unsubstituted" used for the compound of any one of Chemical Formulas A to E means having at least one substituent selected from the group consisting of a deuterium atom, a cyano, a halogen, a hydroxy, a nitro, an alkyl of 1 to 12 carbon atoms, a halogenated alkyl of 1 to 12 carbon atoms, an alkenyl of 2 to 12 carbon atoms, an alkynyl of 2 to 12 carbon atoms, a cycloalkyl of 3 to 12 carbon atoms, a heteroalkyl of 1 to 12 carbon atoms, an aryl of 6 to 18 carbon atoms, an arylakyl of 7 to 20 carbon atoms, an alkylaryl of 7 to 20 carbon atoms, a heteroaryl of 2 to 18 carbon atoms, a heteroarylalkyl of 2 to 18 carbon atoms, an alkoxy of 1 to 12 carbon atoms, an alkylamino of 1 to 12 carbon atoms, a diarylamino of 12 to 18 carbon atoms, a diheteroarylamino 2 to 18 carbon atoms, an aryl(heteroaryl)amino of 7 to 18 carbon atoms, an alkylsilyl of 1 to 12 carbon atoms, an arylsilyl of 6 to 18 carbon atoms, an aryloxy of 6 to 18 carbon atoms, and an arylthionyl of 6 to 18 carbon atoms.

In the present disclosure, the boron compound represented by Chemical Formula A or B is characterized by the structure in which a boron atom is bonded to an unsaturated pentagonal ring moiety bearing X₁ as a ring member and to both Q₁ and Q₂ ring moieties, which are each independently a substituted or unsubstituted aromatic hydrocarbon ring of 6 to 50 carbon atoms, or a substituted or unsubstituted heteroaromatic ring of 2 to 50 carbon atoms, with a linkage between the unsaturated pentagonal ring moiety bearing X₁ as a ring member and the Q1 ring via the linker Y₁ and between the Q1 and Q2 ring moieties via the linker Y₂, and two adjacent carbon atoms as ring members in the unsaturated pentagonal ring moiety bearing X₁ form an additional fused ring with the saturated alkylene Cy1:

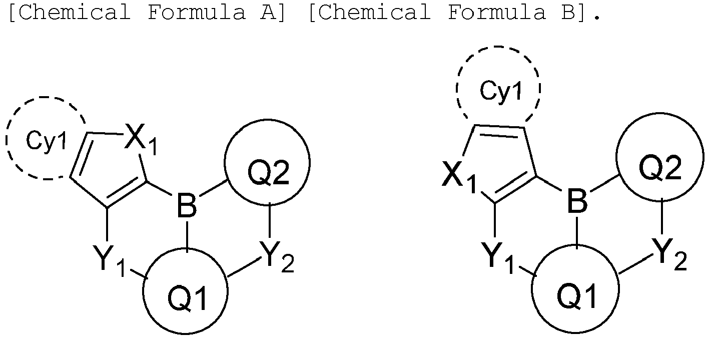

In the present disclosure, the boron compound represented by any one of Chemical Formulas C to E is characterized by the structure in which a boron atom is bonded to both an unsaturated pentagonal ring bearing X₁ as a ring member and an unsaturated pentagonal ring bearing X₂ as a ring member and to Q1, which is a substituted or unsubstituted aromatic hydrocarbon ring of 6 to 50 carbon atoms or a substituted or unsubstituted heteroaromatic ring of 2 to 50 carbon atoms, with a linkage between the unsaturated pentagonal ring moiety bearing X₁ and the Q1 ring moiety via the linker Y₁ and between the unsaturated pentagonal ring moiety bearing X₂ and the Q1 ring moiety via the linker Y₂, and an additional fused ring is formed between two adjacent carbon atoms as ring members in the unsaturated pentagonal ring moiety bearing X₁ and with the saturated alkylene Cy1 and between two adjacent carbon atoms as ring members in the unsaturated pentagonal ring bearing X₂ and and the saturated alkylene Cy2. With such structural characteristics, the boron compound represented by Chemical Formulas A to E exhibit low driving voltage and high luminous efficiency properties.

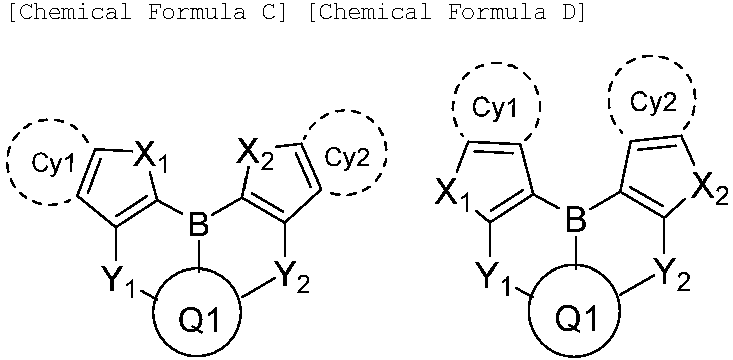

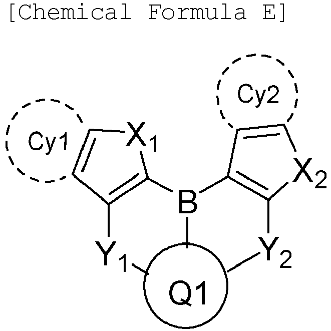

That is, "Cy1" is connected to two adjacent carbon atoms as ring members in the unsaturated pentagonal ring bearing X₁ to form a ring fused to the unsaturated pentagonal ring bearing X₁, wherein the ring accounted for by Cy1 may include a substituted or unsubstituted alkylene of 1 to 10 carbon atoms, particularly, a substituted or unsubstituted alkylene of 2 to 7 carbon atoms, or more particularly a substituted or unsubstituted alkylene of 2 to 5 carbon atoms as a ring constituent thereof except for the two adjacent carbon atoms in the unsaturated pentagonal ring bearing X₁.

In addition, "Cy2" in Chemical Formulas C to E is connected to two adjacent carbon atoms as ring members in the unsaturated pentagonal ring bearing X₂ to form a ring fused to the unsaturated pentagonal ring bearing X₂, wherein the ring accounted for by Cy2 may include a substituted or unsubstituted alkylene of 1 to 10 carbon atoms, particularly a substituted or unsubstituted alkylene of 1 to 7 carbon atoms, or more particularly a substituted or unsubstituted alkylene of 1 to 5 carbon atoms as a ring constituent thereof except for the two adjacent carbon atoms in the unsaturated pentagonal ring bearing X₂.

According to an embodiment, in Chemical Formulas A to E, the linker Y₁ may be N-R₃ or the linker Y₂ may be N-R₆. In some embodiments, the linker Y₁ may be N-R₃ while the linker Y₂ may be N-R₆, wherein R₃ and R₆ are as defined above.

According to an embodiment, when the linker Y₁ is N-R₃ or the linker Y₂ is N-R₆ in Chemical Formulas A to E, R₃ and R₆, which may be same or different, are each independently a substituted or unsubstituted aryl of 6 to 50 carbon atoms or a substituted or unsubstituted heteroaryl of 2 to 50 carbon atoms. In some particular embodiments, R₃ and R₆, which may be same or different, are each independently selected from a substituted or unsubstituted phenyl, a substituted or unsubstituted biphenyl, a substituted or unsubstituted naphthyl, a substituted or unsubstituted anthracenyl, a substituted or unsubstituted phenanthrenyl, and a substituted or unsubstituted fluorenyl, wherein either R₃ or R₆ may additionally form an aliphatic or aromatic mono- or polycyclic ring with the Q1 ring moiety or Q2 ring moiety.

According to an embodiment of the present disclosure, at least one of the linkers Y₁ and Y₂ in Chemical Formulas A to E may be oxygen (O) or sulfur (S).

In Chemical Formulas A to E according to the present disclosure, Q1 and Q2 ring moieties, which are bonded to the boron atom (B) may be same or different and are each independently a substituted or unsubstituted aromatic hydrocarbon ring of 6 to 18 carbon atoms or a substituted or unsubstituted heteroaromatic ring of 2 to 18 carbon atoms.

Here, when Q1 and Q2 ring moieties are same or different and are each independently a substituted or unsubstituted aromatic hydrocarbon ring of 6 to 18 carbon atoms, the aromatic hydrocarbon rings of Q1 and Q2 in Chemical Formulas A to E may each be selected from the following Structural Formulas 10 to 21: 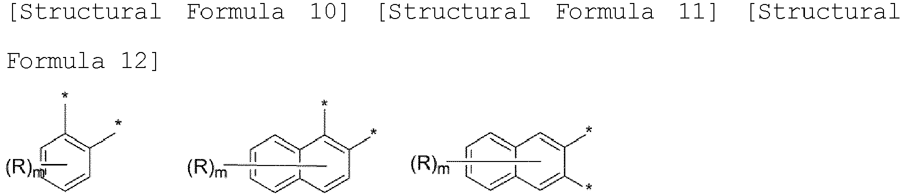 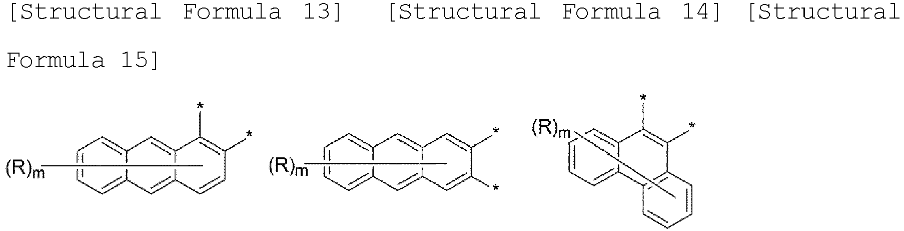 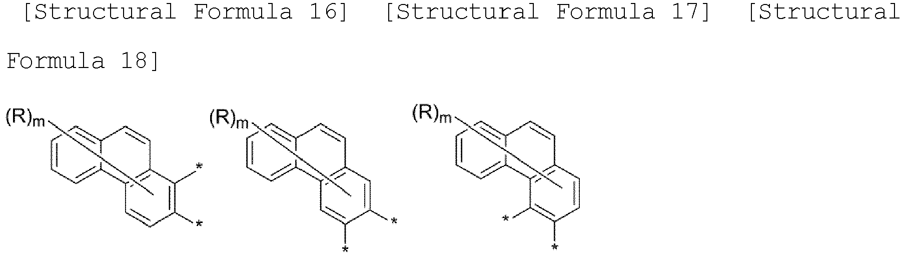 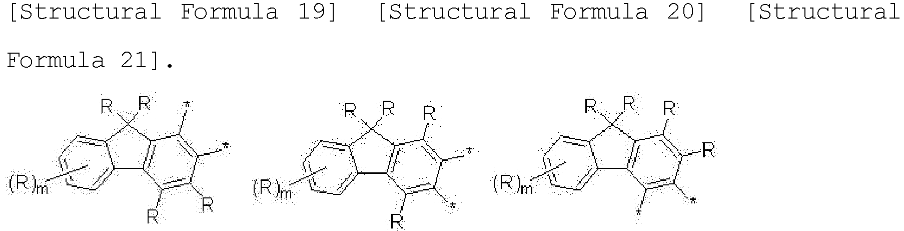 wherein, 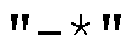 denotes bonding sites at which the corresponding carbons in the aromatic ring of Q2 bond to the boron atom and the linker Y₂, respectively, and
R's, which may be same or different, are each independently any one selected from a hydrogen atoms, a deuterium atom, a cyano, a halogen, a hydroxy, a nitro, an alkyl of 1 to 24 carbon atoms, a halogenated alkyl of 1 to 24 carbon atoms, a cycloalkyl of 3 to 24 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an akylaryl of 7 to 24 carbon atoms, heteroaryl of 2 to 50 carbon atoms, a heteroarylalkyl of 2 to 24 carbon atoms, an alkoxy of 1 to 24 carbon atoms, an alkylamino of 1 to 24 carbon atoms, a diarylamino of 12 to 24 carbon atoms, a diheteroarylamino of 2 to 24 carbon atoms, an aryl(heteroaryl)amino of 7 to 24 carbon atoms, an alkylsilyl of 1 to 24 carbon atoms, an arylsilyl of 6 to 24 carbon atoms, an aryloxy of 6 to 24 carbon atoms, and an arylthionyl of 6 to 24 carbon atoms, and
m is an integer of 1 to 8 wherein when m is 2 or more or two or more R's is present, the corresponding R's may be same or different.

In the case where the Q1 and Q2 ring moieties are same or different and each independently a substituted or unsubstituted aromatic hydrocarbon ring of 6 to 18 carbon atoms, the aromatic hydrocarbon ring of Q1 may be each independently a ring represented by the following Structural Formula B: 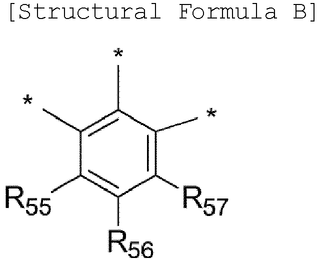 wherein 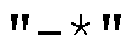 denotes bonding sites at which the corresponding carbons in the aromatic ring of Q1 bond to the boron atom (B) and the linkers Y₁ and Y₂, respectively, and
R₅₅ to R₅₇, which may be same or different, are each independently any one selected from a hydrogen atom, a deuterium atom, a cyano, a halogen, a hydroxy, a nitro, an alkyl of 1 to 24 carbon atoms, a halogenated alkyl of 1 to 24 carbon atoms, a cycloalkyl of 3 to 24 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an akylaryl of 7 to 24 carbon atoms, a heteroaryl of 2 to 50 carbon atoms, a heteroarylalkyl of 2 to 24 carbon atoms, an alkoxy of 1 to 24 carbon atoms, an alkylamino of 1 to 24 carbon atoms, a diarylamino of 12 to 24 carbon atoms, a diheteroarylamino of 2 to 24 carbon atoms, an aryl(heteroaryl)amino of 7 to 24 carbon atoms, an alkylsilyl of 1 to 24 carbon atoms, an arylsilyl of 6 to 24 carbon atoms, an aryloxy of 6 to 24 carbon atoms, and an arylthionyl of 6 to 24 carbon atoms, and
any adjacent two of R₅₅ to R₅₇ may be linked to each to each other to form an additional mono- or polycyclic aliphatic or aromatic ring.

In addition, the ring accounted for by Cy1 in Chemical Formulas A to E includes as a ring constituent a linker represented by the following Structural Formula D:

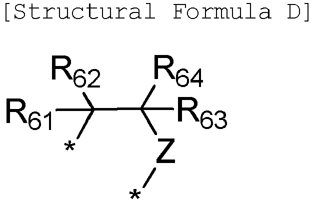

In Chemical Formulas C to E, the ring accounted for by Cy2 may include as a ring constituent a linker represented by the following Structural Formula E:

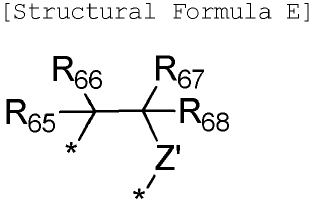

In Structural Formulas D and E, 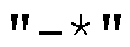 denotes a bonding site to two adjacent carbon atoms within the unsaturated pentagonal ring bearing X₁ or X₂ as a ring member, and
Z and Z', which may be same or different, are each independently any one selected from a single bond,-C(R₆₉)(R₇₀)-, and -C(R₇₁)(R₇₂)-C(R₇₃)(R₇₄)-,
wherein R₆₁ to R₇₄, which may be same or different, are each independently selected from a hydrogen atom, a deuterium atom, a halogen, a substituted or unsubstituted alkyl of 1 to 20 carbon atoms, a substituted or unsubstituted cycloalkyl of 3 to 20 carbon atoms, a substituted or unsubstituted aryl of 6 to 20 carbon atoms, a substituted or unsubstituted heteroaryl of 2 to 20 carbon atoms, a substituted or unsubstituted alkylsilyl of 1 to 20 carbon atoms, and a substituted or unsubstituted arylsilyl of 6 to 20 carbon atoms wherein the term 'substituted" in the expression "substituted or unsubstituted" used is as defined above.

In Chemical Formulas A to E, the Q1 ring moiety may include no amines or one amine represented by -NR₉R₁₀ as a substituent and the Q2 ring moiety may include no amines or one amine represented by -NR₁₁R₁₂ as a substituent. According to some particular embodiments, the Q1 ring moiety includes no amine radicals while the Q2 ring moiety includes one amine radical represented by -NR₁₁R₁₂ as a substituent.

In an embodiment, the amine radical represented by -NR₉R₁₀ as a substituent on the Q1 ring moiety or the amino radical represented by -NR₁₁R₁₂ as a substituent on the Q2 ring moiety in Chemical Formulas A to E may be same or different and are each independently an amine represented by the following Structural Formula F 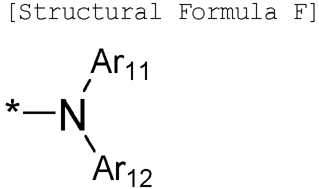 wherein 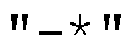 denotes a bonding site to a carbon atom as a member in the aromatic ring of at least one of Q1 and Q2, and
Ar₁₁ and Ar₁₂, which may be same or different, are each independently a substituted or unsubstituted aryl of 6 to 18 carbon atoms.

The boron compound represented by any one of Chemical Formulas A to E may be any one selected from <Compound 1> to <Compound 243>:

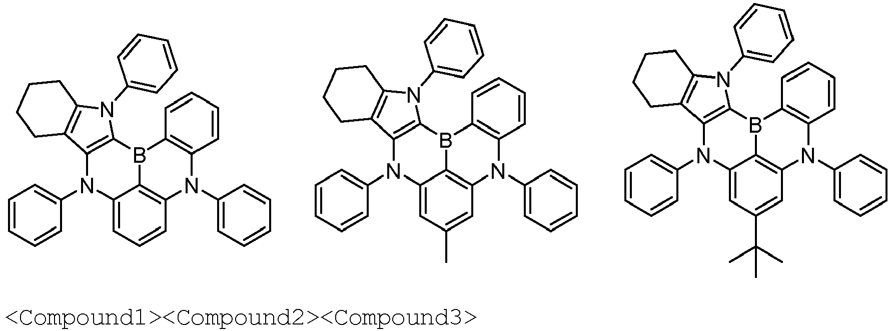

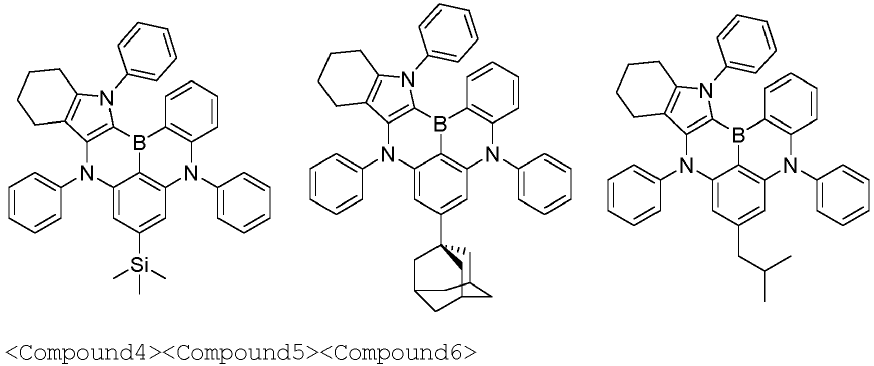

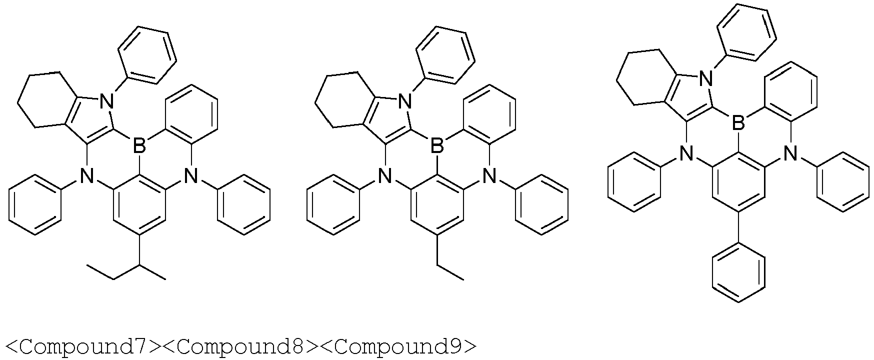

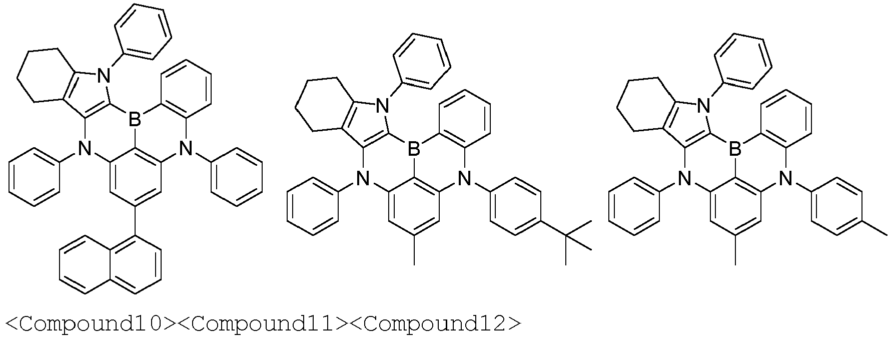

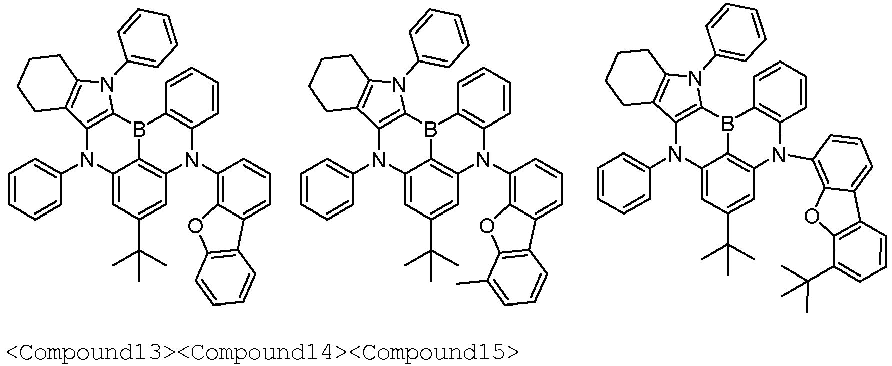

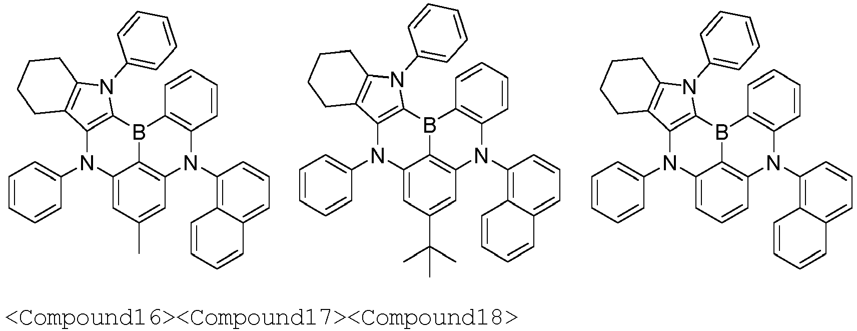

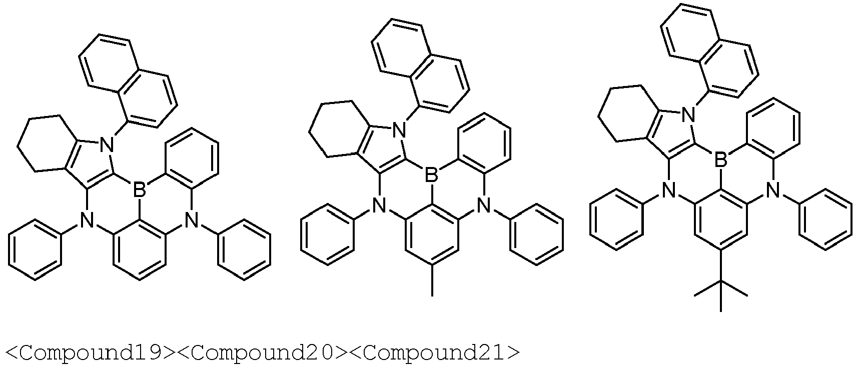

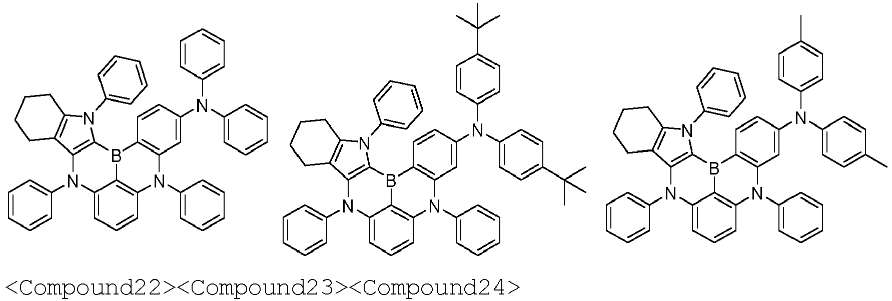

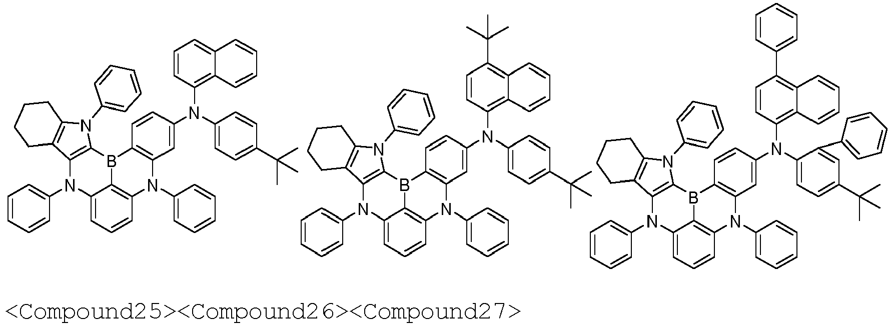

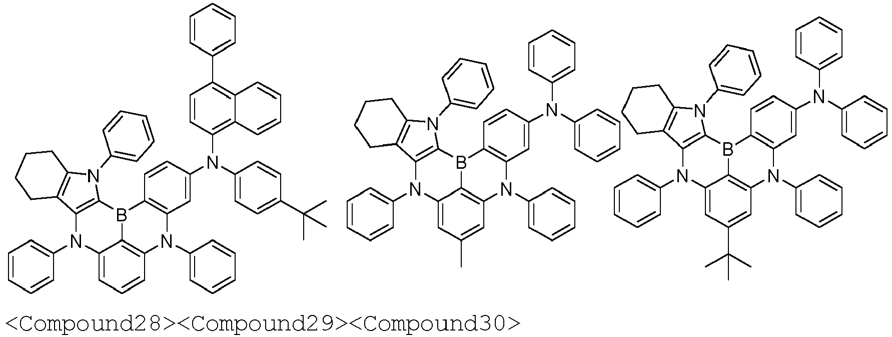

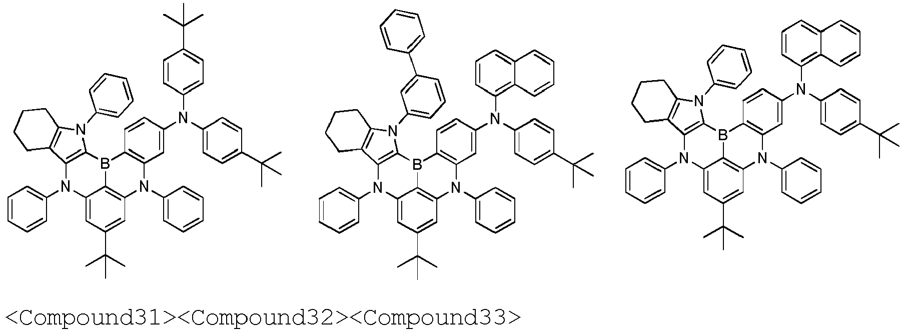

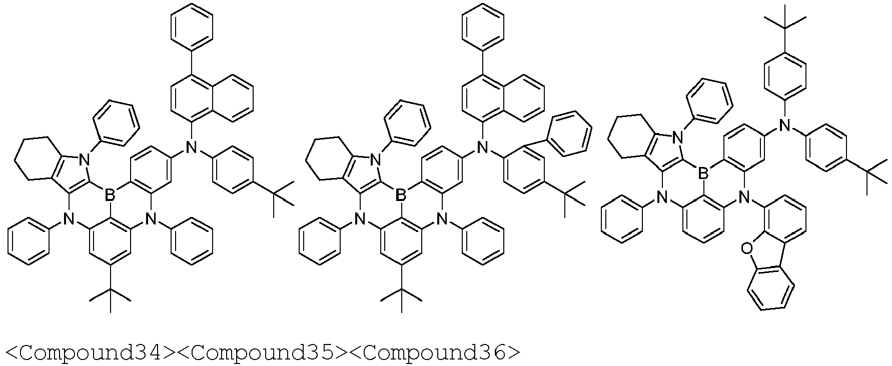

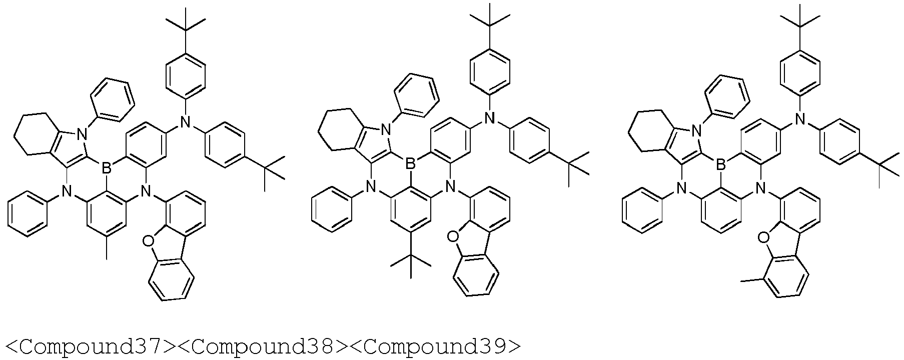

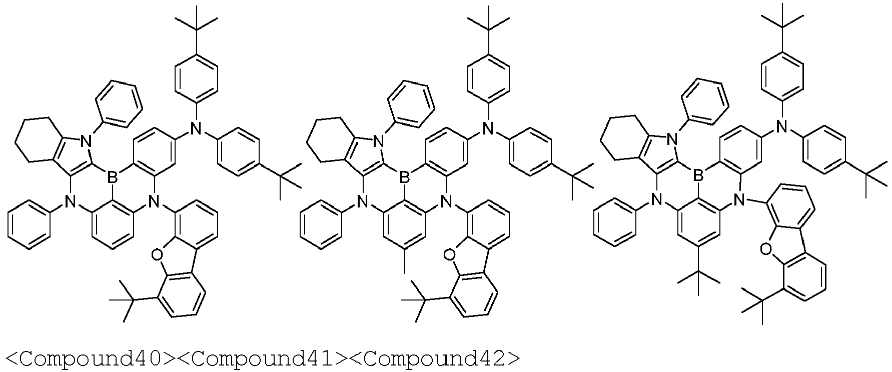

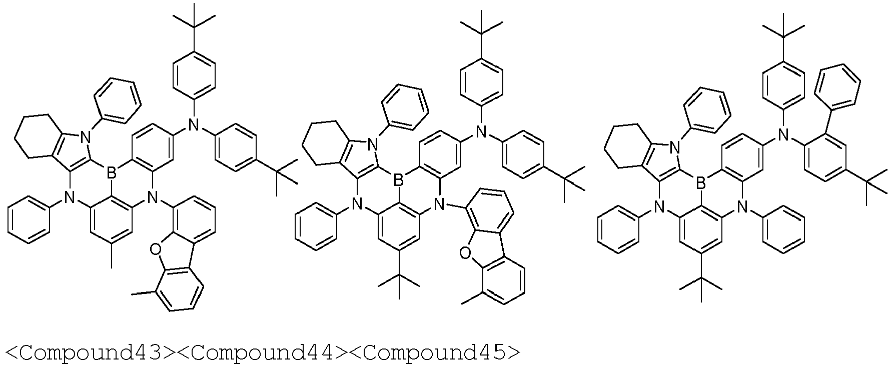

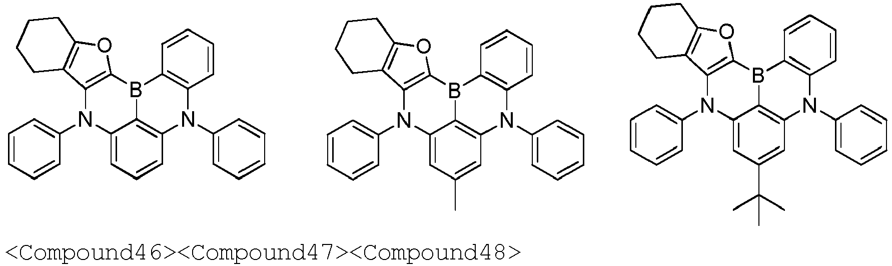

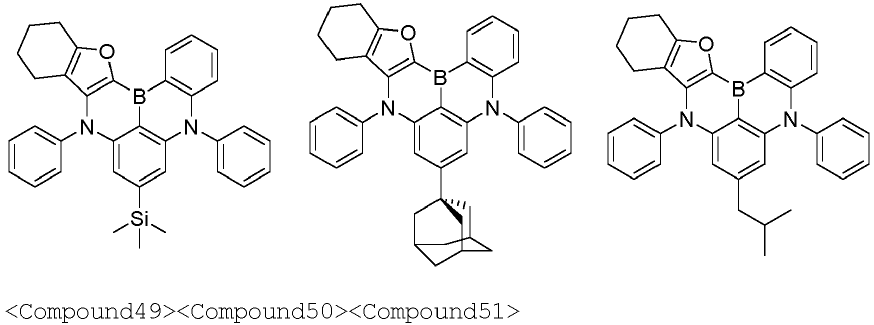

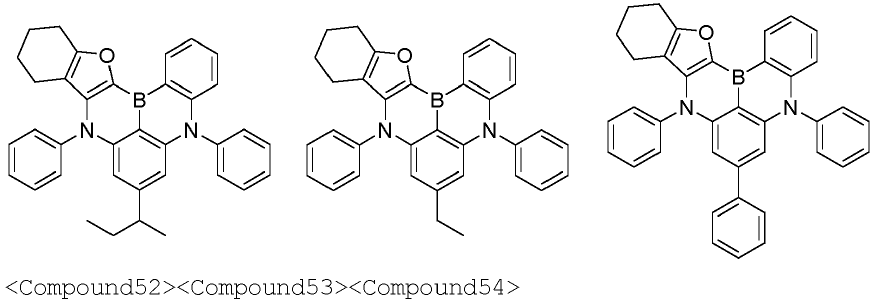

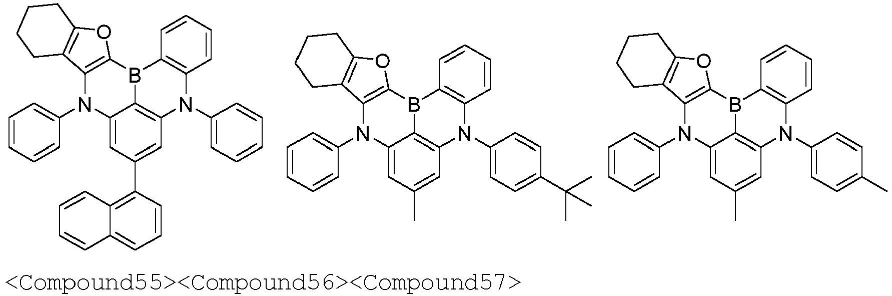

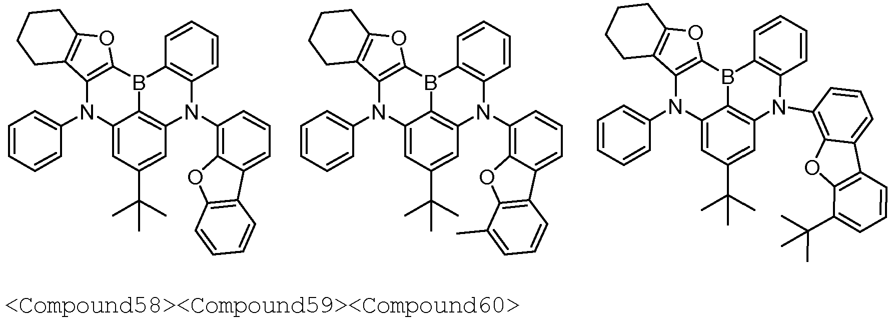

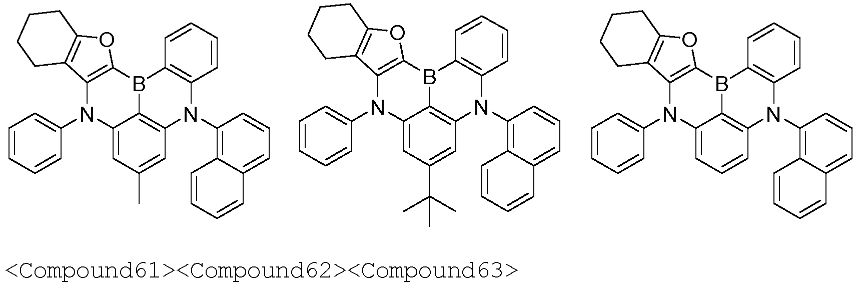

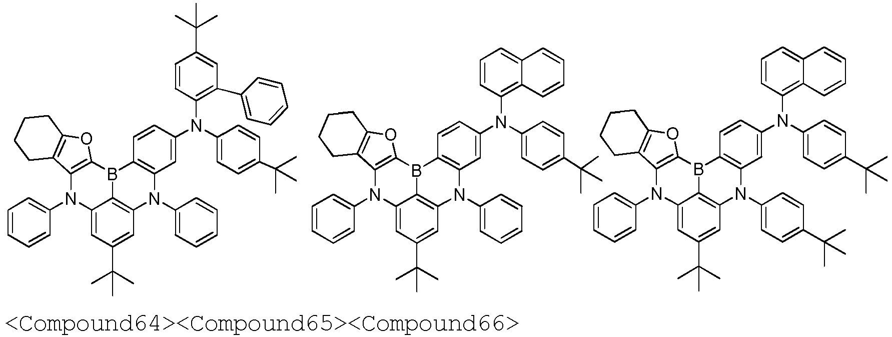

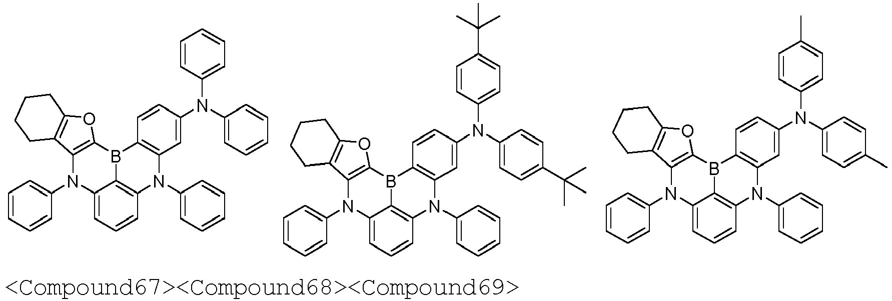

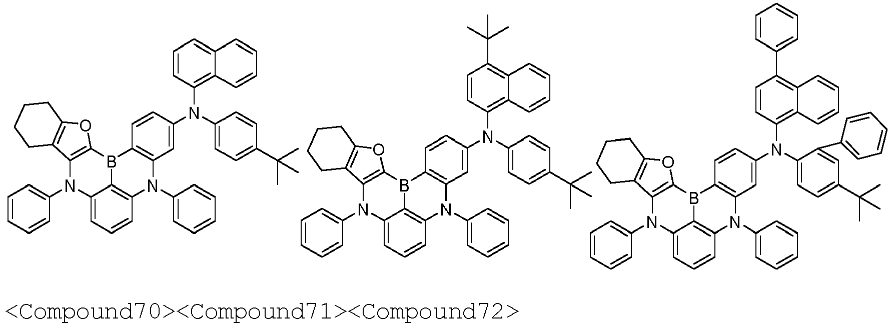

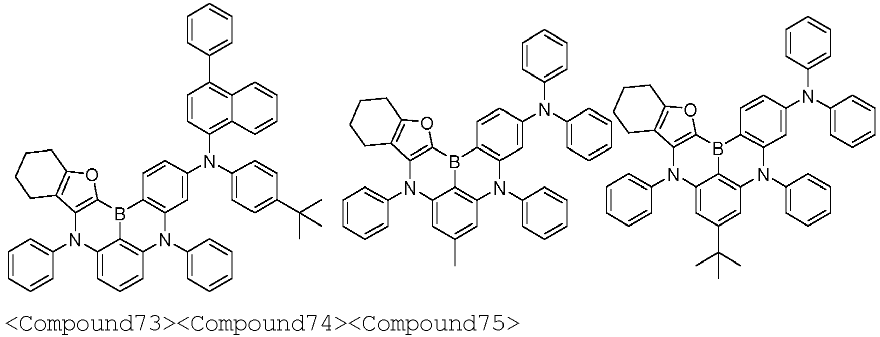

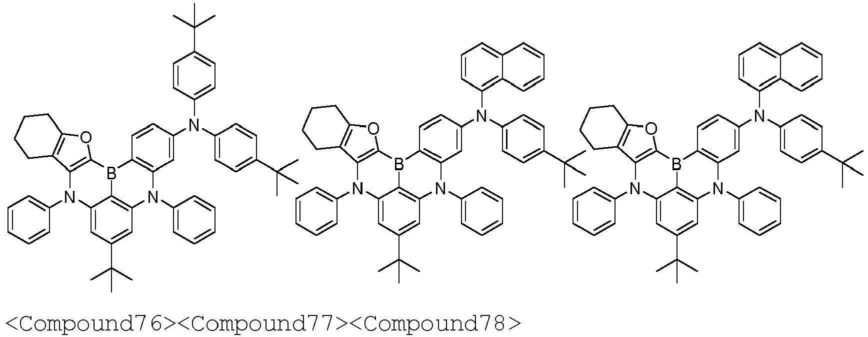

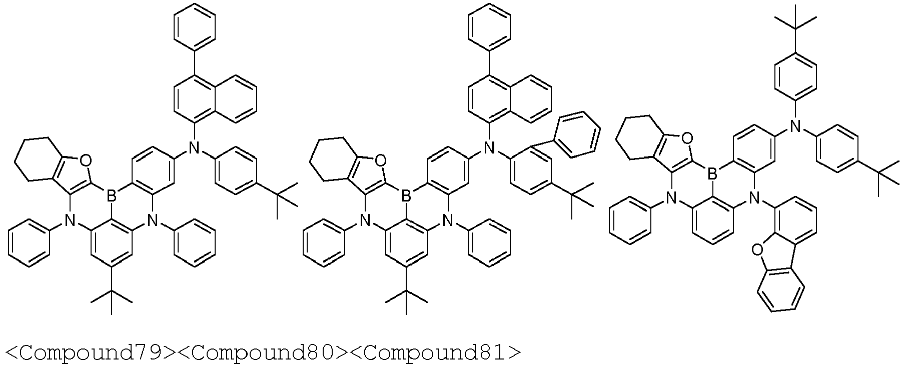

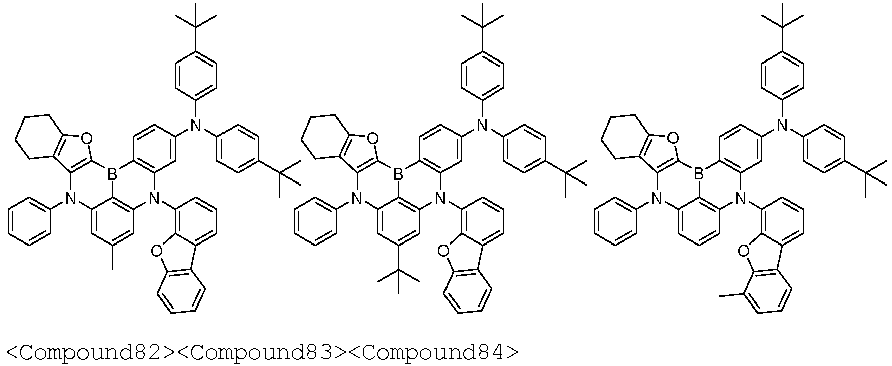

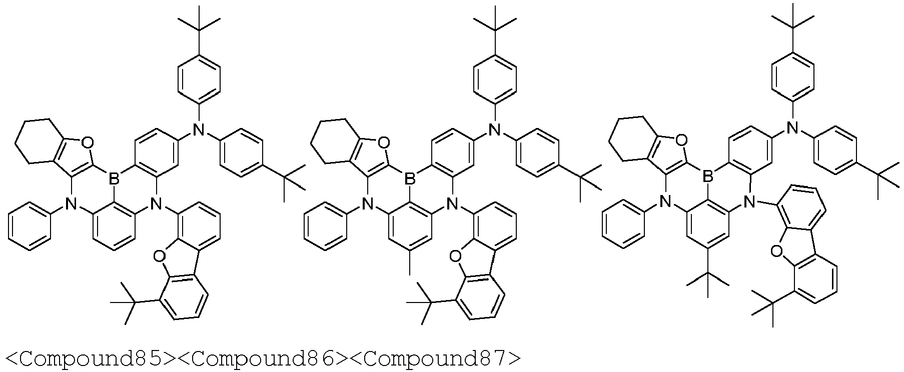

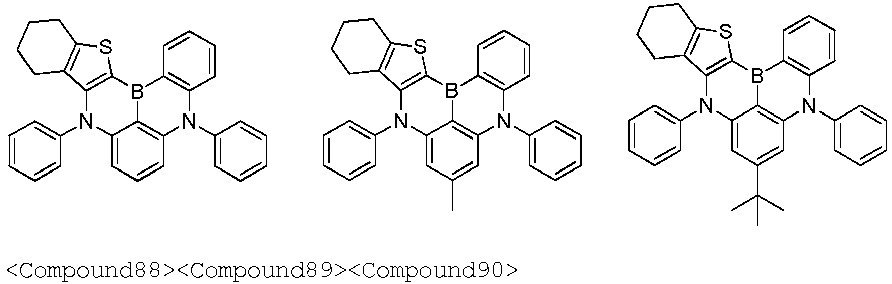

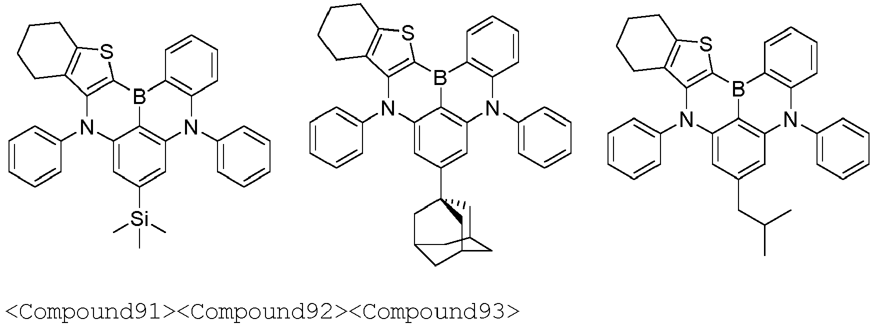

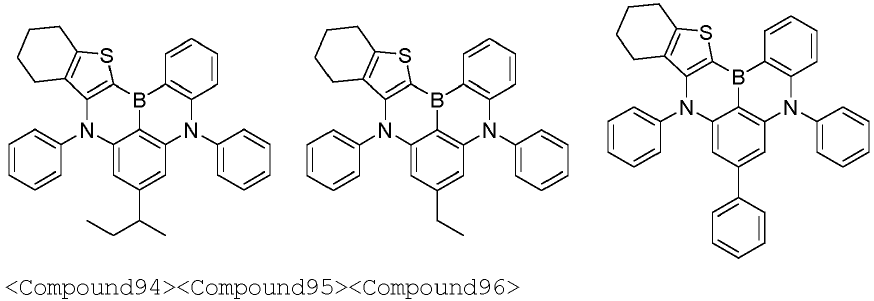

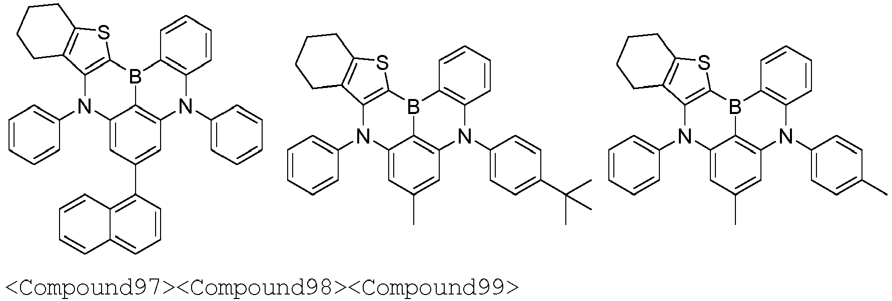

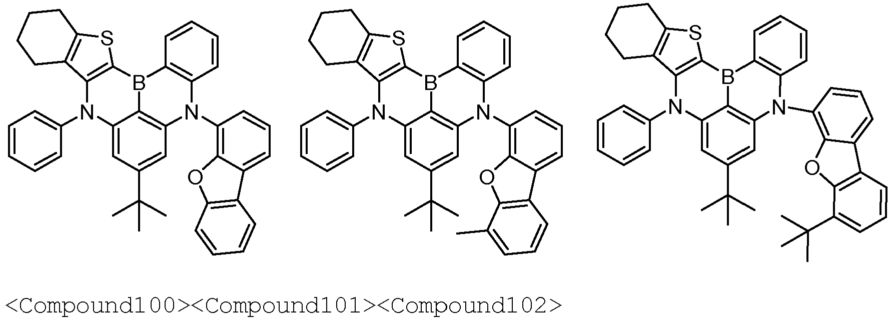

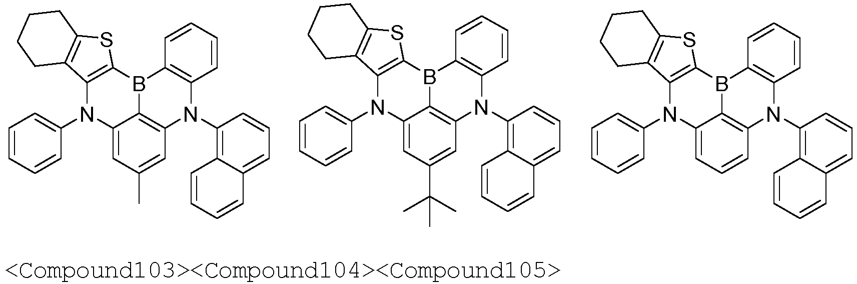

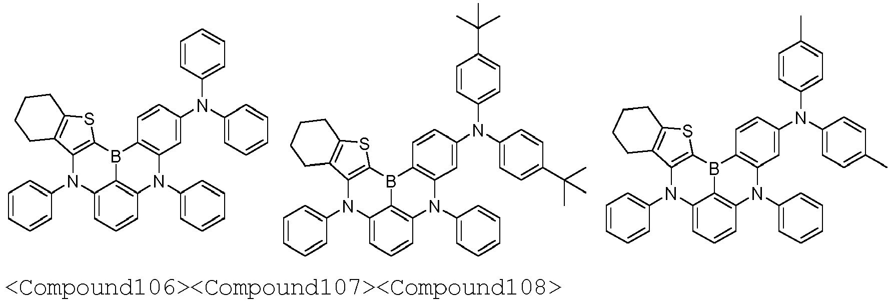

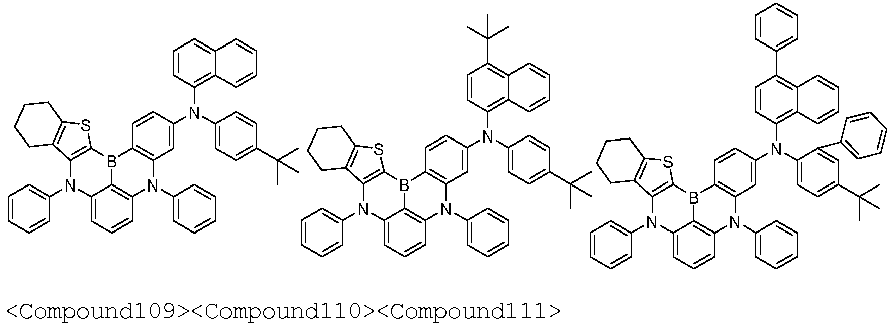

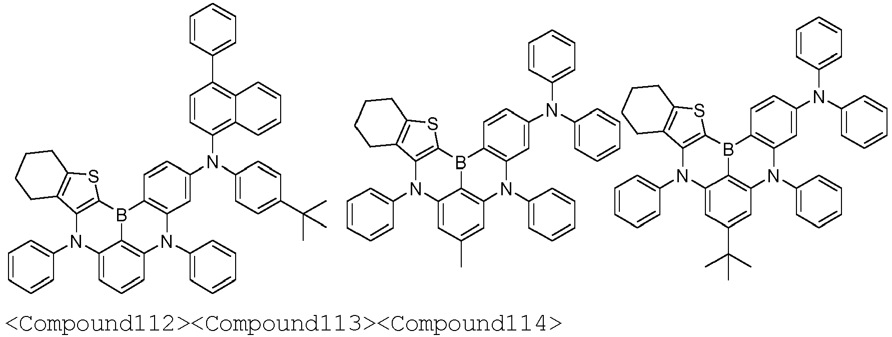

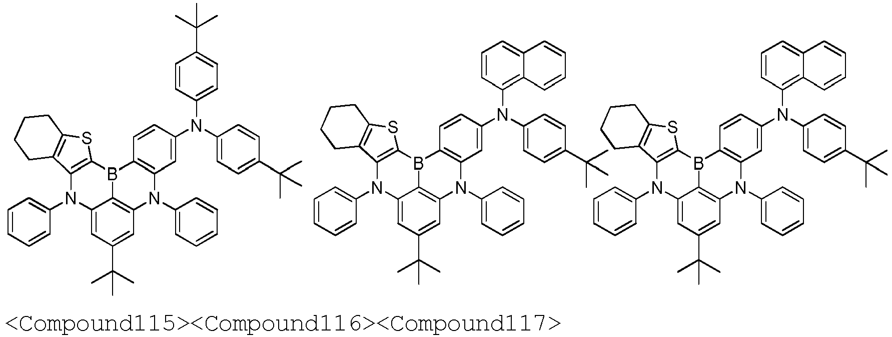

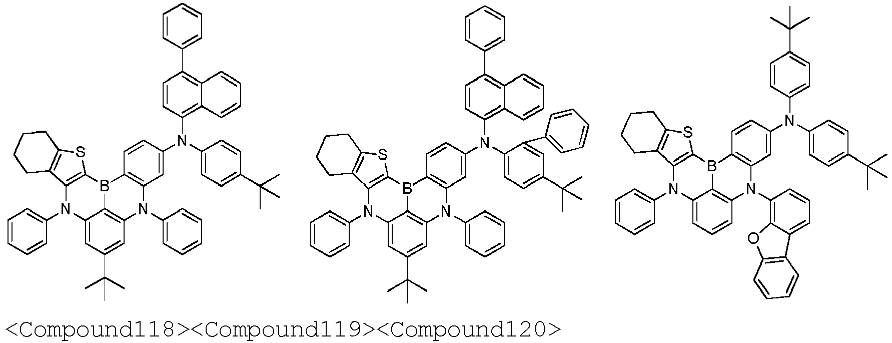

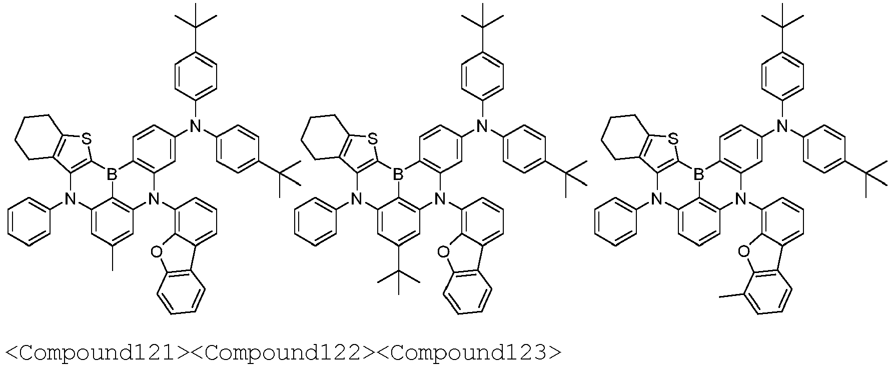

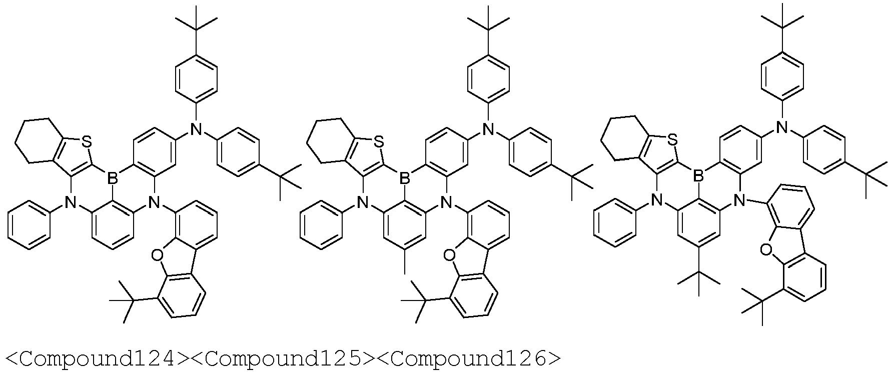

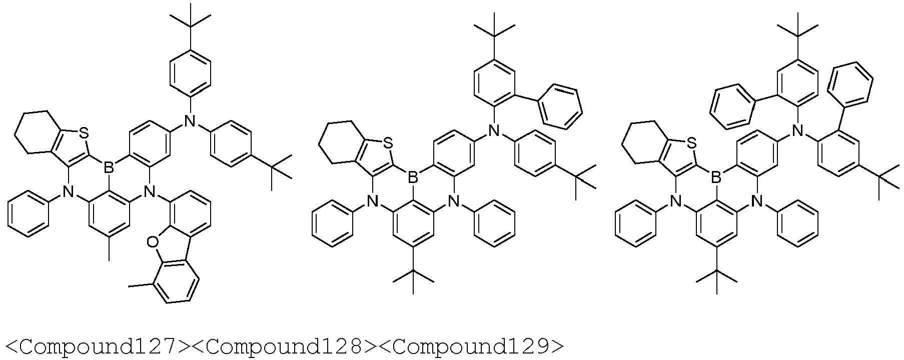

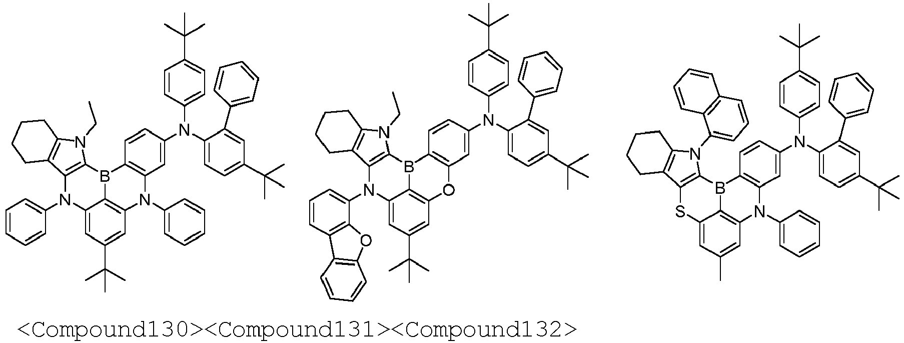

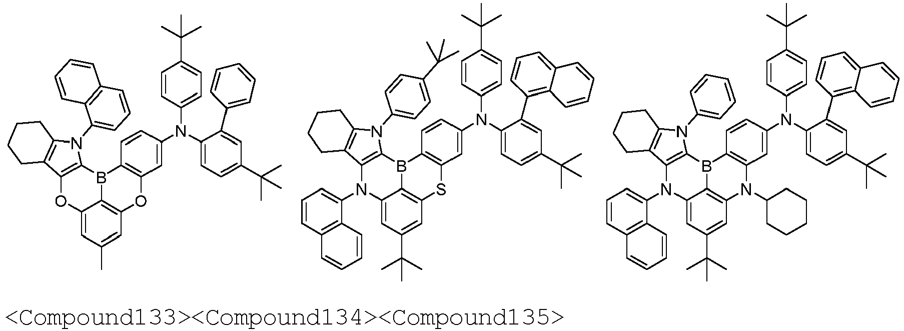

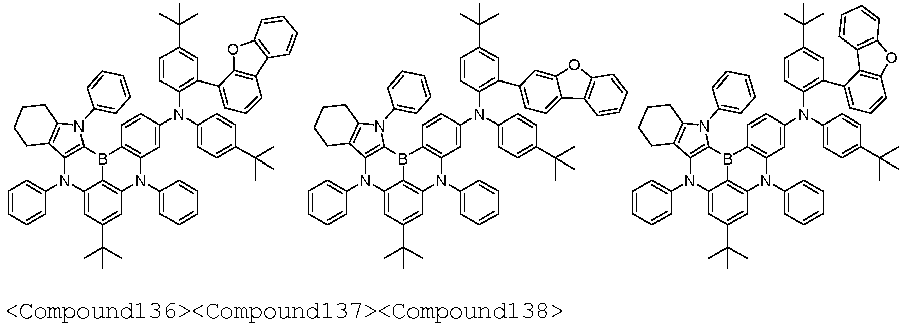

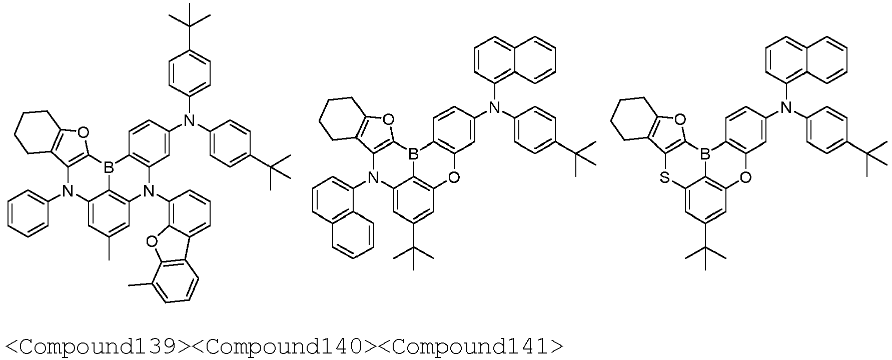

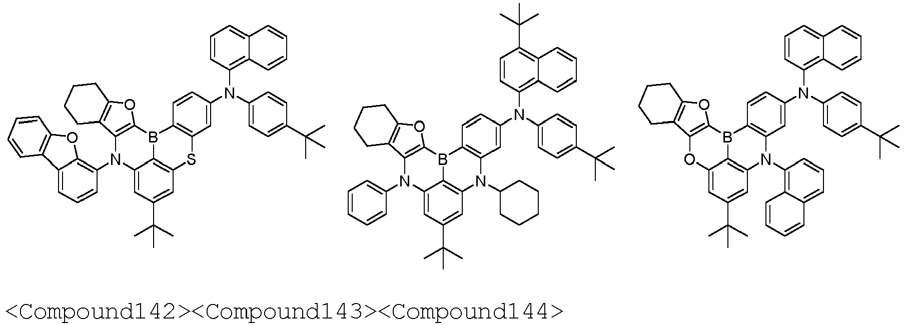

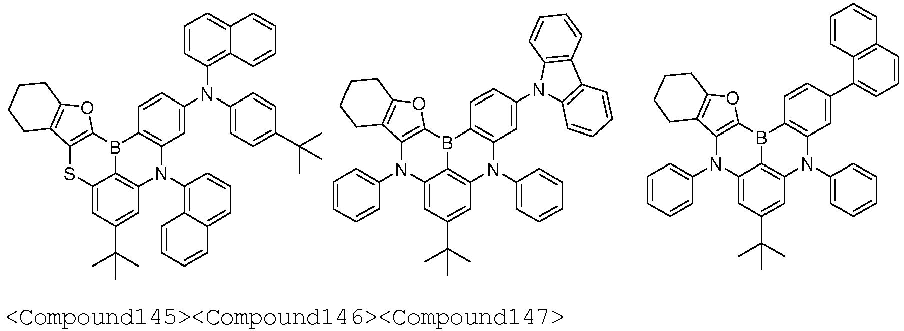

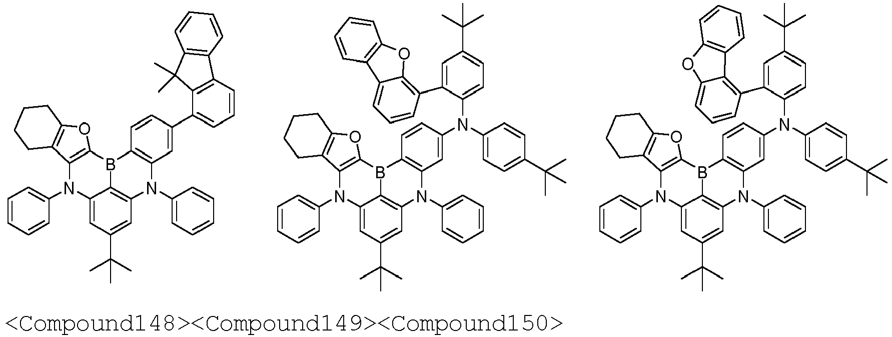

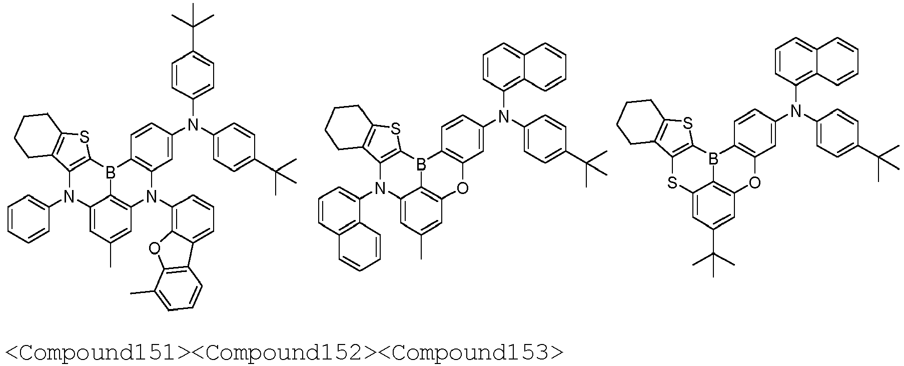

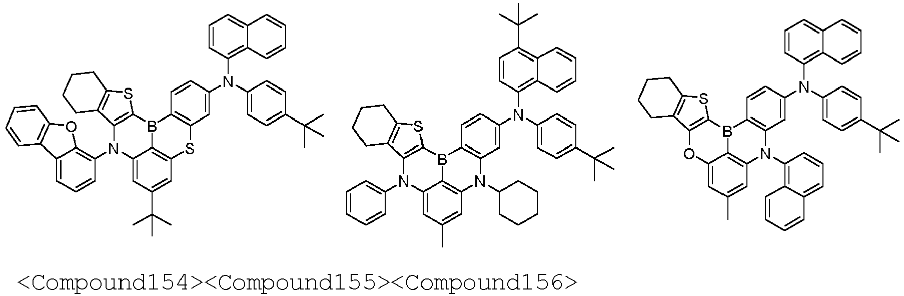

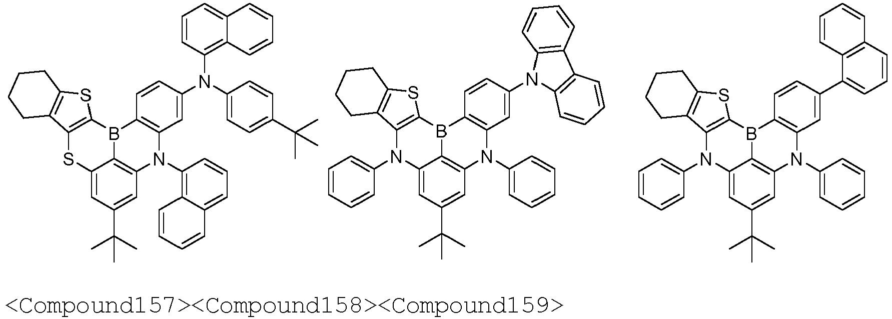

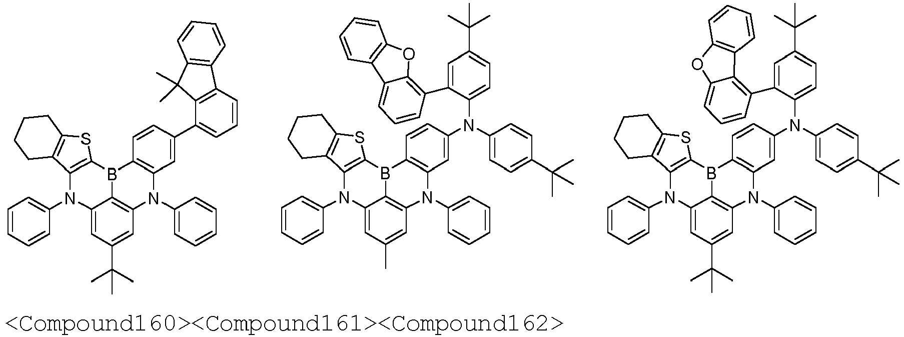

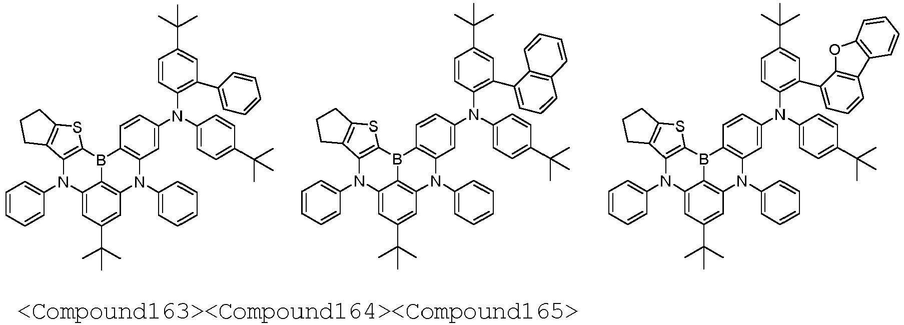

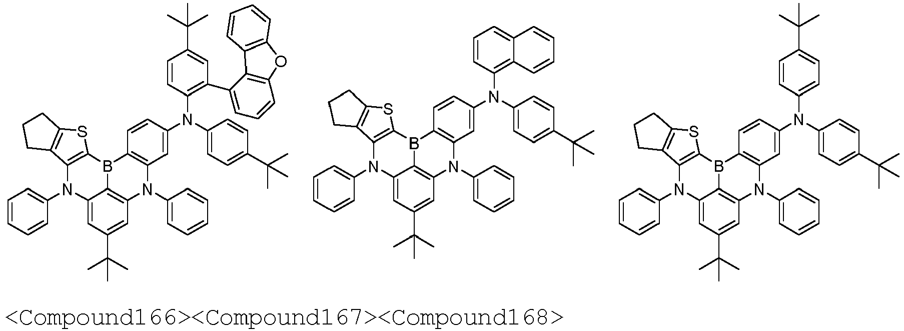

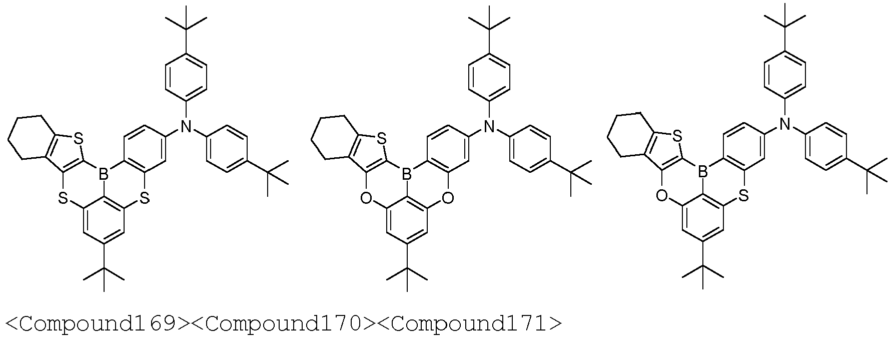

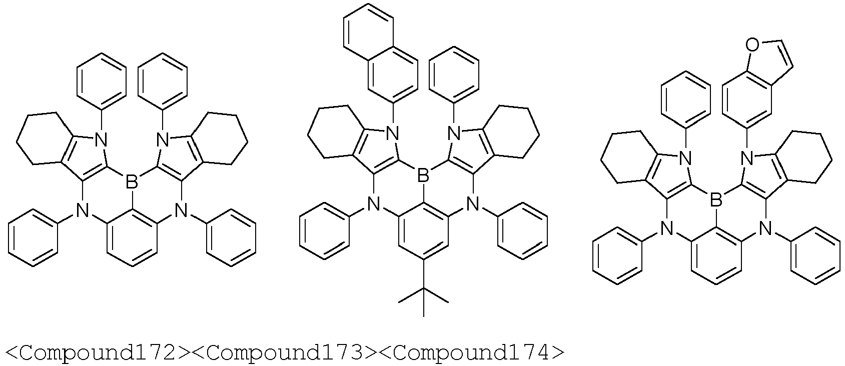

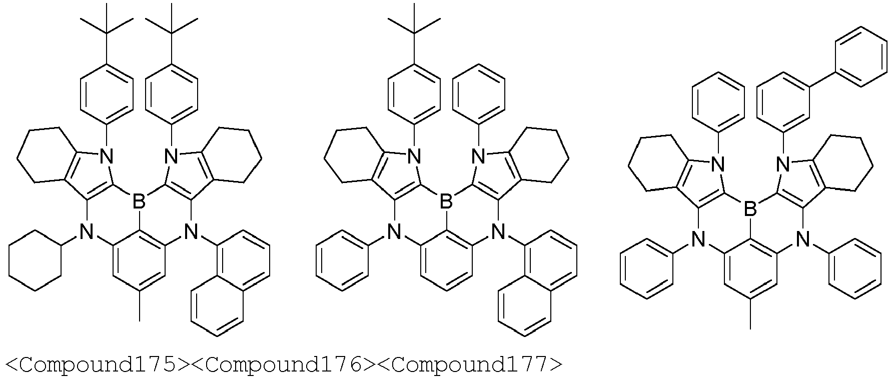

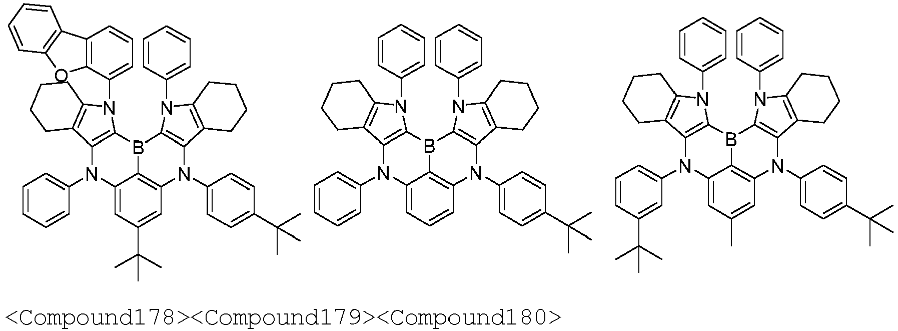

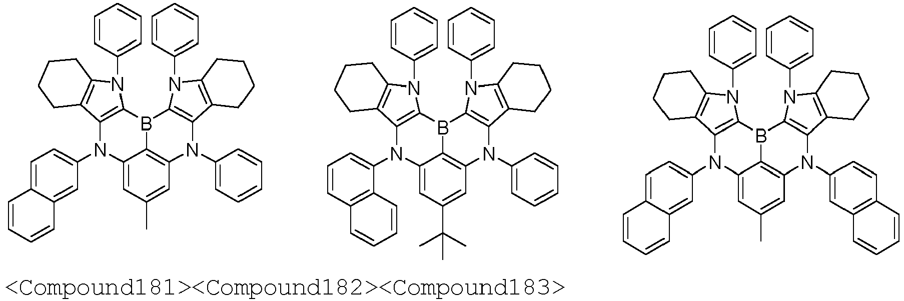

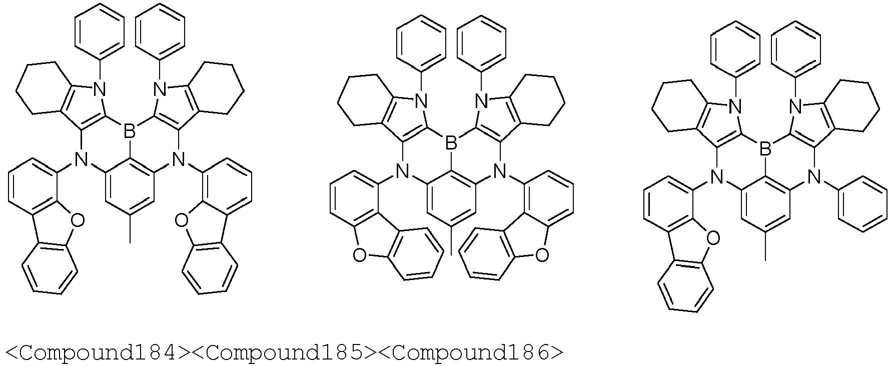

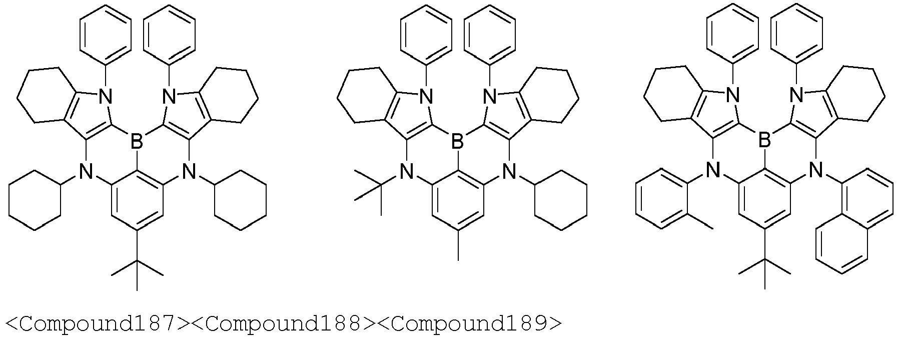

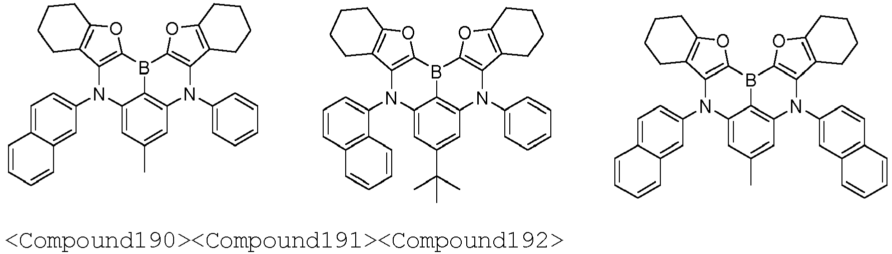

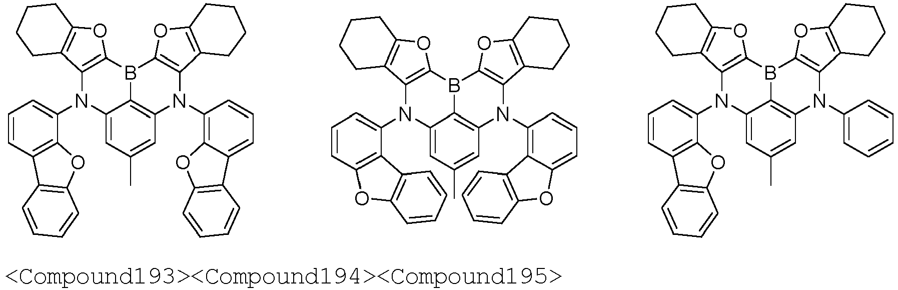

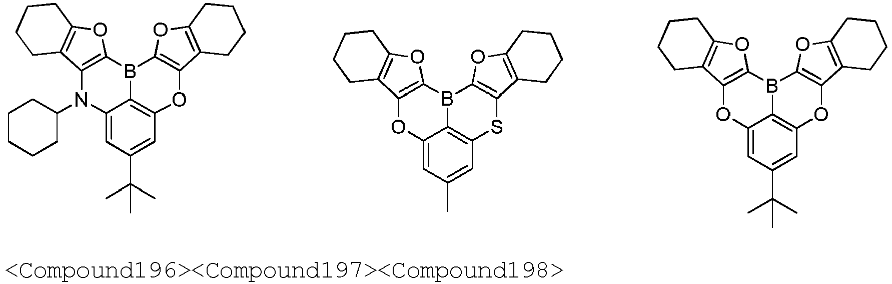

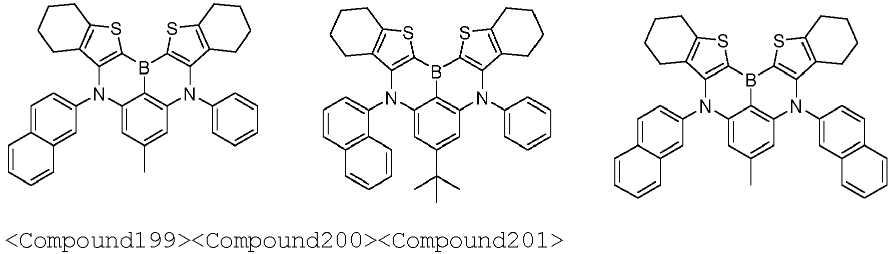

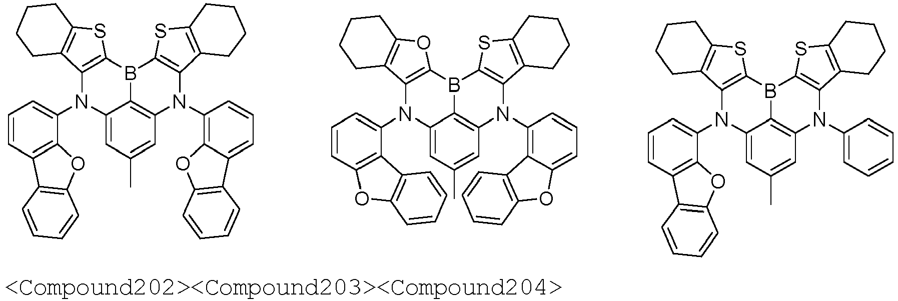

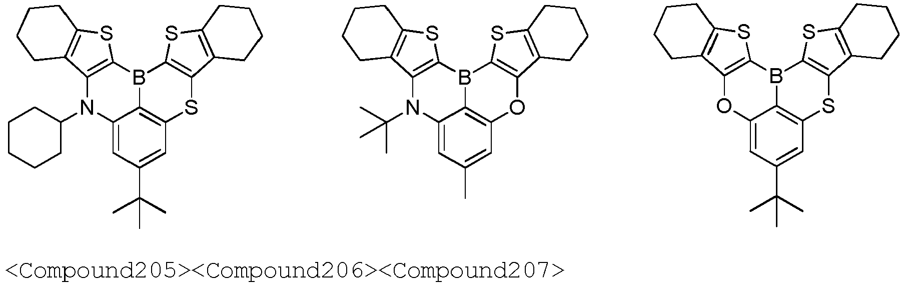

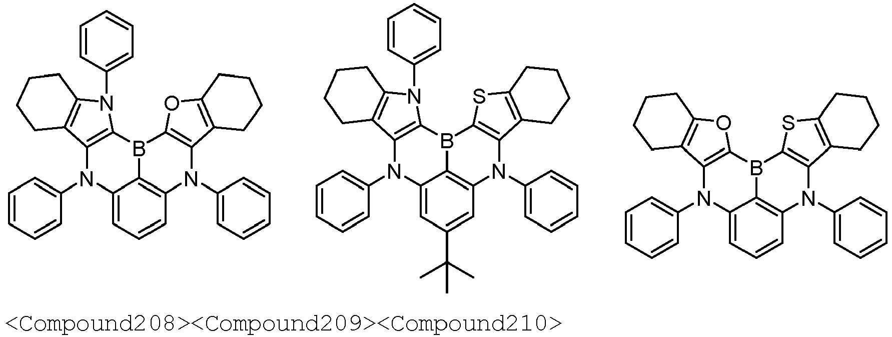

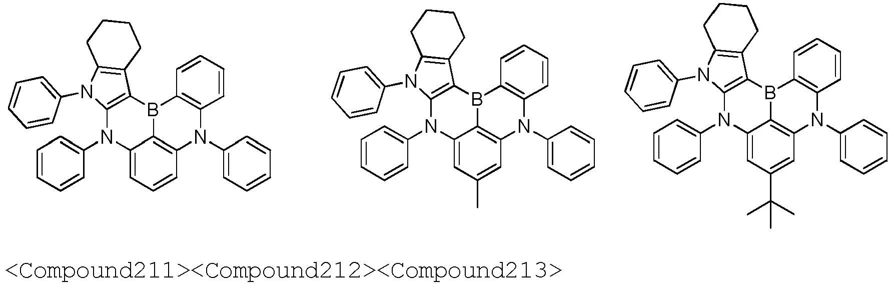

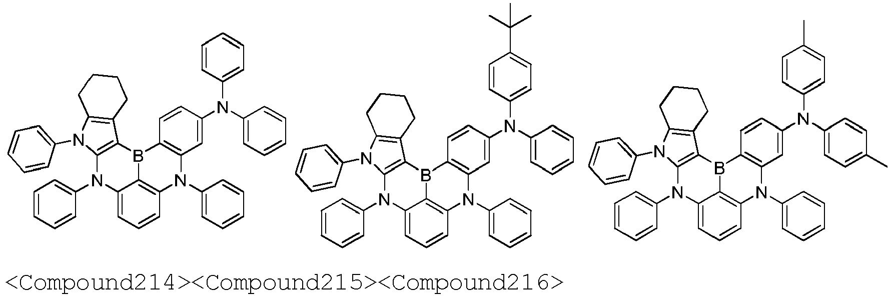

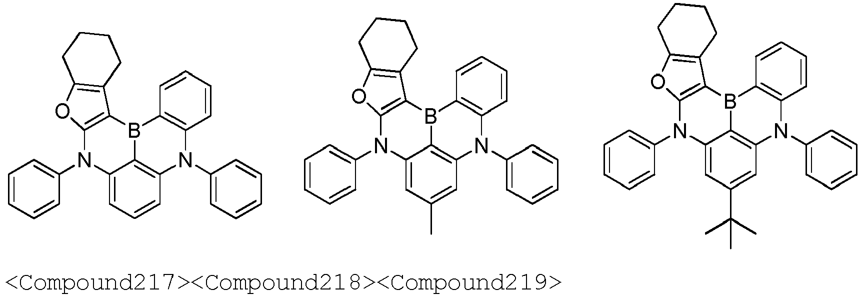

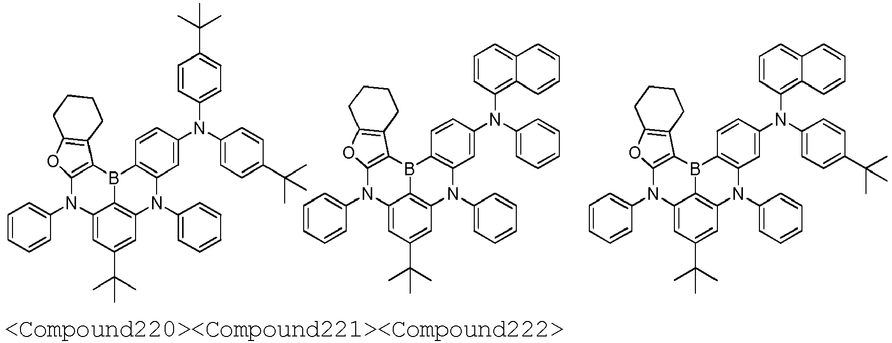

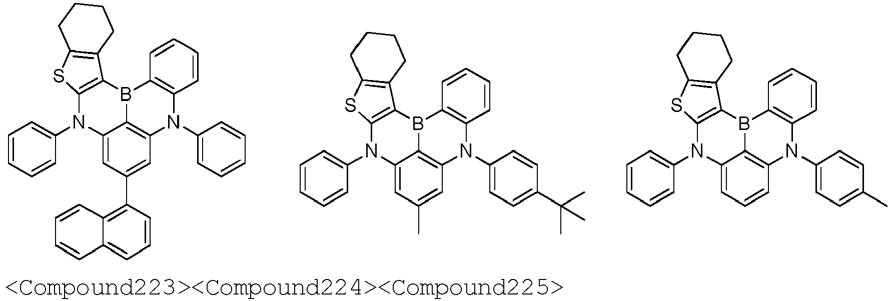

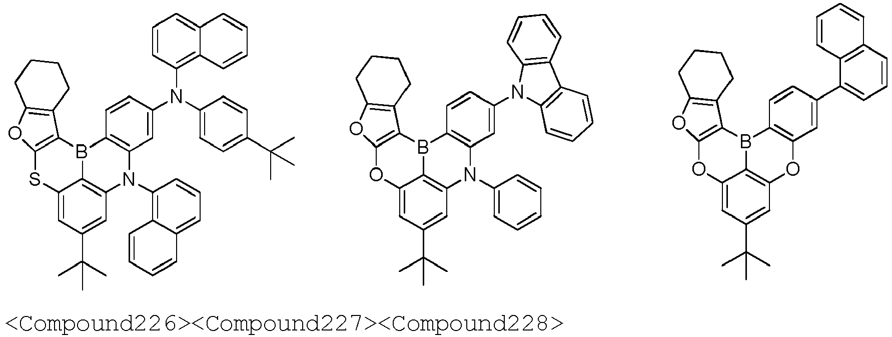

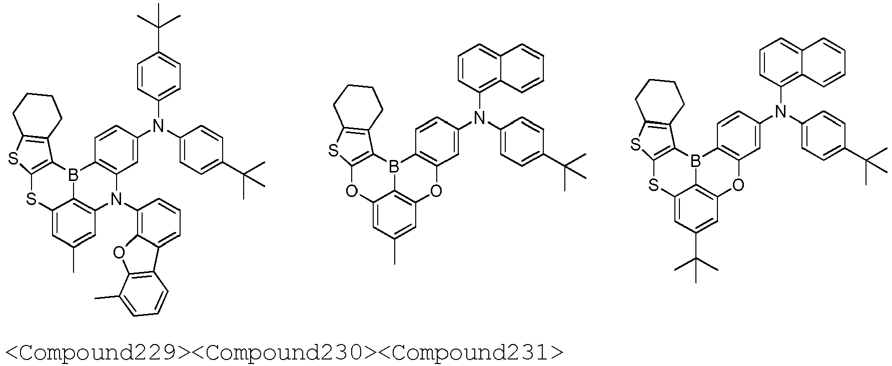

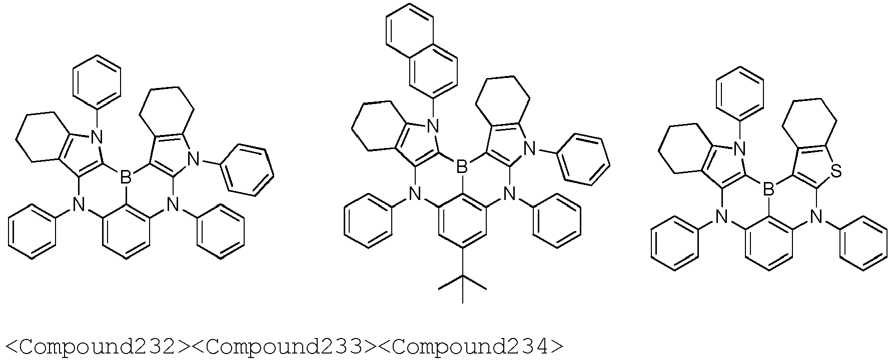

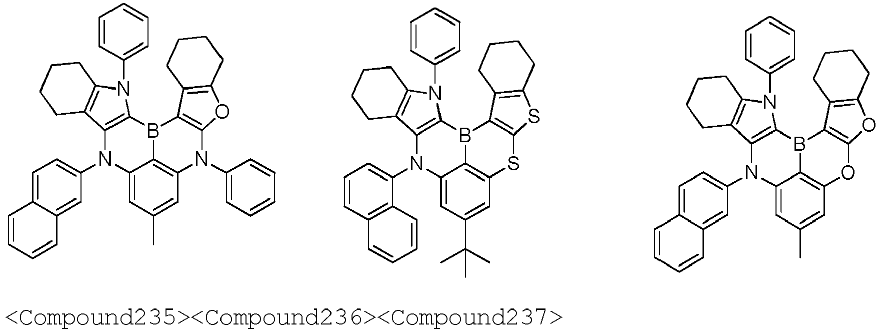

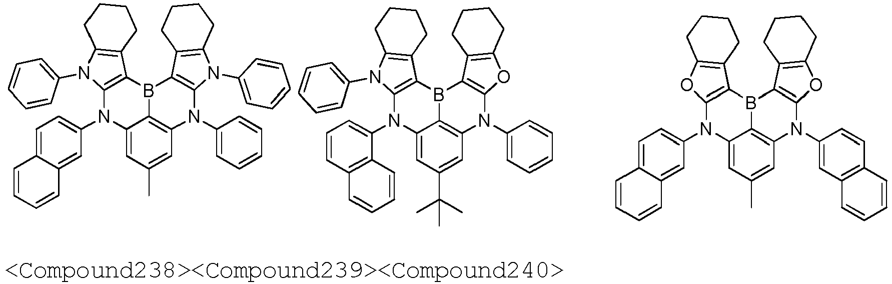

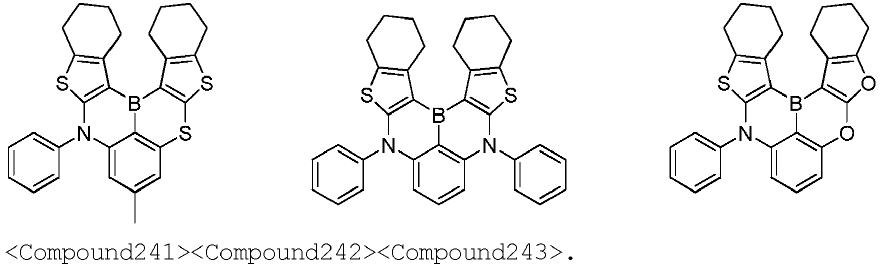

In particular some embodiments thereof, the present disclosure provides an organic light-emitting diode comprising: a first electrode; a second electrode facing the second electrode; and an organic layer interposed between the first electrode and the second electrode, wherein the organic layer includes a boron compound represented by any one of Chemical Formulas A to E.

Throughout the description of the present disclosure, the phrase "(an organic layer) includes at least one organic compound" may be construed to mean that "(an organic layer) may include a single organic compound species or two or more difference species of organic compounds falling within the scope of the present disclosure".

In this regard, the organic layer in the organic light-emitting diode according to the present disclosure may include at least one of a hole injection layer, a hole transport layer, a functional layer capable of both hole injection and hole transport, an electron blocking layer, a light-emitting layer, an electron transport layer, an electron injection layer, and a capping layer.

In more particular embodiments of the present disclosure, the organic layer disposed between the first electrode and the second electrode includes a light-emitting layer composed of a host and a dopant, wherein the boron compound represented by any one of Chemical Formulas A to E serves as the dopant.

In an embodiment, the organic light-emitting diode according to the present disclosure may employ an anthracene derivative represented by the following Chemical Formula F: 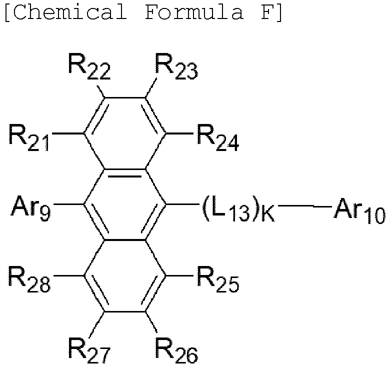 wherein
R₂₁ to R₂₈, which are same or different, are each as defined for R₁ to R₈ in the boron compound above;
Ar₉ and Ar₁₀, which are the same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl 2 to 20 carbon atoms, a substituted or unsubstituted cycloalkyl of 3 to 30 carbon atoms, a substituted or unsubstituted cycloalkenyl 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted alkoxy of 1 to 30 carbon atoms, a substituted or unsubstituted aryloxy of 6 to 30 carbon atoms, a substituted or unsubstituted alkylthio of 1 to 30 carbon atoms, a substituted or unsubstituted arylthioxy of 6 to 30 carbon atoms, a substituted or unsubstituted alkylamine of 1 to 30 carbon atoms, a diarylamino of 12 to 24 carbon atoms, a diheteroarylamino of 2 to 24 carbon atoms, an aryl(heteroaryl)amino of 7 to 24 carbon atoms, a substituted or unsubstituted alkylsilyl of 1 to 30 carbon atoms, and a substituted or unsubstituted arylsilyl of 6 to 30 carbon atoms;
L₁₃, which functions as a linker, is a single bond or is selected from a substituted or unsubstituted arylene of 6 to 20 carbon atoms, and a substituted or unsubstituted heteroarylene of 2 to 20 carbon atoms; and
k is an integer of 1 to 3, wherein when k is 2 or greater, the corresponding L₁₃'s are the same or different.

In a more particular embodiment, the linker L₁₃ may be a single bond or a substituted or unsubstituted arylene of 6 to 20 carbon atoms, and k may be 1 or 2, with the proviso that when k is 2, corresponding L₁₃'s may be the same or different.

For a more exemplary host, Ar₉ in Chemical Formula F may be a substituent represented by the following Chemical Formula F-1: 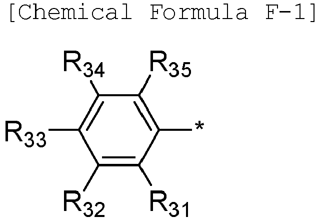 wherein, R₃₁ to R₃₅, which may be same or different, are as defined for R₁ to R₈ above; and may each be linked to an adjacent one to form a saturated or unsaturated cyclic ring.

According to one embodiment, the anthracene derivative may be any one selected from the compounds represented by the following <Chemical Formula F1> to <Chemical Formula F54>:

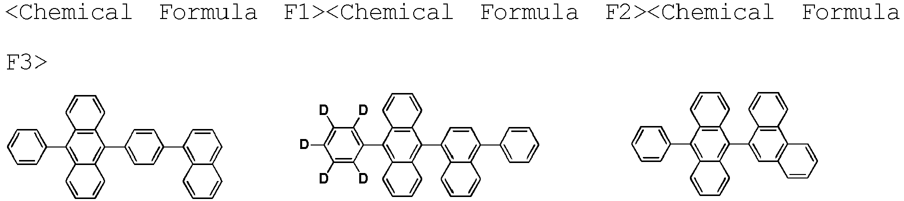

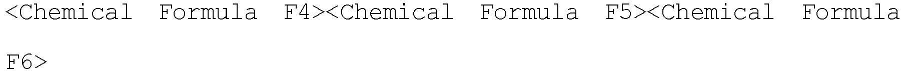

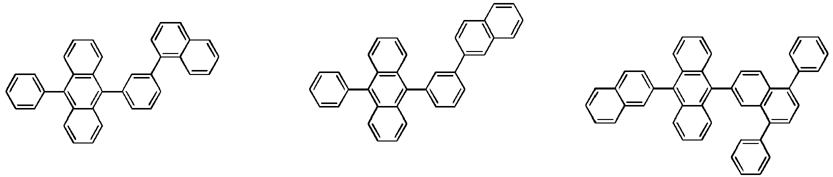

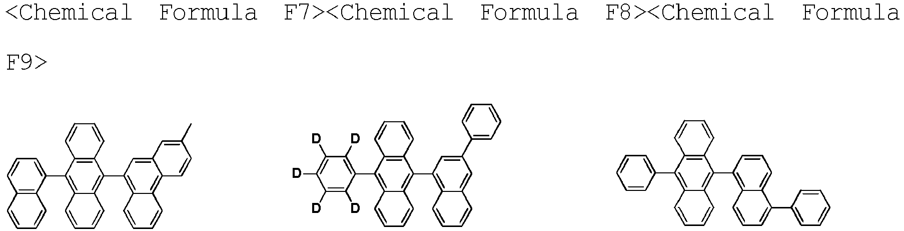

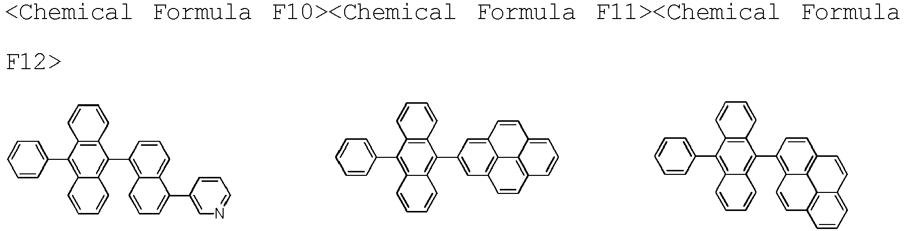

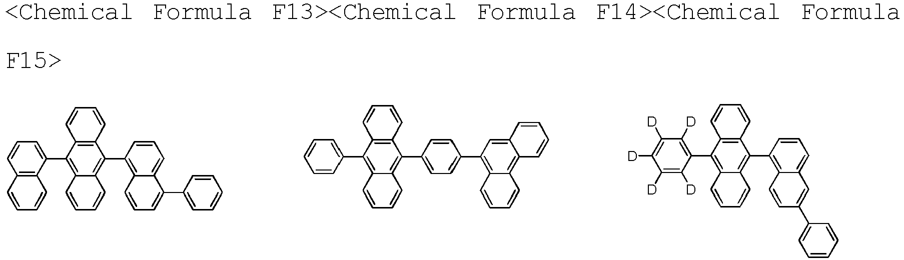

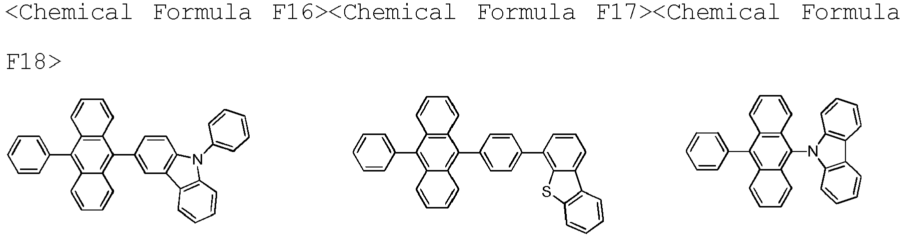

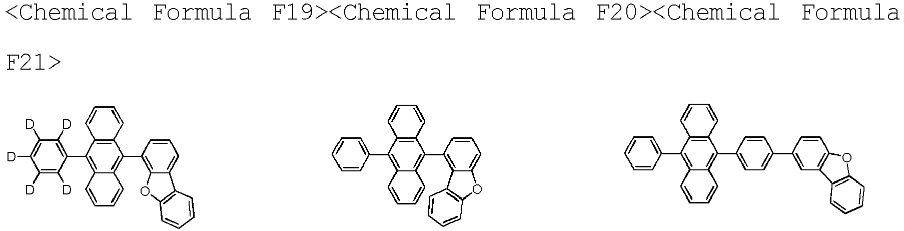

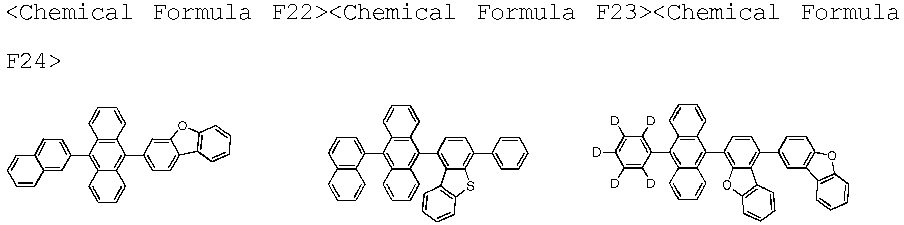

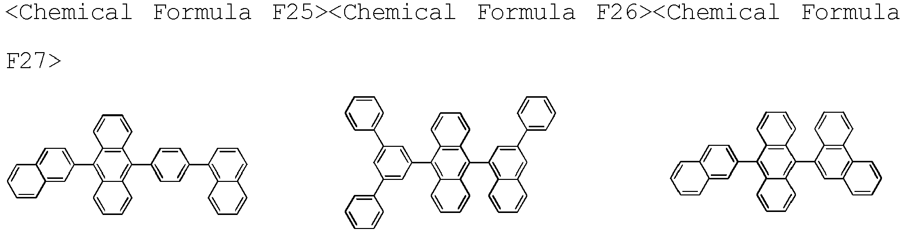

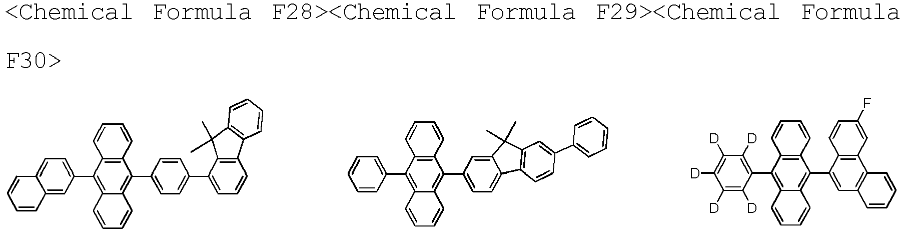

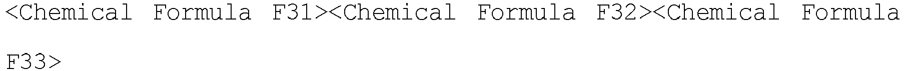

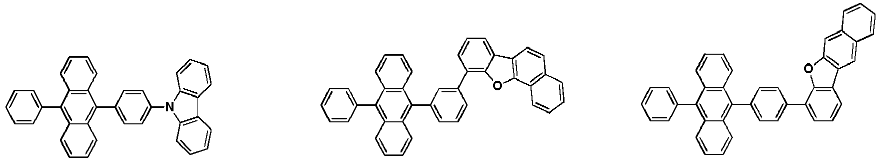

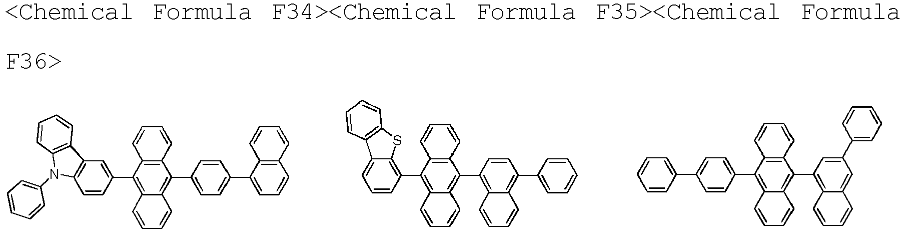

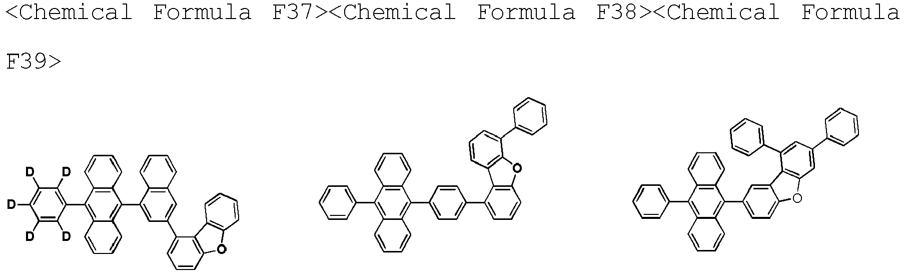

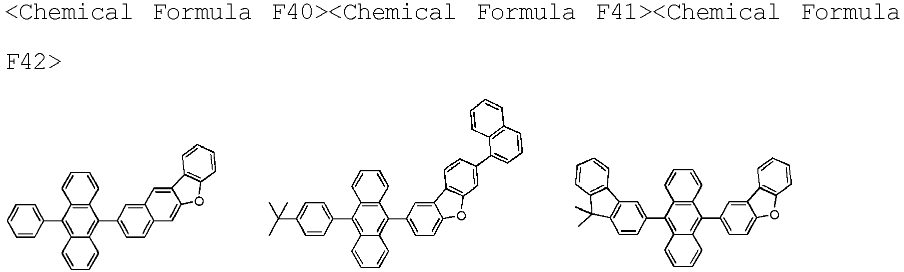

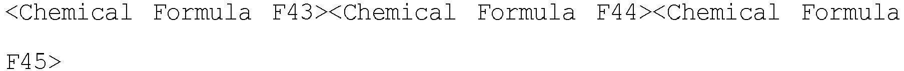

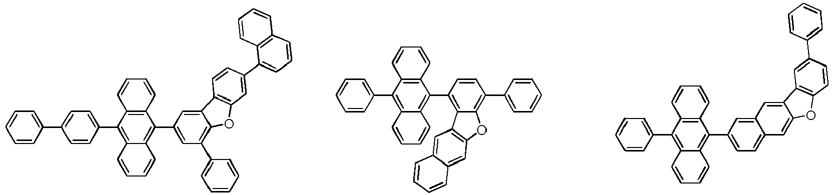

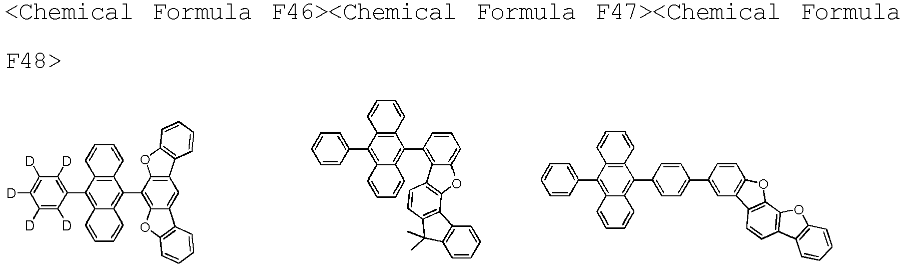

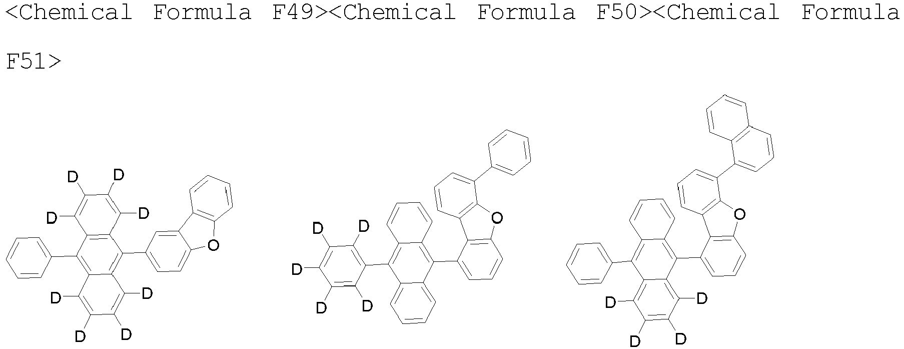

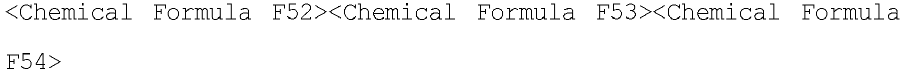

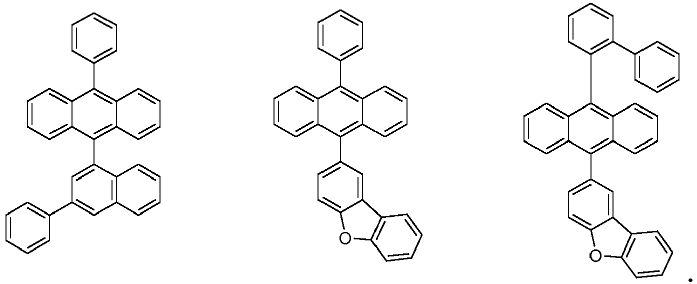

In a particular embodiment thereof, the present invention provides an organic light-emitting diode comprises: an anode as a first electrode; a cathode as a second electrode facing the first electrode; and an organic layer interposed between the anode and the cathode, wherein the organic layer comprises at least one of the boron compounds represented by Chemical Formulas A to E as a dopant and at least one of the compounds represented by Chemical Formula F as a host. Having such structural characteristics, the organic light-emitting diode according to the present disclosure can be driven at a low voltage with high luminous efficiency.

In a particular embodiment, the content of the dopant in the light-emitting layer may range from about 0.01 to 20 parts by weight, based on 100 parts by weight of the host, but is not limited thereto.

In addition to the above-mentioned dopants and hosts, the light-emitting layer may further include various hosts and dopant materials.

Below, the organic light-emitting diode of the present disclosure is explained with reference to the drawing.

FIG. 1 is a schematic cross-sectional view of the structure of an organic light-emitting diode according to an embodiment of the present disclosure.

As shown in FIG. 1, the organic light-emitting diode according to an embodiment of the present disclosure comprises an anode 20, a hole transport layer 40, an organic light-emitting layer 50 containing a host and a dopant, an electron transport layer 60, and a cathode 80, wherein the anode and the cathode serve as a first electrode and a second electrode, respectively, with the interposition of the hole transport layer between the anode and the light-emitting layer, and the electron transport layer between the light-emitting layer and the cathode.

Furthermore, the organic light-emitting diode according to an embodiment of the present disclosure may comprise a hole injection layer 30 between the anode 20 and the hole transport layer 40, and an electron injection layer 70 between the electron transport layer 60 and the cathode 80.

Reference is made to FIG. 1 with regard to the organic light emitting diode of the present disclosure and the fabrication method therefor.

First, a substrate 10 is coated with an anode electrode material to form an anode 20. So long as it is used in a typical organic electroluminescence device, any substrate may be used as the substrate 10. Preferable is an organic substrate or transparent plastic substrate that exhibits excellent transparency, surface smoothness, ease of handling, and waterproofness. As the anode electrode material, indium tin oxide (ITO), indium zinc oxide (IZO), tin oxide (SnO₂), or zinc oxide (ZnO), which are transparent and superior in terms of conductivity, may be used.

A hole injection layer material is applied on the anode 20 by thermal deposition in a vacuum or by spin coating to form a hole injection layer 30. Subsequently, thermal deposition in a vacuum or by spin coating may also be conducted to form a hole transport layer 40 with a hole transport layer material on the hole injection layer 30.

So long as it is typically used in the art, any material may be selected for the hole injection layer without particular limitations thereto. Examples include, but are not limited to, 2-TNATA [4,4',4"-tris(2-naphthylphenyl-phenylamino)-triphenylamine], NPD [N,N'-di(1-naphthyl)-N,N'-diphenylbenzidine)], TPD [N,N'-diphenyl-N,N'-bis(3-methylphenyl)-1,1'-biphenyl-4,4'-diamine], DNTPD [N,N'-diphenyl-N,N'-bis[4-(phenyl-m-tolyl-amino)-phenyl]-biphenyl-4,4'-diamine], and HAT-CN (2,3,6,7,10,11-hexacyanohexaazatriphenylene).

Any material that is typically used in the art may be selected for the hole transport layer without particular limitations thereto. Examples include, but are not limited to, N,N'-bis(3-methylphenyl)-N,N'-diphenyl-[1,1-biphenyl]-4,4'-diamine (TPD) and N,N'-di(naphthalen-1-yl)-N,N'-diphenylbenzidine (a-NPD).

In an embodiment of the present disclosure, an electron blocking layer may be additionally disposed on the hole transport layer. Functioning to prevent the electrons injected from the electron injection layer from entering the hole transport layer from the light-emitting layer, the electron blocking layer is adapted to increase the life span and luminous efficiency of the diode. The electron blocking layer may be formed of any suitable material at a suitable position between the light emitting layer and the hole injection layer. Particularly, the electron blocking layer may be formed between the light emitting layer and the hole transport layer.

Next, the light-emitting layer 50 may be deposited on the hole transport layer 40 or the electron blocking layer by deposition in a vacuum or by spin coating.

Herein, the light-emitting layer may contain a host and a dopant and the materials are as described above.

In some embodiments of the present disclosure, the light-emitting layer particularly ranges in thickness from 50 to 2,000 Å.

Meanwhile, the electron transport layer 60 is applied on the light-emitting layer by deposition in a vacuum and spin coating.

A material for use in the electron transport layer functions to stably carry the electrons injected from the electron injection electrode (cathode), and may be an electron transport material known in the art. Examples of the electron transport material known in the art include quinoline derivatives, particularly, tris(8-quinolinolate)aluminum (Alq₃), Liq, TAZ, BAlq, beryllium bis(benzoquinolin-10-olate) (Bebq₂), Compound 201, Compound 202, BCP, and oxadiazole derivatives such as PBD, BMD, and BND, but are not limited thereto:

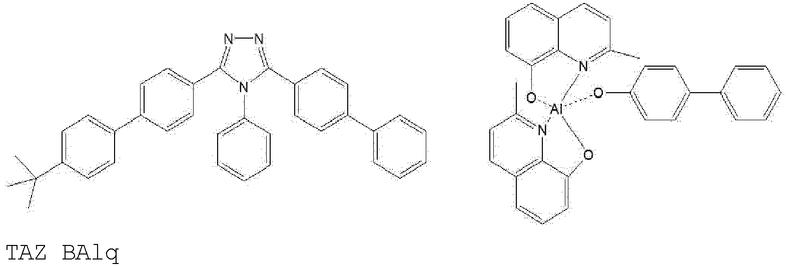

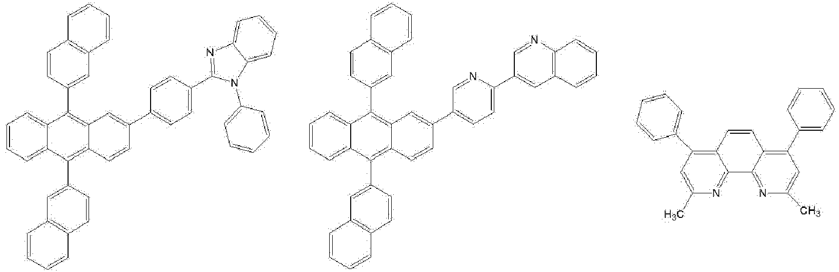

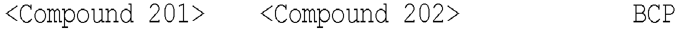

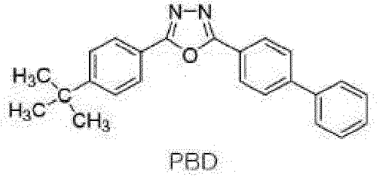

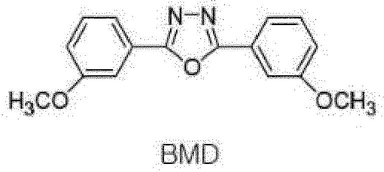

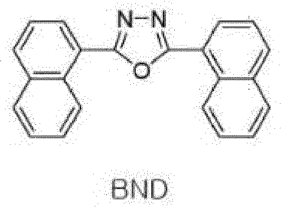

In the organic light emitting diode of the present disclosure, an electron injection layer (EIL) that functions to facilitate electron injection from the cathode may be deposited on the electron transport layer. The material for the EIL is not particularly limited.

Any material that is conventionally used in the art can be available for the electron injection layer without particular limitations. Examples include CsF, NaF, LiF, Li₂O, and BaO. Deposition conditions for the electron injection layer may vary, depending on compounds used, but may be generally selected from condition scopes that are almost the same as for the formation of hole injection layers.

The electron injection layer may range in thickness from about 1 Å to about 100 Å, and particularly from about 3 Å to about 90 Å. Given the thickness range for the electron injection layer, the diode can exhibit satisfactory electron injection properties without actually elevating a driving voltage.

In order to facilitate electron injection, the cathode may be made of a material having a small work function, such as metal or metal alloy such as lithium (Li), magnesium (Mg), calcium (Ca), an alloy aluminum (Al) thereof, aluminum-lithium (Al-Li), magnesium-indium (Mg-In), and magnesium-silver (Mg-Ag). Alternatively, ITO or IZO may be employed to form a transparent cathode for an organic light-emitting diode.

Moreover, the organic light-emitting diode of the present disclosure may further comprise a light-emitting layer containing a blue, green, or red luminescent material that emits radiations in the wavelength range of 380 nm to 800 nm. That is, the light-emitting layer in the present disclosure has a multi-layer structure wherein the blue, green, or red luminescent material may be a fluorescent material or a phosphorescent material.

Furthermore, at least one selected from among the layers may be deposited using a single-molecule deposition process or a solution process.

Here, the deposition process is a process by which a material is vaporized in a vacuum or at a low pressure and deposited to form a layer, and the solution process is a method in which a material is dissolved in a solvent and applied for the formation of a thin film by means of inkjet printing, roll-to-roll coating, screen printing, spray coating, dip coating, spin coating, etc.

Also, the organic light-emitting diode of the present disclosure may be applied to a device selected from among flat display devices, flexible display devices, monochrome or grayscale flat illumination devices, and monochrome or grayscale flexible illumination devices.

A better understanding of the present disclosure may be obtained through the following examples which are set forth to illustrate, but are not to be construed as limiting the present invention.

### (EXAMPLES)

### EXAMPLE 1. Synthesis of Compound 1

### Synthesis Example 1-(1): Synthesis of Intermediate 1-a

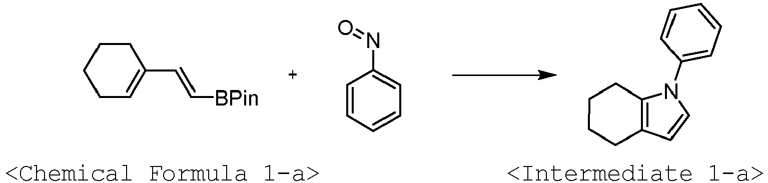

In a round-bottom flask, a solution of <Chemical Formula 1-a> (50 g, 466 mmol) in methanol (500 ml) was stirred together with nitrosobenzene 124.7 g (1165 mmol) at room temperature for 16 hours. After completion of the reaction, the reaction mixture was subjected to layer separation. Column separation afforded <Intermediate 1-a> (45.9 g). (yield 50%)

### Synthesis Example 1-(2): Synthesis of Intermediate 1-b

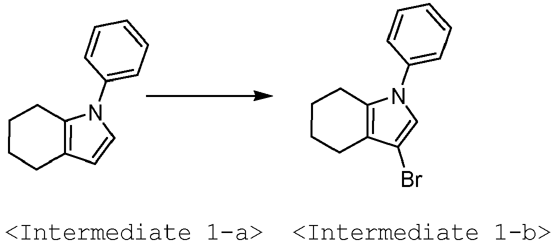

In a round-bottom flask, <Intermediate 1-a> (45.9 g, 233 mmol), N-bromosuccinimide (41.5 g, 423 mmol), and dimethylformamide (450 ml) were together stirred at room temperature for 6 hours under a nitrogen atmosphere. After completion of the reaction, the reaction mixture was subjected to layer separation. The organic layer thus formed was concentrated in a vacuum, followed by column separation to afford <Intermediate 1-b> (57.9 g). (yield 90%)

### Synthesis Example 1-(3): Synthesis of Intermediate 1-c

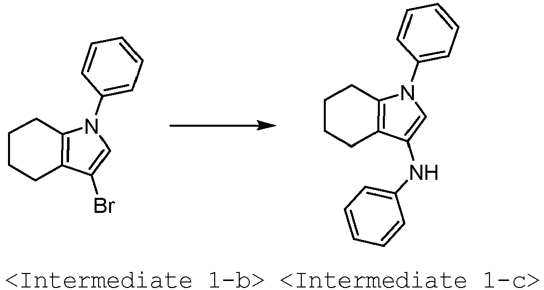

In a round-bottom flask, <Intermediate 1-b> (57.9 g, 210 mmol), aniline (23.5 g, 252 mmol), tris(dibenzirideneacetone)dipalladium (3.8 g, 4.2 mmol), sodium tert-butoxide (40.3 g, 420 mmol), 2, 2'-bis(diphenylphosphino)-1,1'-binaphthyl (2.6 g, 4.2 mmol), and tolutne (600 ml) were stirred under reflux. The organic layer thus formed was concentrated in a vacuum, followed by column separation to afford <Intermediate 1-c> (52.0 g). (yield 86%)

### Synthesis Example 1-(4): Synthesis of Intermediate 1-d

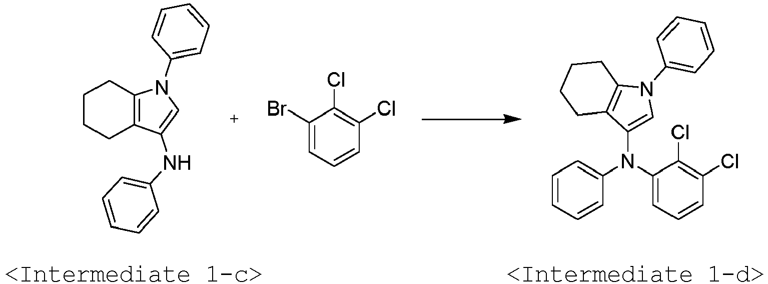

<Intermediate 1-d> was synthesized in the same manner as in Synthesis Example 1-(3) with the exception of using 1-bromo-2,3-dichlorobenzene and <Intermediate 1-c> instead of <Intermediate 1-b> and aniline, respectively.

### Synthesis Example 1-(5): Synthesis of Intermediate 1-e

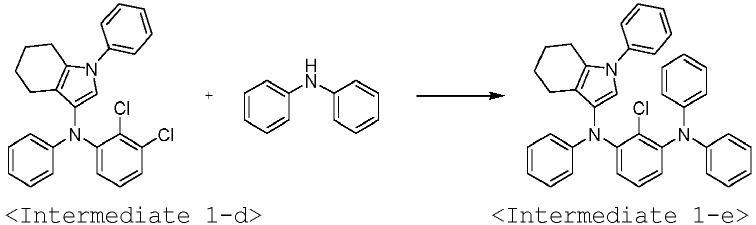

<Intermediate 1-e> was synthesized in the same manner as in Synthesis Example 1-(4) with the exception of using diphenylamine and <Intermediate 1-d> instead of <Intermediate 1-c> and 1-bromo-2,3-dichlorobenzene, respectively.

### Synthesis Example 1-(6): Synthesis of Compound 1

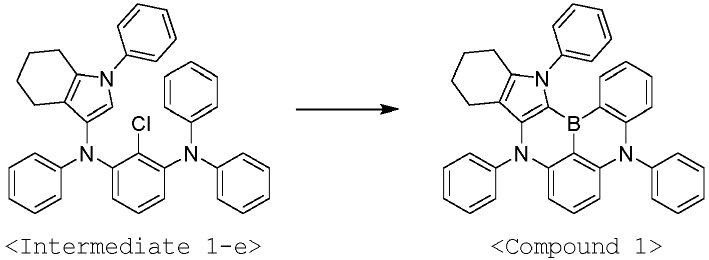

In a round-bottom flask, <Intermediate 1-e> (20.1 g, 35.6 mmol) and tert-butyl benzene (200 ml) were stirred under a nitrogen atmosphere. The mixture was cooled to 0°C and added with drops of 1.7 M tert-butyl lithium (52.3 ml, 89 mmol) before being stirred at 60°C for 3 hours. The temperature was lowered to -30°C and boron tribromide (17.8 g, 71.2 mmol) was added to the mixture which was then stirred at room temperature for 1 hour. Subsequently, diisopropylethylamine (9.2 g, 71.2 mmol) was added, followed by stirring at 120°C for 3 hours. The organic layer thus formed was concentrated in a vacuum, followed by column separation to afford <Compound 1> (5.7 g). (yield 30%)

MS (MALDI-TOF) : m/z 539.25 [M⁺]

### EXAMPLE 2. Synthesis of Compound 46

### Synthesis Example 2-(1): Synthesis of Intermediate 2-a

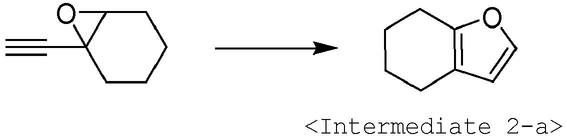

In a round-bottom flask purged with nitrogen, molybdenum hexacarbonyl (32.4 g, 123 mmol) was stirred together with triethylamine (100 ml) and diethylether (400 ml) for 20 minutes. After exposure to a UV lamp, 1-ethynyl -7-oxabicyclo[4.1.0]heptane (50.0 g, 410 mmol) and diethyl ether (20 ml) were added together and stirred at room temperature for 18 hours. The organic layer thus formed was concentrated in a vacuum, followed by column separation to afford <Intermediate 2-a> (42.5 g). (yield 85%)

### Synthesis Example 2-(2): Synthesis of Intermediate 2-b

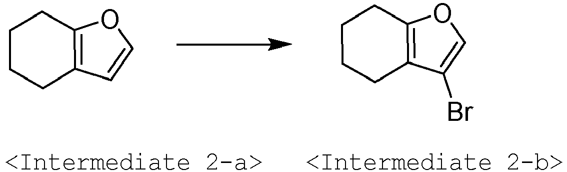

<Intermediate 2-b>was synthesized in the same manner as in Synthesis Example 1-(2) with the exception of using <Intermediate 2-a> instead of <Intermediate 1-a>.

### Synthesis Example 2-(3): Synthesis of Intermediate 2-c

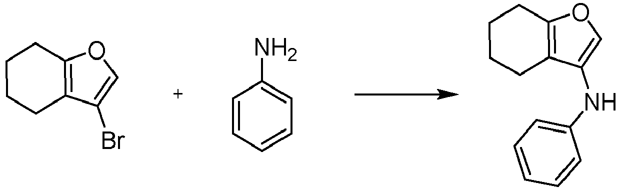

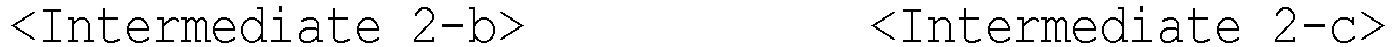

<Intermediate 2-c> was synthesized in the same manner as in Synthesis Example 1-(3) with the exception of using <Intermediate 2-b> instead of <Intermediate 1-b>.

### Synthesis Example 2-(4): Synthesis of Intermediate 2-d

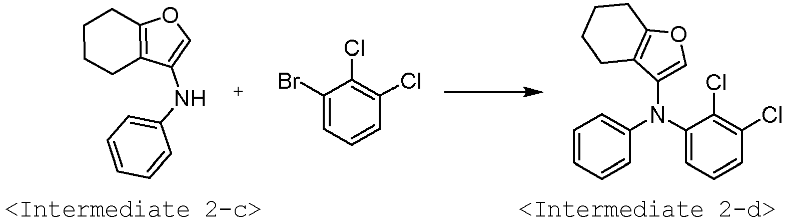

<Intermediate 2-d> was synthesized in the same manner as in Synthesis Example 1-(4) with the exception of using <Intermediate 2-c> instead of <Intermediate 1-c>.

### Synthesis Example 2-(5): Synthesis of Intermediate 2-e

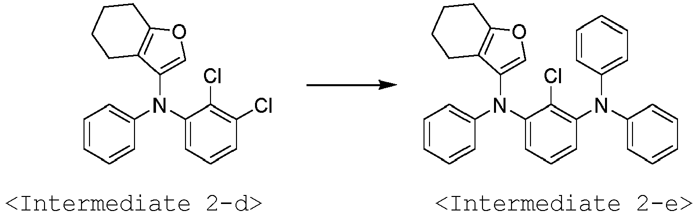

<Intermediate 2-e> was synthesized in the same manner as in Synthesis Example 1-(4) with the exception of using diphenylamine and <Intermediate 2-d> instead of <Intermediate 1-c> and 1-bromo-2,3-dichlorobenzene, respectively.

### Synthesis Example 2-(6): Synthesis of Compound 46

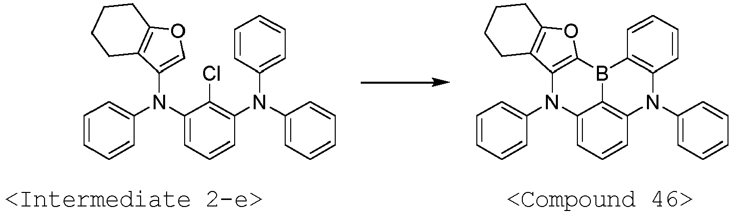

<Compound 46> was synthesized in the same manner as in Synthesis Example 1-(6) with the exception of using <Intermediate 2-e> instead of <Intermediate 1-e>.

MS (MALDI-TOF) : m/z 464.21 [M⁺]

### EXAMPLE 3. Synthesis of Compound 88

### Synthesis Example 3-(1): Synthesis of Intermediate 3-a

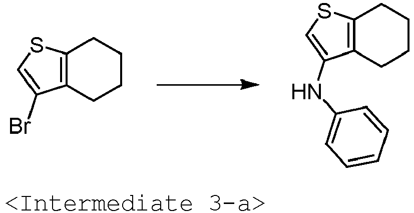

<Intermediate 3-a> was synthesized in the same manner as in Synthesis Example 1-(3) with the exception of using 3-bromo-4,5,6,7-tetrahydrobenzothiophene instead of <Intermediate 1-b>.

### Synthesis Example 3-(2): Synthesis of Intermediate 3-b

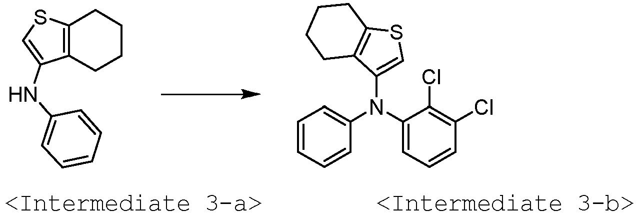

<Intermediate 3-b> was synthesized in the same manner as in Synthesis Example 1-(4) with the exception of using <Intermediate 3-a> instead of <Intermediate 1-c>.

### Synthesis Example 3-(3): Synthesis of Intermediate 3-c

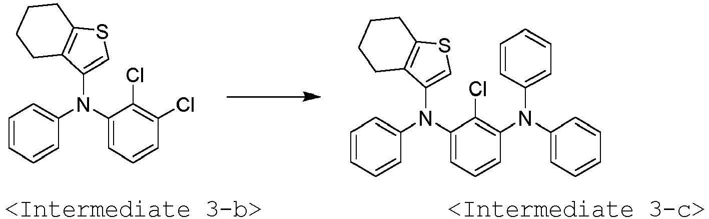

<Intermediate 3-c> was synthesized in the same manner as in Synthesis Example 1-(4) with the exception of using diphenylamine and <Intermediate 3-b> instead of <Intermediate 1-c> and 1-bromo-2,3-dichlorobenzene, respectively.

### Synthesis Example 3-(4): Synthesis of Compound 88

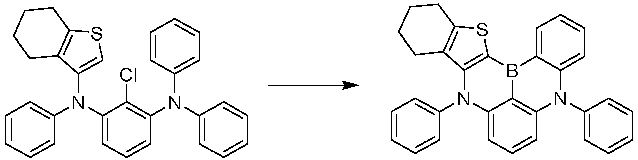

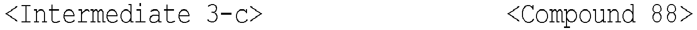

<Compound 88> was synthesized in the same manner as in Synthesis Example 1-(6) with the exception of using <Intermediate 3-c> instead of <Intermediate 1-e>.

MS (MALDI-TOF) : m/z 480.18 [M⁺]

### EXAMPLE 4. Synthesis of Compound 37

### Synthesis Example 4-(1): Synthesis of Intermediate 4-a

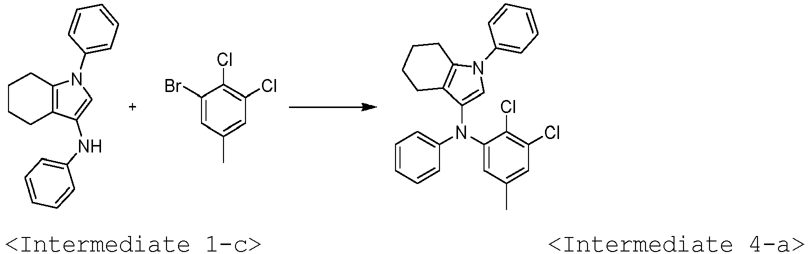

<Intermediate 4-a> was synthesized in the same manner as in Synthesis Example 1-(4) with the exception of using 1-bromo-2,3-dichloro-5-methylbenzene instead of 1-bromo-2,3-dichlorobenzene.

### Synthesis Example 4-(2): Synthesis of Intermediate 4-b

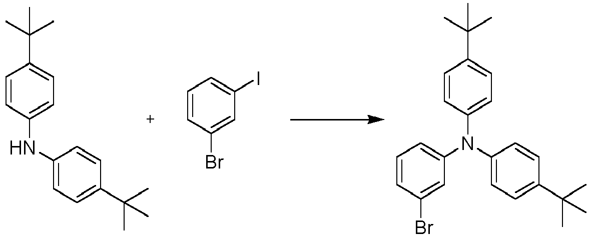

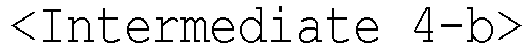

<Intermediate 4-b> was synthesized in the same manner as in Synthesis Example 1-(4) with the exception of using bis(4-tert-butylphenyl)amine and 1-bromo-3-iodobenzene instead of <Intermediate 1-c> and 1-bromo-2,3-dichlorobenzene, respectively.

### Synthesis Example 4-(3): Synthesis of Intermediate 4-c

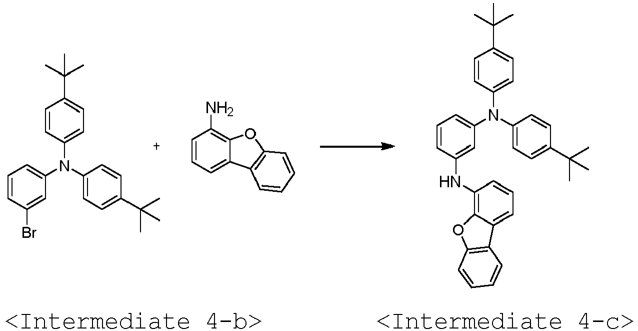

<Intermediate 4-c> was synthesized in the same manner as in Synthesis Example 1-(3) with the exception of using<Intermediate 4-b> and 4-dibenzofuranamine instead of <Intermediate 1-b> and aniline, respectively.

### Synthesis Example 4-(4): Synthesis of Intermediate 4-d

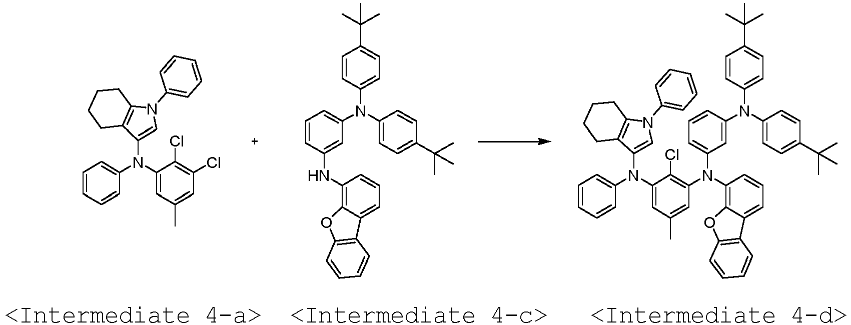

<Intermediate 4-d> was synthesized in the same manner as in Synthesis Example 1-(4) with the exception of using <Intermediate 4-c> and <Intermediate 4-a> instead of <Intermediate 1-c> and 1-bromo-2,3-dichlorobenzene, respectively.

### Synthesis Example 4-(5): Synthesis of Compound 37

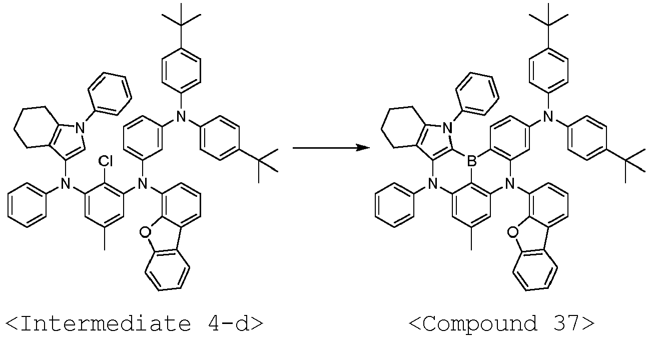

<Compound 37> was synthesized in the same manner as in Synthesis Example 1-(6) with the exception of using <Intermediate 4-d> instead of <Intermediate 1-e>.

MS (MALDI-TOF) : m/z 922.48 [M⁺]

### EXAMPLE 5. Synthesis of Compound 32

### Synthesis Example 5-(1): Synthesis of Intermediate 5-a

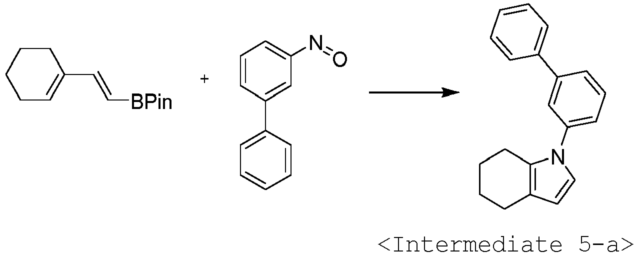

<Intermediate 5-a> was synthesized in the same manner as in Synthesis Example 1-(1) with the exception of using 3-nitrosobiphenyl instead of nitrosobenzene.

### Synthesis Example 5-(2): Synthesis of Intermediate 5-b

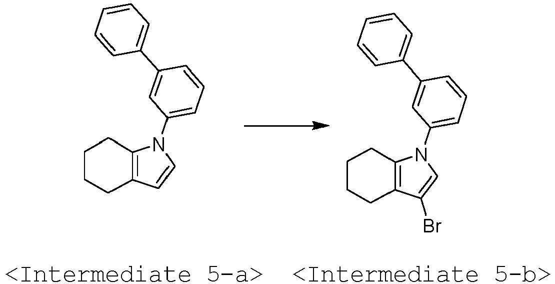

<Intermediate 5-b> was synthesized in the same manner as in Synthesis Example 1-(2) with the exception of using <Intermediate 5-a> instead of <Intermediate 1-a>.

### Synthesis Example 5-(3): Synthesis of Intermediate 5-c

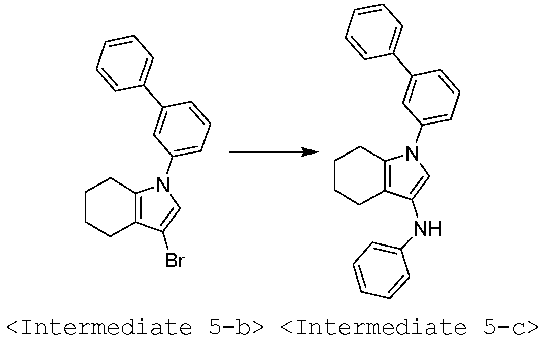

<Intermediate 5-c> was synthesized in the same manner as in Synthesis Example 1-(3) with the exception of using <Intermediate 5-b> instead of <Intermediate 1-b>.

### Synthesis Example 5-(4): Synthesis of Intermediate 5-d

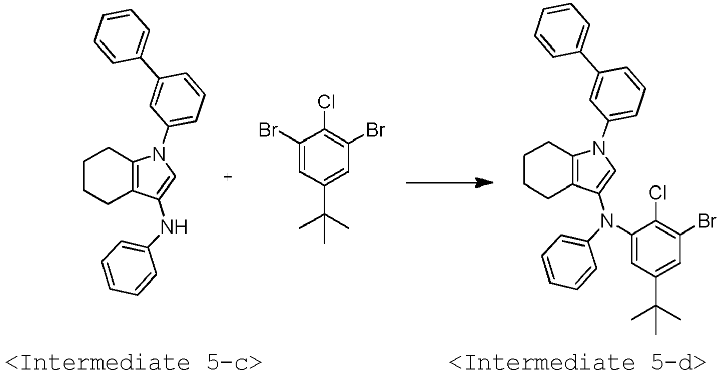

<Intermediate 5-d> was synthesized in the same manner as in Synthesis Example 1-(4) with the exception of using <Intermediate 5-c> and 4-chloro-3,5-dibromo-tert-butyl benzene instead of <Intermediate 1-c> and 1-bromo-2,3-dichlorobenzene, respectively.

### Synthesis Example 5-(5): Synthesis of Intermediate 5-e

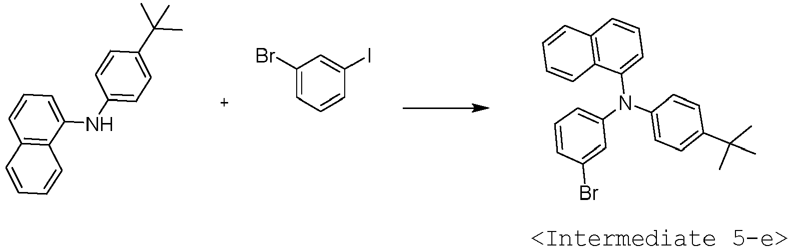

<Intermediate 5-e> was synthesized in the same manner as in Synthesis Example 1-(4) with the exception of using n-(4-tert-butylphenyl)naphthalene-1-amine and 1-bromo-3-iodobenzene instead of <Intermediate 1-c> and 1-bromo-2,3-dichlorobenzene, respectively.

### Synthesis Example 5-(6): Synthesis of Intermediate 5-f

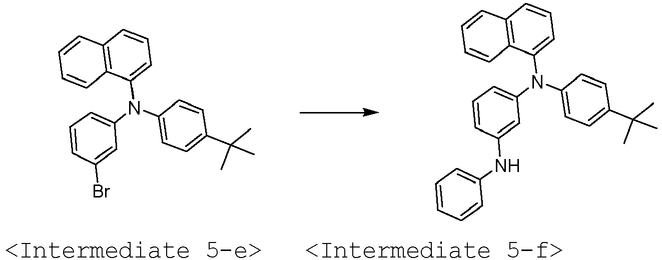

<Intermediate 5-f> was synthesized in the same manner as in Synthesis Example 1-(3) with the exception of using <Intermediate 5-e> instead of <Intermediate 1-b>.

### Synthesis Example 5-(7): Synthesis of Intermediate 5-g

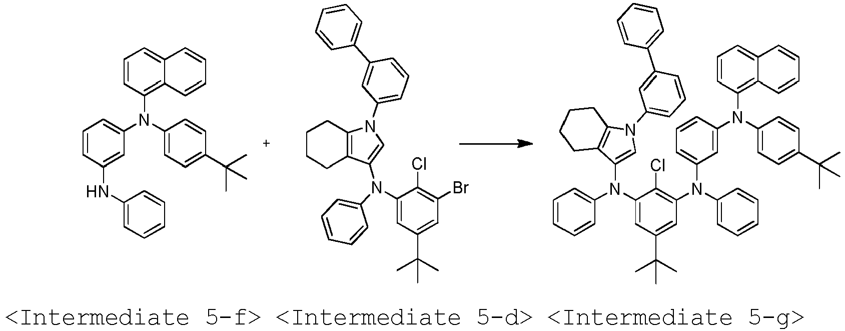

<Intermediate 5-g> was synthesized in the same manner as in Synthesis Example 1-(4) with the exception of using < Intermediate 5-f> and <Intermediate 5-d> instead of <Intermediate 1-c> and 1-bromo-2,3-dichlorobenzene, respectively.

### Synthesis Example 5-(8): Synthesis of Compound 32

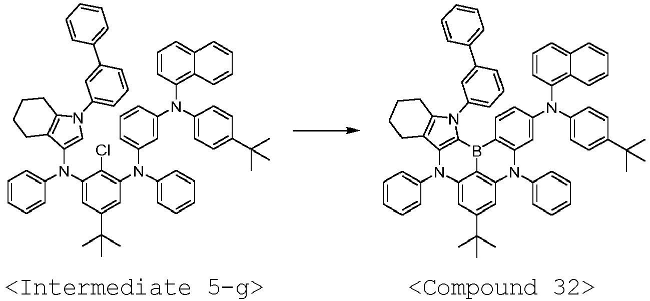

<Compound 32> was synthesized in the same manner as in Synthesis Example 1-(6) with the exception of using <Intermediate 5-g> instead of <Intermediate 1-e>.

MS (MALDI-TOF) : m/z 944.50 [M⁺]

### EXAMPLE 6. Synthesis of Compound 64

### Synthesis Example 6-(1): Synthesis of Intermediate 6-a

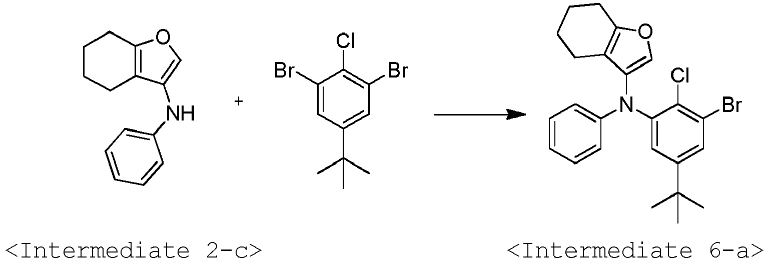

<Intermediate 6-a> was synthesized in the same manner as in Synthesis Example 1-(4) with the exception of using <Intermediate 2-c> and 4-chloro-3,5-dibromo-tert-butyl benzene instead of <Intermediate 1-c> and 1-bromo-2,3-dichlorobenzene, respectively.

### Synthesis Example 6-(2): Synthesis of Intermediate 6-b

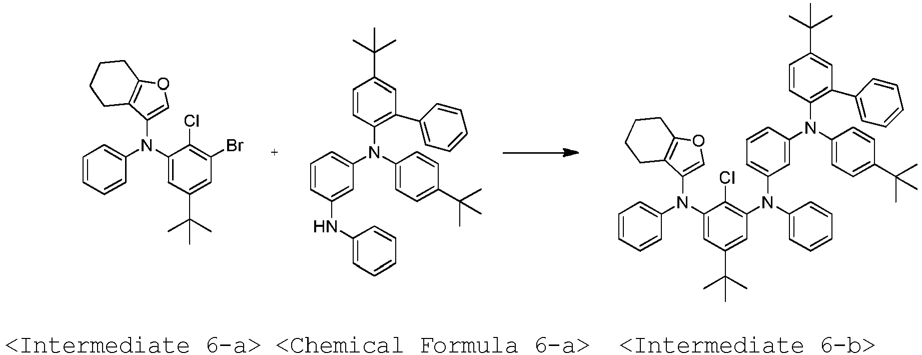

<Intermediate 6-b> was synthesized in the same manner as in Synthesis Example 1-(4) with the exception of using <Chemical Formula 6-a> and <Intermediate 6-a> instead of <Intermediate 1-c> and 1-bromo-2,3-dichlorobenzene, respectively.

### Synthesis Example 6-(3): Synthesis of Compound 64

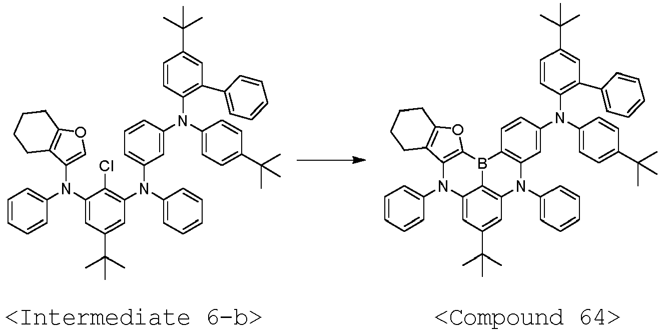

<Compound 64> was synthesized in the same manner as in Synthesis Example 1-(6) with the exception of using <Intermediate 6-b> instead of <Intermediate 1-e>.

MS (MALDI-TOF) : m/z 875.50 [M⁺]

### EXAMPLE 7. Synthesis of Compound 65

### Synthesis Example 7-(1): Synthesis of Intermediate 7-a

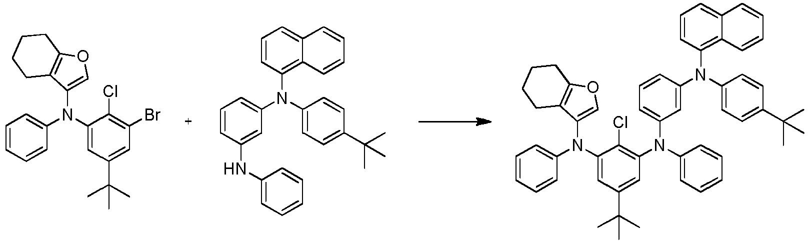

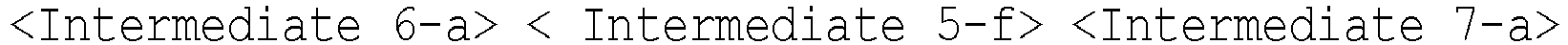

<Intermediate 7-a> was synthesized in the same manner as in Synthesis Example 1-(4) with the exception of using < Intermediate 5-f> and <Intermediate 6-a> instead of <Intermediate 1-c> and 1-bromo-2,3-dichlorobenzene, respectively.

### Synthesis Example 7-(2): Synthesis of Compound 65

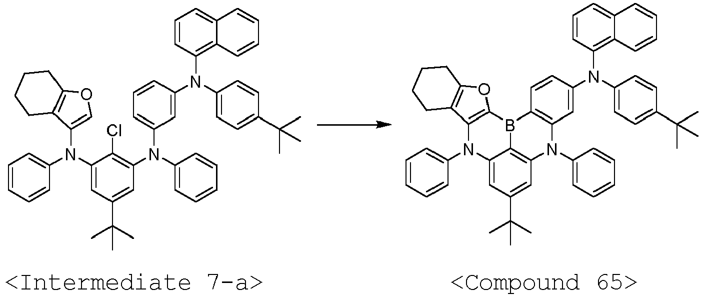

<Compound 65> was synthesized in the same manner as in Synthesis Example 1-(6) with the exception of using <Intermediate 7-a> instead of <Intermediate 1-e>.

MS (MALDI-TOF) : m/z 793.42 [M⁺]

### EXAMPLE 8. Synthesis of Compound 115

### Synthesis Example 8-(1): Synthesis of Intermediate 8-a

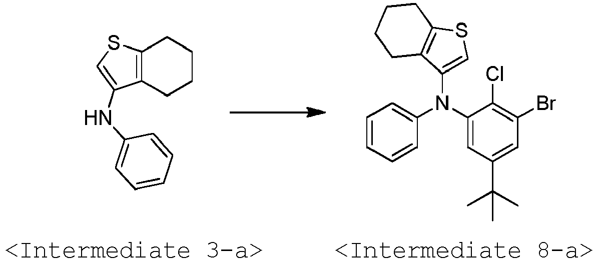

<Intermediate 8-a> was synthesized in the same manner as in Synthesis Example 1-(4) with the exception of using <Intermediate 3-a> and 4-chloro-3,5-dibromo-tert-butyl benzene instead of <Intermediate 1-c> and 1-bromo-2,3-dichlorobenzene, respectively.

### Synthesis Example 8-(2): Synthesis of Intermediate 8-b

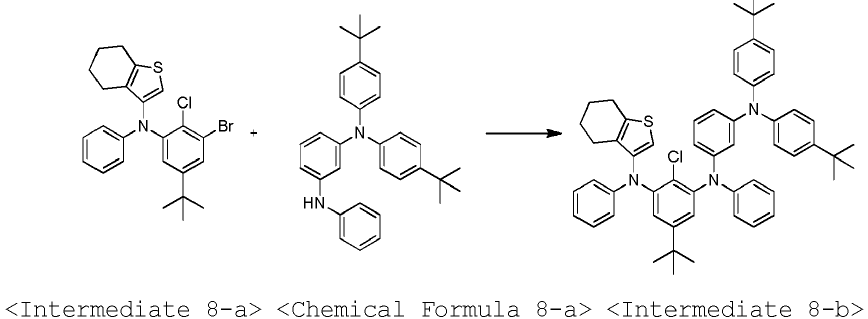

<Intermediate 8-b> was synthesized in the same manner as in Synthesis Example 1-(4) with the exception of using <Chemical Formula 8-a> and <Intermediate 8-a> instead of <Intermediate 1-c> and 1-bromo-2,3-dichlorobenzene, respectively.

### Synthesis Example 8-(3): Synthesis of Compound 115

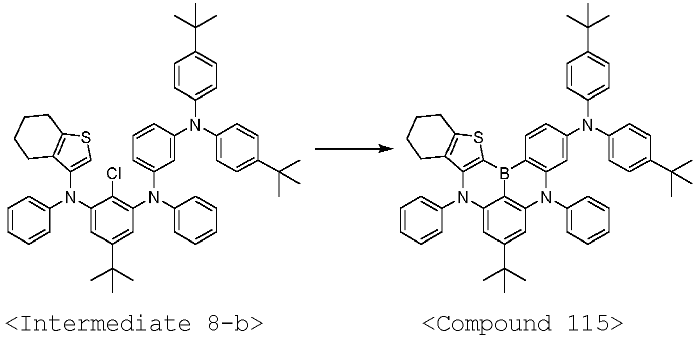

<Compound 115> was synthesized in the same manner as in Synthesis Example 1-(6) with the exception of using <Intermediate 8-b> instead of <Intermediate 1-e>.

MS (MALDI-TOF) : m/z 815.44 [M⁺]

### EXAMPLE 9. Synthesis of Compound 119

### Synthesis Example 9-(1): Synthesis of Intermediate 9-a

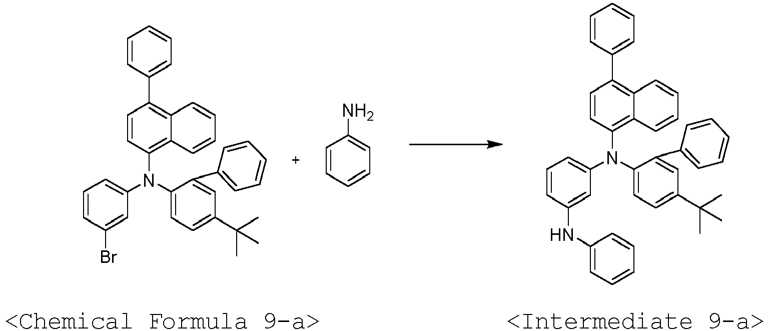

<Intermediate 9-a> was synthesized in the same manner as in Synthesis Example 1-(3) with the exception of using <Chemical Formula 9-a> instead of <Intermediate 1-b>.

### Synthesis Example 9-(2): Synthesis of Intermediate 9-b

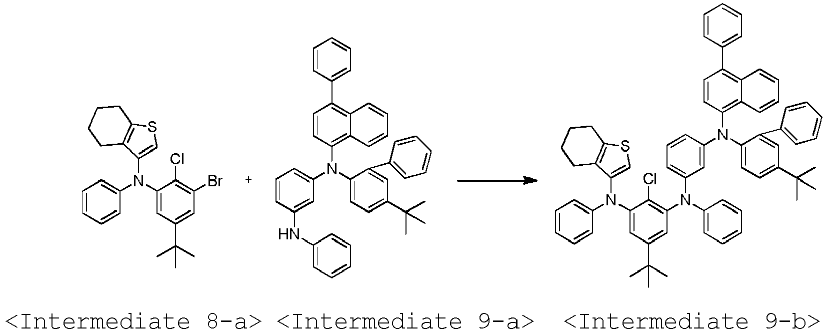

<Intermediate 9-b> was synthesized in the same manner as in Synthesis Example 1-(4) with the exception of using <Intermediate 9-a> and <Intermediate 8-a> instead of <Intermediate 1-c> and 1-bromo-2,3-dichlorobenzene, respectively.

### Synthesis Example 9-(3): Synthesis of Compound 119

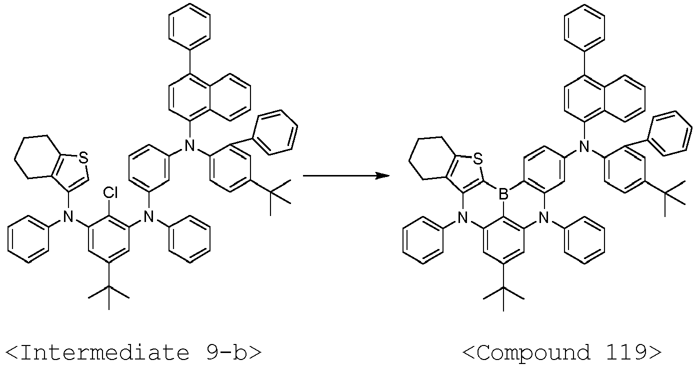

<Compound 119> was synthesized in the same manner as in Synthesis Example 1-(6) with the exception of using <Intermediate 9-b> instead of <Intermediate 1-e>.

MS (MALDI-TOF) : m/z 961.46 [M⁺]

### EXAMPLES 1-8: Fabrication of Organic Light-Emitting Diodes

An ITO glass substrate was patterned to have a translucent area of 2 mm×2 mm and cleansed. The ITO glass was mounted in a vacuum chamber that was then set to have a base pressure of 1×10⁻⁷ torr. On the ITO glass substrate, films were sequentially formed of DNTPD (700 Å) and α-NPD (300 Å). Subsequently, a light-emitting layer (250 Å) was formed of a combination of the host (BH1) described below and the boron compound (3 wt %) of the present disclosure. Then, [Chemical Formula E-1] and [Chemical Formula E-2] were deposited at a weight ratio of 1:1 to form an electron transport layer (300 Å) on which an electron injection layer of [Chemical Formula E-1] (5 Å) was formed and then covered with an Al layer (1000 Å) to fabricate an organic light-emitting diode. The organic light-emitting diodes thus obtained were measured at 0.4 mA for luminescence properties.

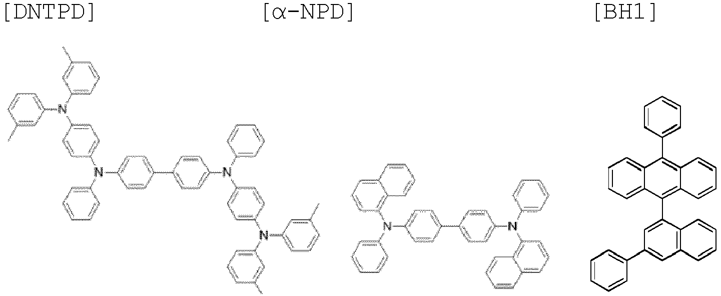

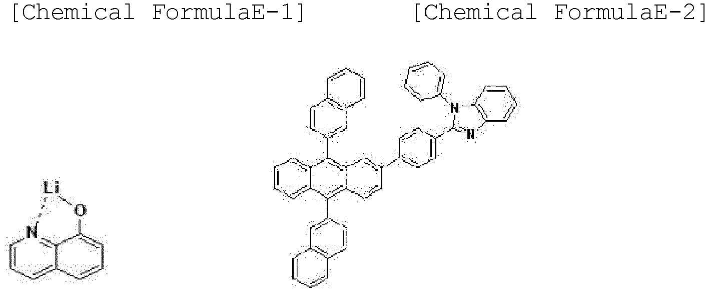

### EXAMPLES 9 TO 11

Organic light-emitting diodes were fabricated in the same manner as in Example 1 with the exception of using the compounds listed in Table 2 as dopants, instead of the compound of Example 1, and [BH2] as a host. The organic light-emitting diodes thus obtained were measured at 0.4 mA for luminescence properties.

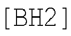

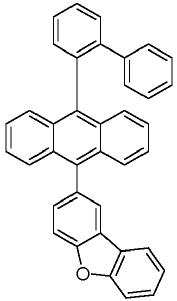

### COMPARATIVE EXAMPLES 1 TO 3:

Organic light emitting diodes were fabricated in the same manner as in the Example 1-1, with the exception of using [BD1] to [BD3] as dopants instead of the compounds according to the present disclosure. The luminescence of the organic light-emitting diodes thus obtained was measured at 0.4 mA. Structures of compounds [BD1] to [BD3] are as follows:

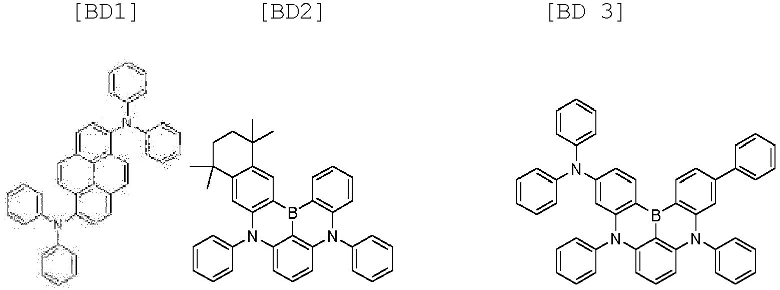

### COMPARATIVE EXAMPLES 4 TO 6

Organic light emitting diodes were fabricated in the same manner as in the Example 9, with the exception of using [BD1] to [BD3] as dopants instead of the compound according to the present disclosure. The luminescence of the organic light-emitting diodes thus obtained was measured at 0.4 mA.

**TABLE 1**

| | Dopant | Current Density (mA) | Volt. (V) | External quantum efficiency (%) |
|---|---|---|---|---|
| Example 1 | Compound1 | 0.4 | 3.81 | 8.8 |
| Example 2 | Compound32 | 0.4 | 3.82 | 9.1 |
| Example 3 | Compound37 | 0.4 | 3.79 | 9.0 |
| Example 4 | Compound46 | 0.4 | 3.78 | 9.1 |
| Example 5 | Compound64 | 0.4 | 3.77 | 9.2 |
| Example 6 | Compound65 | 0.4 | 3.83 | 9.0 |
| Example 7 | Compound88 | 0.4 | 3.82 | 9.4 |
| Example 8 | Compound115 | 0.4 | 3.80 | 9.5 |
| C. Example 1 | BD1 | 0.4 | 4.10 | 7.3 |
| C. Example 2 | BD2 | 0.4 | 3.85 | 7.9 |
| C. Example 3 | BD3 | 0.4 | 3.87 | 7.7 |

**TABLE 2**

| | Dopant | Current Density (mA) | Volt. (V) | External quantum efficiency (%) |
|---|---|---|---|---|
| Example 9 | Compound88 | 0.4 | 3.75 | 9.8 |
| Example 10 | Compound115 | 0.4 | 3.72 | 10.1 |
| Example 11 | Compound119 | 0.4 | 3.7 | 9.9 |
| C. Example 4 | BD1 | 0.4 | 4.0 | 7.6 |
| C. Example 5 | BD2 | 0.4 | 3.8 | 8.3 |
| C. Example 6 | BD3 | 0.4 | 3.83 | 8.0 |

As is understood from data of Table 1 for Examples 1 to 11, the boron compounds according to the present disclosure allow for low driving voltages and high quantum efficiency, compared to Comparative Examples 1 to 6, thus finding high availability for organic light-emitting diodes.

### Industrial Applicability

As a dopant material in an organic light-emitting diode, the novel boron compound according to the present disclosure exhibits low driving voltages and high luminous efficiency, compared to conventional compounds and guarantee the organic light-emitting diode improved properties. Accordingly, the compound is highly industrially available in the field of organic light-emitting diodes and relevant fields.

## Claims

1. A boron compound represented by any one of the following Chemical Formulas A to E: 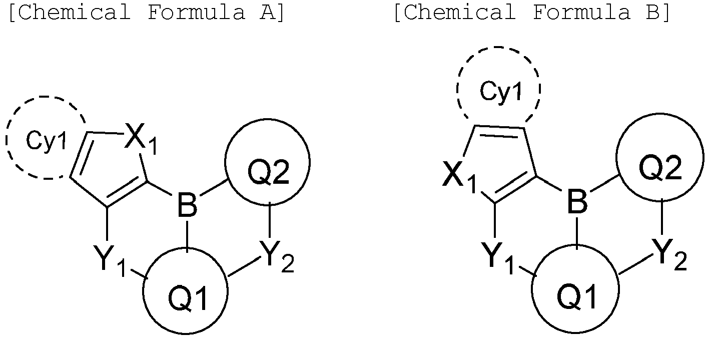 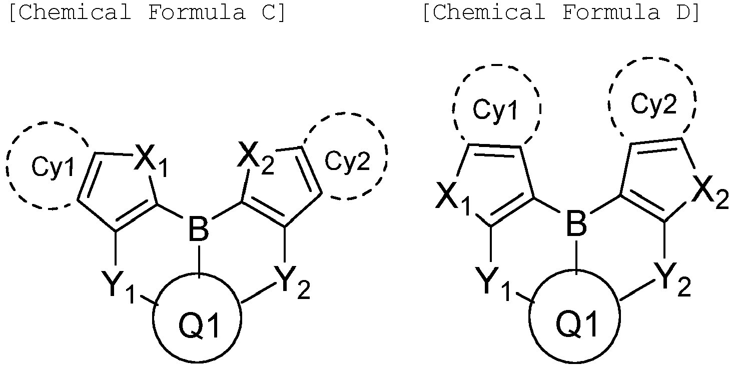 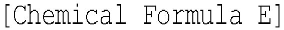 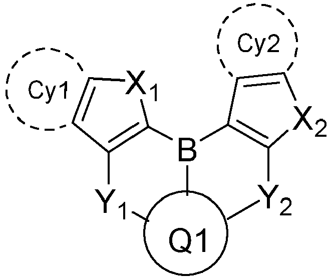 wherein,
X₁ is O, S, or NR₁,
X₂ is O, S, or NR₂,
Y₁ is any one selected from O, S, Se, NR₃, and CR₄R₅,
Y₂ is any one selected from O, S, Se, NR₆, and CR₇R₈,
Q₁ and Q₂, which may be same or different, are each independently a substituted or unsubstituted aromatic hydrocarbon ring of 6 to 50 carbon atoms, or a substituted or unsubstituted heteroaromatic ring of 2 to 50 carbon atoms,
the Q1 ring moiety having no amine radicals as substituents or including one amine radical represented by - NR₉R₁₀ as one substituent thereon,
the Q2 ring moiety having no amine radicals as substituents thereon or including one amine radical represented by -NR₁₁R₁₂ as a substituent thereon,
R₁ to R₈, which may be same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted cycloalkyl of 3 to 30 carbon atoms, a substituted or unsubstituted heteroaryl of 2 to 50 carbon atoms, a substituted or unsubstituted alkoxy of 1 to 30 carbon atoms, a substituted or unsubstituted aryloxy of 6 to 30 carbon atoms, a substituted or unsubstituted alkylthio of 1 to 30 carbon atoms, a substituted or unsubstituted arylthio of 5 to 30 carbon atoms, a substituted or unsubstituted alkylamine of 1 to 30 carbon atoms, a substituted or unsubstituted arylamine of 5 to 30 carbon atoms, a substituted or unsubstituted alkylsilyl of 1 to 30 carbon atoms, a substituted or unsubstituted arylsilyl of 5 to 30 carbon atoms, a nitro, a cyano, and a halogen,
R₉ to R₁₂, which may be same or different, are each independently selected from a Hydrogen atom, a deuterium atom, a substituted or unsubstituted alkyl of 1 to 30 carbon atoms, a substituted or unsubstituted aryl of 6 to 50 carbon atoms, a substituted or unsubstituted cycloalkyl of 3 to 30 carbon atoms, and a substituted or unsubstituted heteroaryl of 2 to 50 carbon atoms,
R₉ and R₁₀ may be bonded to each other to additionally form an aliphatic or aromatic mono- or polycyclic ring, and R₁₁ and R₁₂ may be bonded to each other to additionally form an aliphatic or aromatic mono- or polycyclic ring,
R₃ to R₅ and R₆ to R₈ may each independently bonded to the Q1 ring moiety to additionally form an aliphatic or aromatic mono- or polycyclic ring,
R₄ and R₅ may be boned to each other to additionally form an aliphatic or aromatic mono- or polycyclic ring,
R₇ and R₈ may be bonded to each other to additionally an aliphatic or aromatic mono- or polycyclic ring,
the ring accounted for by Cy1 includes a substituted or unsubstituted alkylene of 1 to 10 carbon atoms as a ring constituent except for the two carbon atoms as ring members of the unsaturated pentagonal ring bearing X₁,
the ring accounted for by Cy2 includes a substituted or unsubstituted alkylene of 1 to 10 carbon atoms as a ring constituent except for the two carbon atoms as ring members of the unsaturated pentagonal ring bearing X₂, and
R₆ to R₈ in Chemical Formulas A and Chemical Formula B may be bonded to the Q2 ring moiety to additionally form an aliphatic or aromatic mono- or polycyclic ring,
wherein, the term "substituted" in the expression "substituted or unsubstituted" used for the compound of Chemical Formulas A to E means having at least one substituent selected from the group consisting of a deuterium atom, a cyano, a halogen, a hydroxy, a thiol, a nitro, an alkyl of 1 to 24 carbon atoms, a halogenated alkyl of 1 to 24 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 2 to 24 carbon atoms, an alkoxy of 1 to 24 carbon atoms, an alkylamino of 1 to 24 carbon atoms, a diarylamino of 12 to 24 carbon atoms, a diheteroarylamino of 2 to 24 carbon atoms, an aryl(heteroaryl)amino of 7 to 24 carbon atoms, an alkylsilyl of 1 to 24 carbon atoms, an arylsilyl of 6 to 24 carbon atoms, an aryloxy of 6 to 24 carbon atoms, and an arylthionyl of 6 to 24 carbon atoms.

2. The boron compound of claim 1, wherein Y₁ is N-R₃ or Y₂ is N-R₆ in Chemical Formulas A to E, R₃ and R₆ being defined as in claim 1.

3. The boron compound of claim 2, wherein Y₁ is N-R₃ and Y₂ is N-R₆.

4. The boron compound of claim 2, wherein R₃ and R₆ are same or different and are each independently a substituted or unsubstituted aryl of 6 to 50 carbon atoms or a substituted or unsubstituted heteroaryl of 2 to 50 carbon atoms.

5. The boron compound of claim 4, wherein R₃ and R₆ are same or different and each independently selected from a substituted or unsubstituted phenyl, a substituted or unsubstituted biphenyl, a substituted or unsubstituted naphthyl, a substituted or unsubstituted anthracenyl, a substituted or unsubstituted phenanthrenyl, and a substituted or unsubstituted fluorenyl and any one of R₃ and R₆ can bond to the Q1 or Q2 ring moiety to form a mono- or polycyclic ring.

6. The boron compound of claim 1, wherein at least one of Y₁ and Y₂ in Chemical Formulas A to E is an oxygen atom (O) or sulfur atom (S).

7. The boron compound of claim 1, wherein Q1 and Q2 are same or different and are each independently a substituted or unsubstituted aromatic hydrocarbon ring of 6 to 18 carbon atoms or a substituted or unsubstituted heteroaromatic ring of 2 to 18 carbon atoms.

8. The boron compound of claim 7, wherein the aromatic hydrocarbon ring of Q2 in Chemical Formulas A and B is any one selected from Structural Formulas 10 to 21, below: 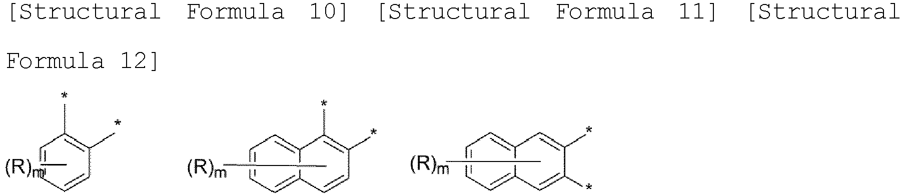 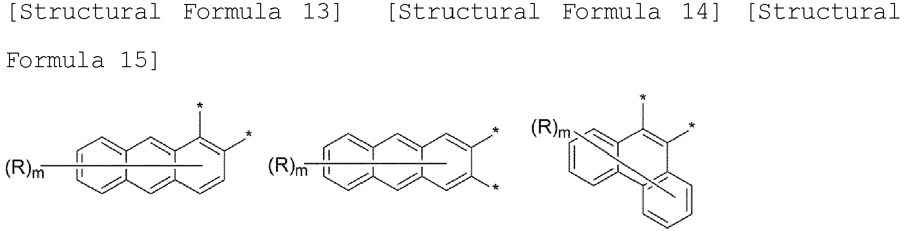 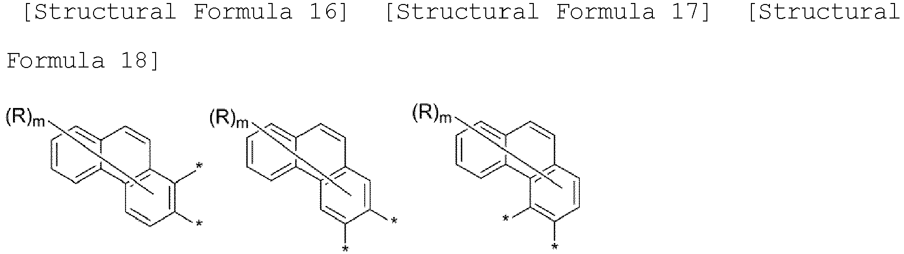 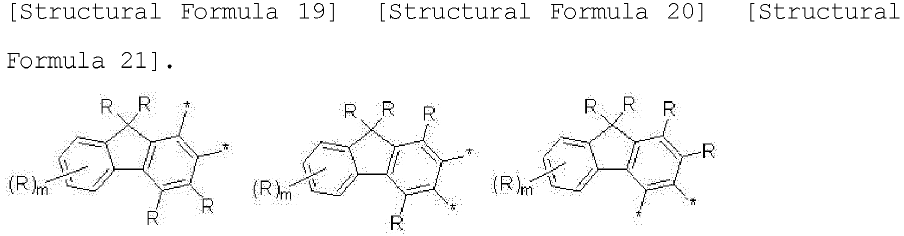 wherein, 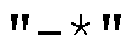 denotes bonding sites at which the corresponding carbons in the aromatic ring of Q2 bond to the boron atom and the linker Y₂, respectively, and
R's, which may be same or different, are each independently any one selected from a hydrogen atoms, a deuterium atom, a cyano, a halogen, a hydroxy, a nitro, an alkyl of 1 to 24 carbon atoms, a halogenated alkyl of 1 to 24 carbon atoms, a cycloalkyl of 3 to 24 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an akylaryl of 7 to 24 carbon atoms, heteroaryl of 2 to 50 carbon atoms, a heteroarylalkyl of 2 to 24 carbon atoms, an alkoxy of 1 to 24 carbon atoms, an alkylamino of 1 to 24 carbon atoms, a diarylamino of 12 to 24 carbon atoms, a diheteroarylamino of 2 to 24 carbon atoms, an aryl(heteroaryl)amino of 7 to 24 carbon atoms, an alkylsilyl of 1 to 24 carbon atoms, an arylsilyl of 6 to 24 carbon atoms, an aryloxy of 6 to 24 carbon atoms, and an arylthionyl of 6 to 24 carbon atoms, and
m is an integer of 1 to 8 wherein when m is 2 or more or two or more R's is present, the corresponding R's may be same or different.

9. The boron compound of claim 7, wherein the aromatic hydrocarbon ring of Q1 in Chemical Formulas A to E is a ring represented by the following Structural Formula B: 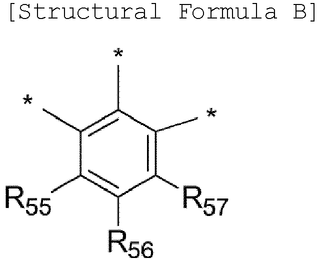 wherein 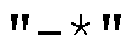 denotes bonding sites at which the corresponding carbons in the aromatic ring of Q1 bond to the boron atom (B) and the linkers Y₁ and Y₂, respectively, and
R₅₅ to R₅₇, which may be same or different, are each independently any one selected from a hydrogen atom, a deuterium atom, a cyano, a halogen, a hydroxy, a nitro, an alkyl of 1 to 24 carbon atoms, a halogenated alkyl of 1 to 24 carbon atoms, a cycloalkyl of 3 to 24 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an akylaryl of 7 to 24 carbon atoms, a heteroaryl of 2 to 50 carbon atoms, a heteroarylalkyl of 2 to 24 carbon atoms, an alkoxy of 1 to 24 carbon atoms, an alkylamino of 1 to 24 carbon atoms, a diarylamino of 12 to 24 carbon atoms, a diheteroarylamino of 2 to 24 carbon atoms, an aryl(heteroaryl)amino of 7 to 24 carbon atoms, an alkylsilyl of 1 to 24 carbon atoms, an arylsilyl of 6 to 24 carbon atoms, an aryloxy of 6 to 24 carbon atoms, and an arylthionyl of 6 to 24 carbon atoms, and
any adjacent two of R₅₅ to R₅₇ may be linked to each to each other to form an additional mono- or polycyclic aliphatic or aromatic ring.

10. The boron compound of claim 1, wherein
the ring accounted for by Cy1 in Chemical Formulas A to E includes as a ring constituent a linker represented by the following Structural Formula D: 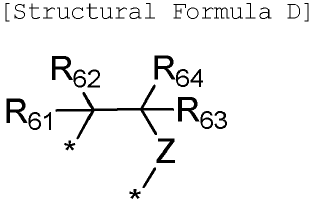
the ring accounted for by Cy2 in Chemical Formulas C to E includes as a ring constituent a linker represented by the following Structural Formula E: 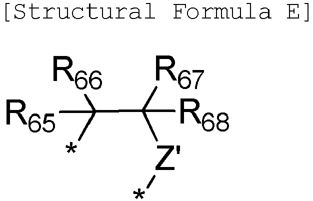
wherein 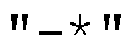 denotes a bonding site to two adjacent carbon atoms within the unsaturated pentagonal ring bearing X₁ or X₂ as a ring member, and
Z and Z', which are same or different, are each independently any one selected from a single bond,-C(R₆₉ )(R₇₀)-, and -C(R₇₁)(R₇₂)-C(R₇₃)(R₇₄)-,
wherein R₆₁ to R₇₄, which may be same or different, are each independently selected from a hydrogen atom, a deuterium atom, a halogen, a substituted or unsubstituted alkyl of 1 to 20 carbon atoms, a substituted or unsubstituted cycloalkyl of 3 to 20 carbon atoms, a substituted or unsubstituted aryl of 6 to 20 carbon atoms, a substituted or unsubstituted heteroaryl of 2 to 20 carbon atoms, a substituted or unsubstituted alkylsilyl of 1 to 20 carbon atoms, and a substituted or unsubstituted arylsilyl of 6 to 20 carbon atoms wherein the term 'substituted" in the expression "substituted or unsubstituted" used is as defined above.

11. The boron compound of claim 1, wherein the Q1 ring moiety has no amine radicals as substituents thereon and only the Q2 ring moiety includes one amine radical represented by - NR₁₁R₁₂ as a substituent thereon in Chemical Formulas A to E.

12. The boron compound of claim 1, wherein the amine radicals represented by -NR₉R₁₀ as a substituent on the Q1 ring moiety or the amino radicals represented by -NR₁₁R₁₂ as a substituent on the Q2 ring moiety in Chemical Formulas A to E are same or different and are each independently an amine represented by the following Structural Formula F: 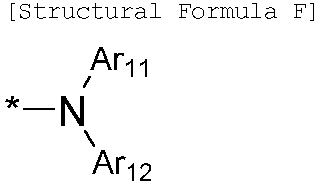 wherein 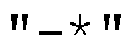 denotes a bonding site to a carbon atom as a member in the aromatic ring of at least one of Q1 and Q2, and
Ar₁₁ and Ar₁₂, which are same or different, are each independently a substituted or unsubstituted aryl of 6 to 18 carbon atoms.

13. The boron compound of claim 1, wherein the boron compound is any one selected from <Compound 1> to <Compound 243>

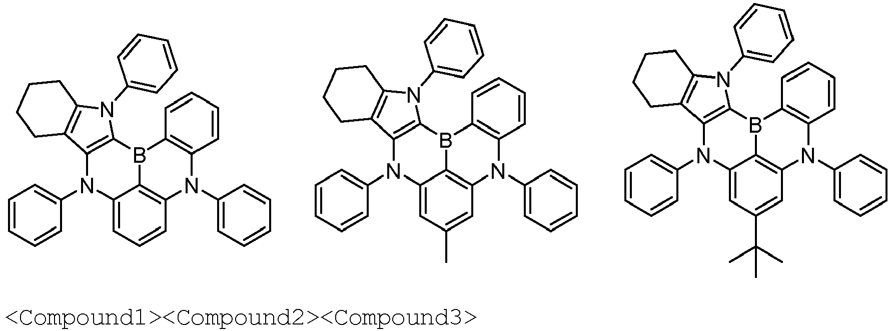

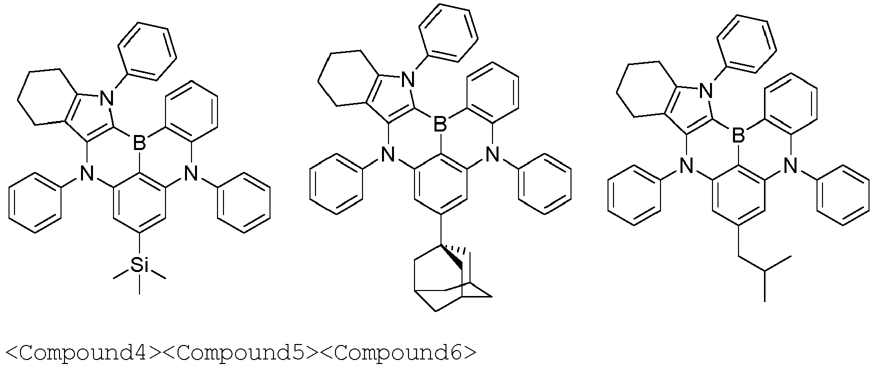

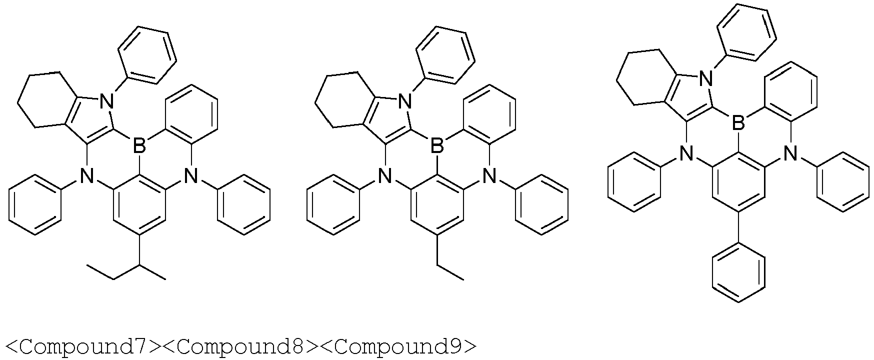

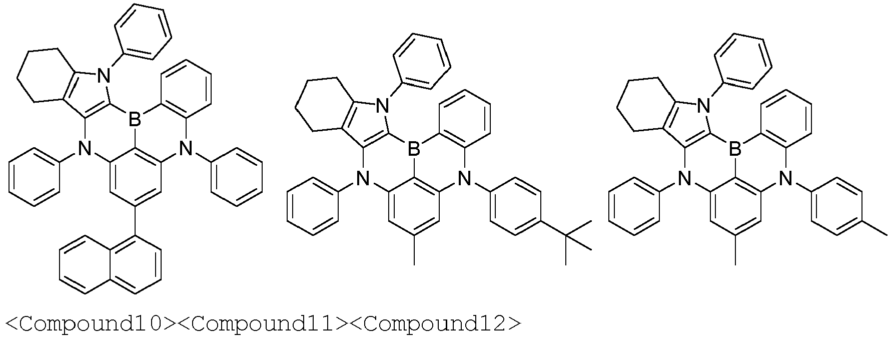

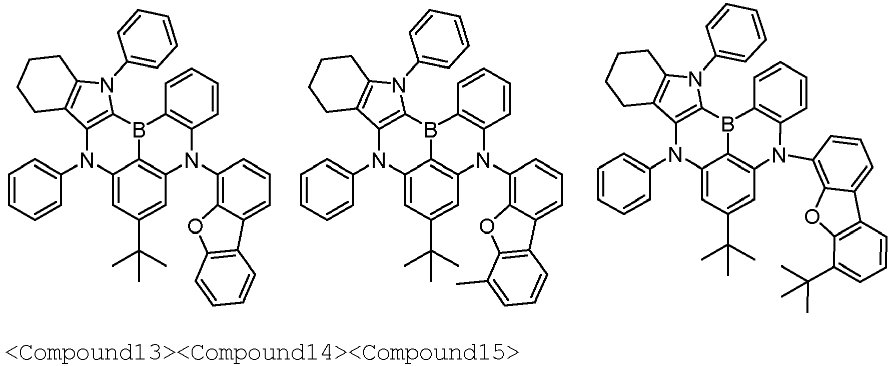

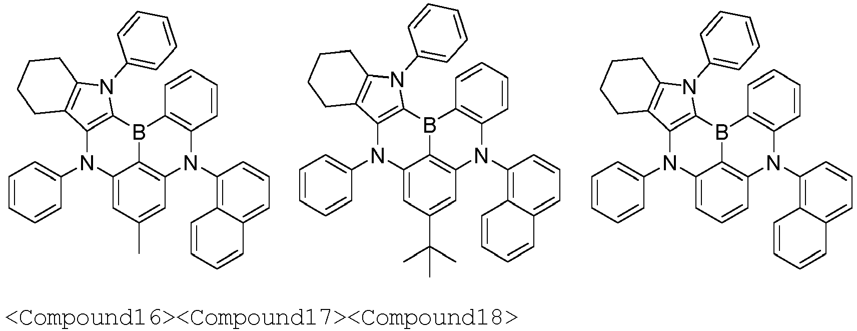

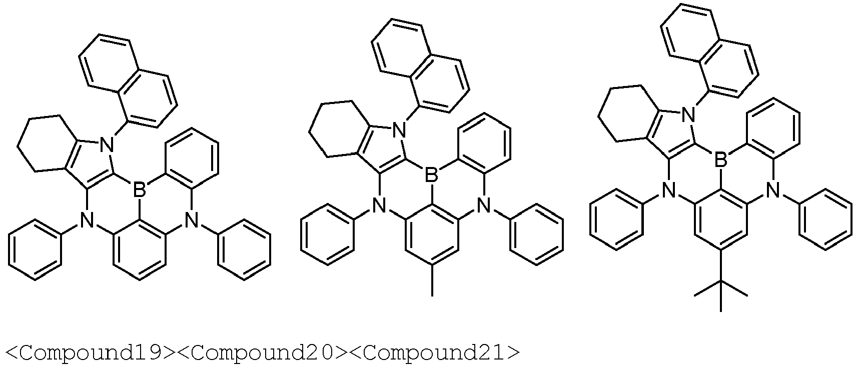

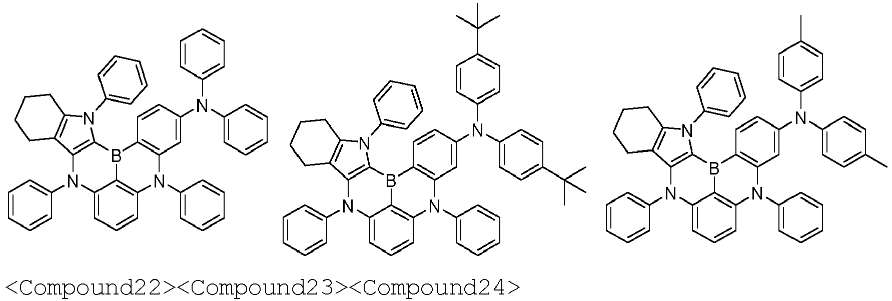

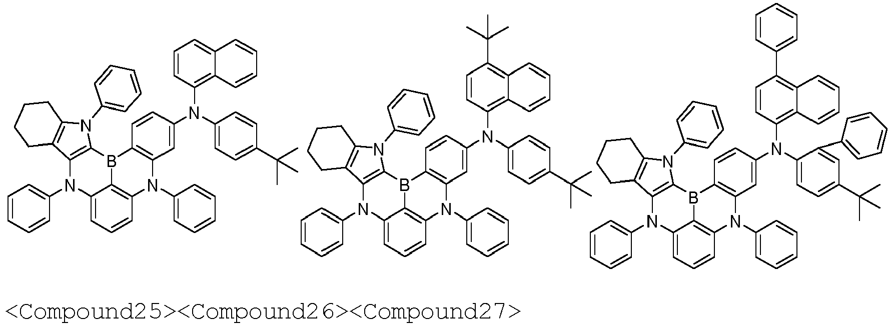

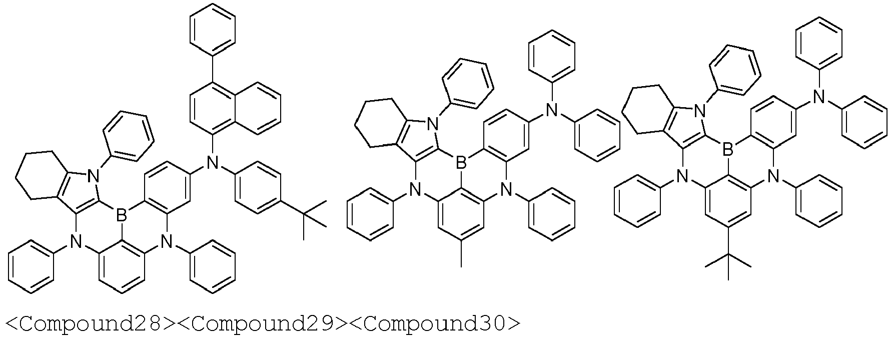

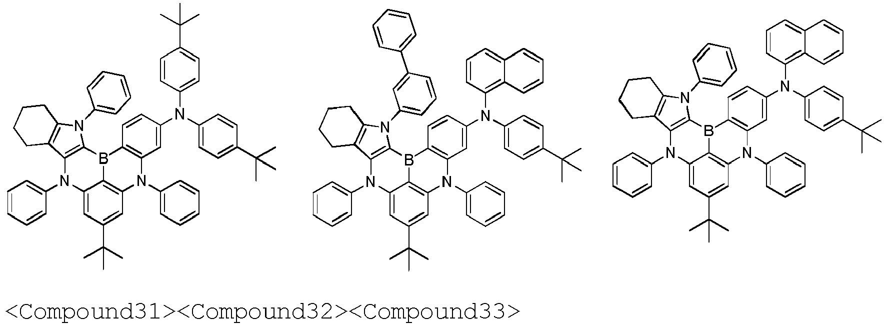

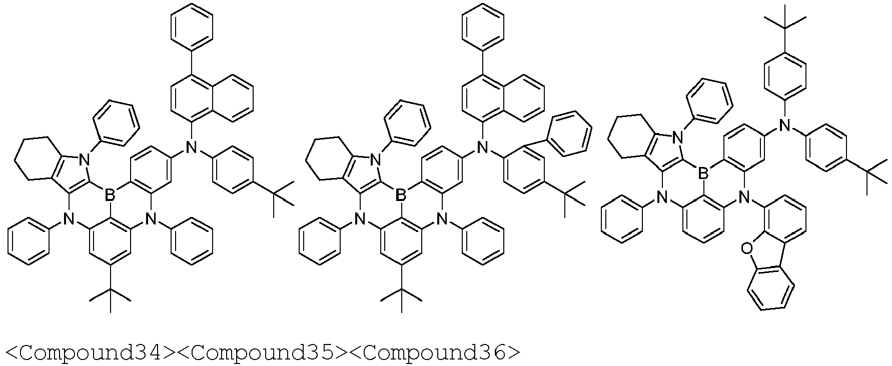

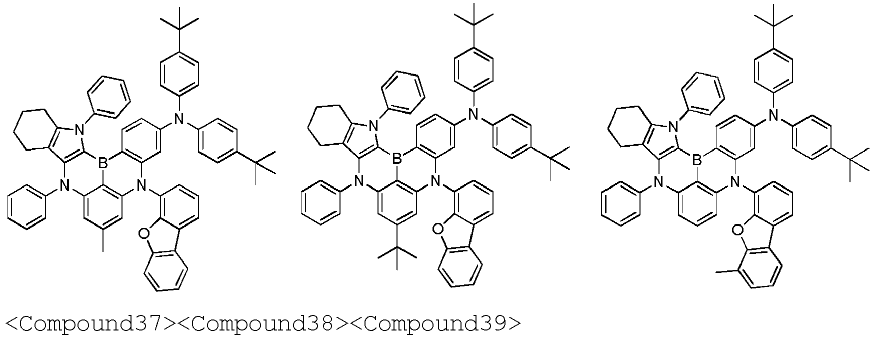

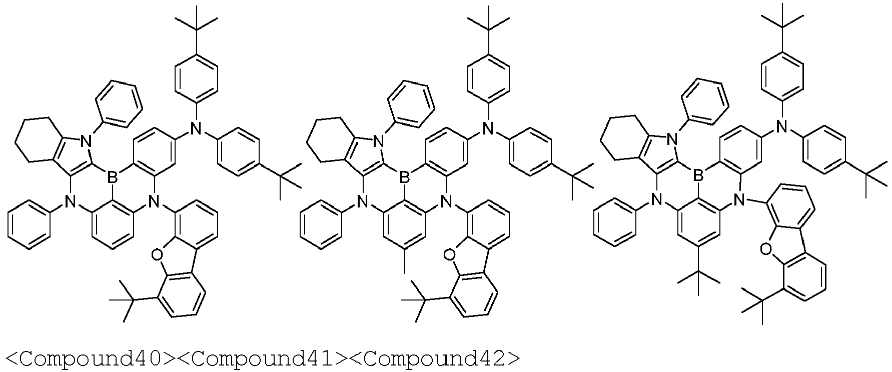

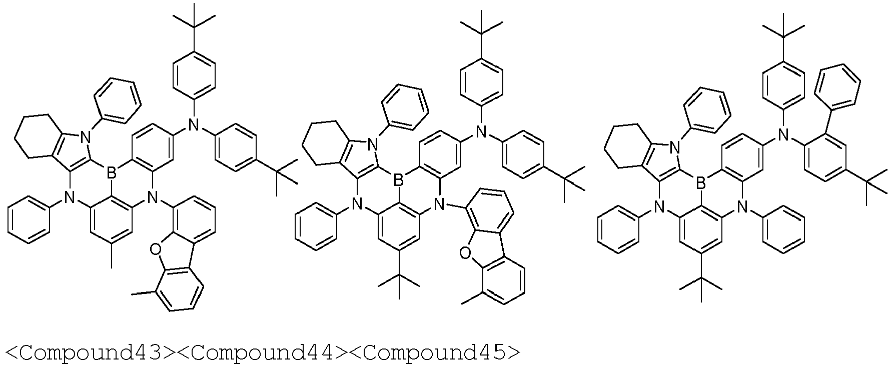

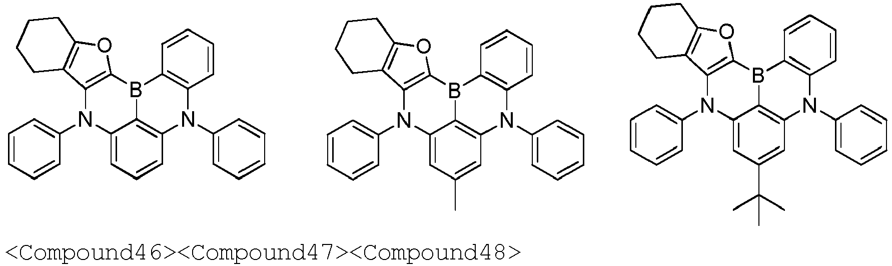

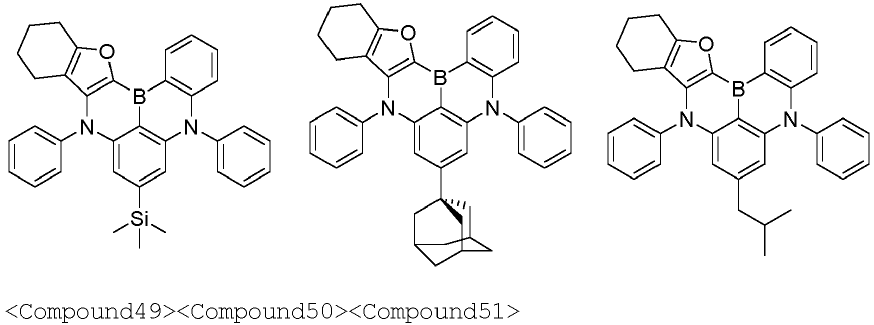

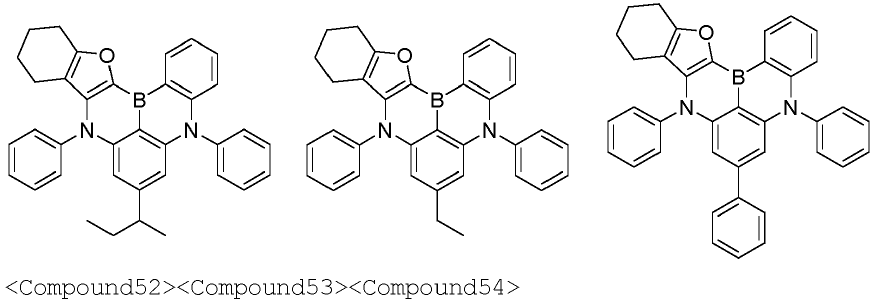

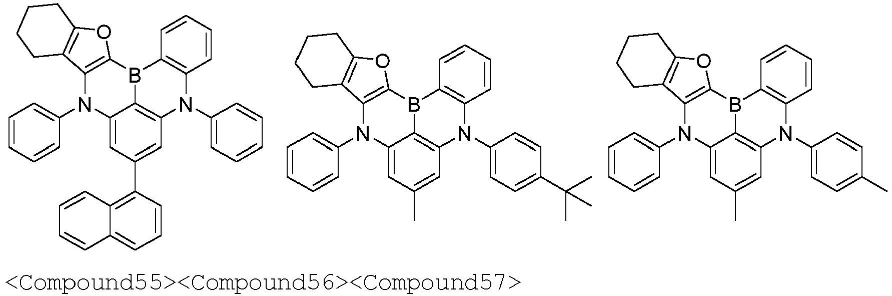

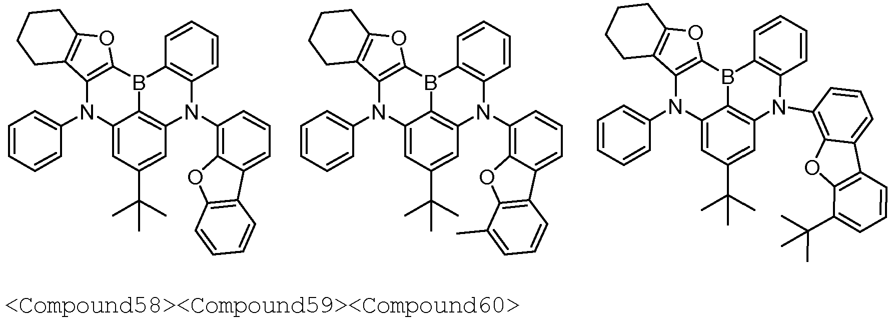

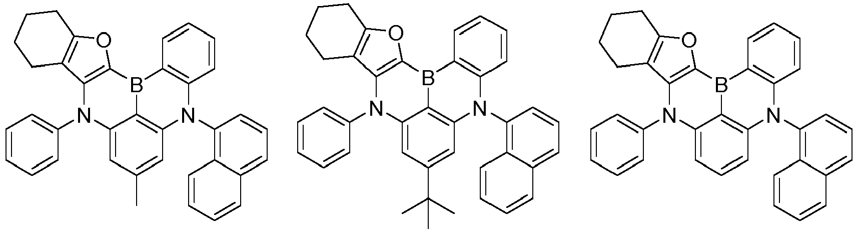

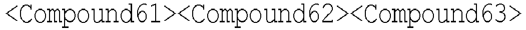

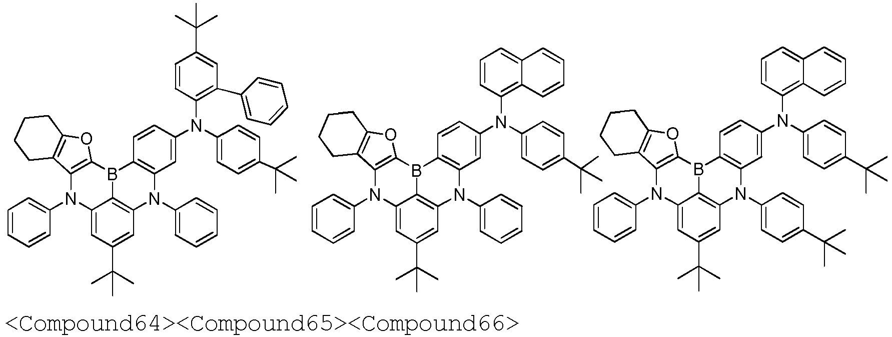

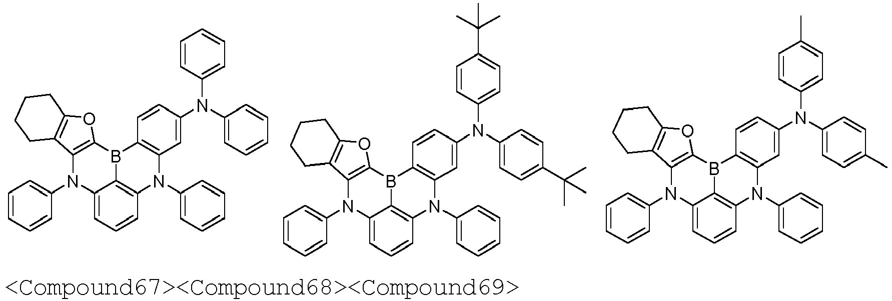

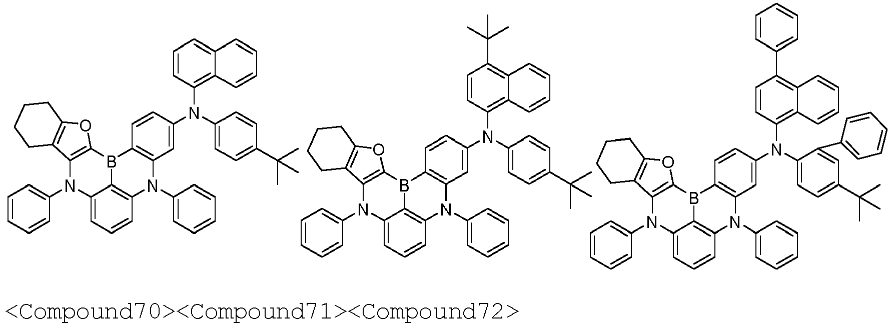

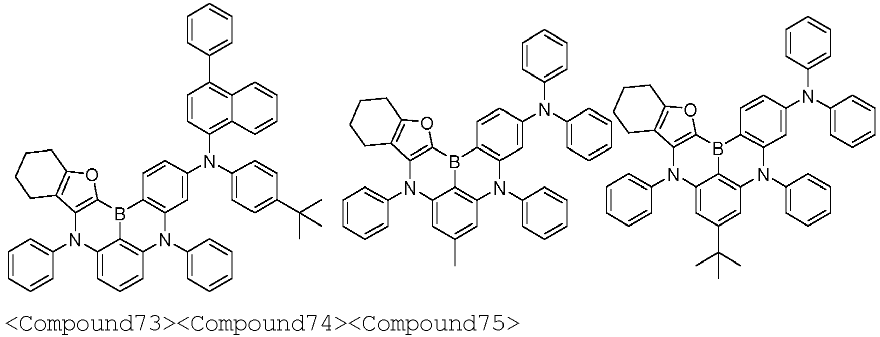

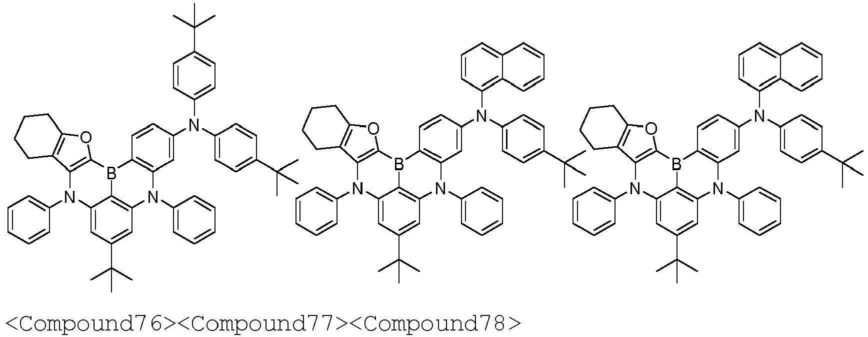

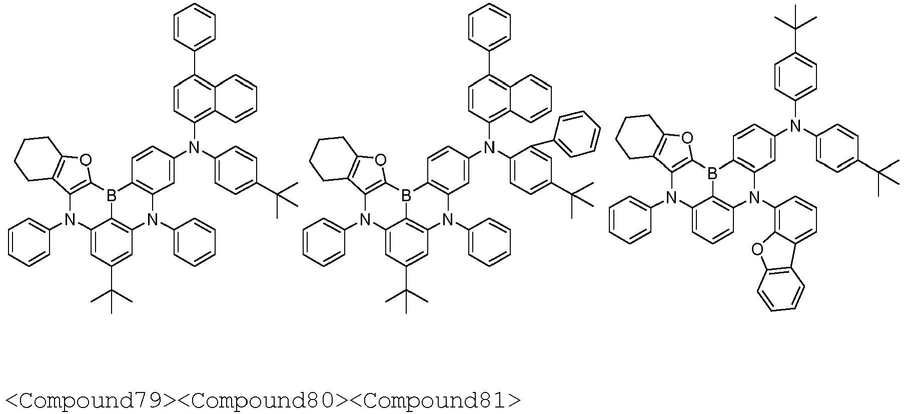

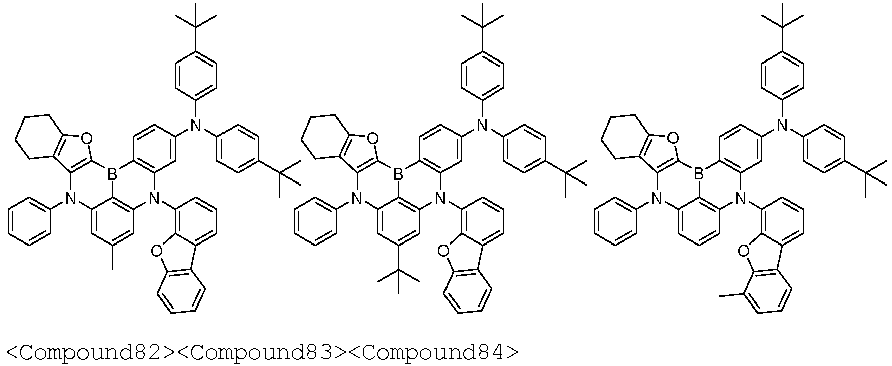

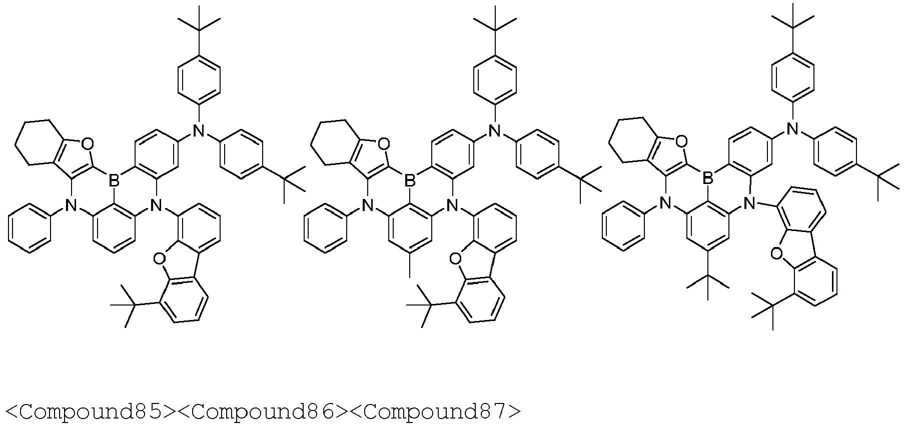

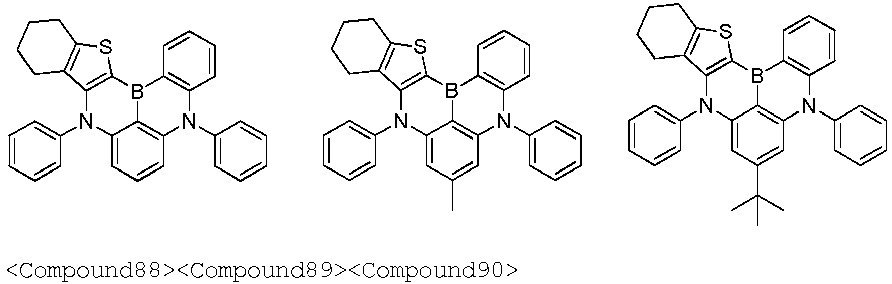

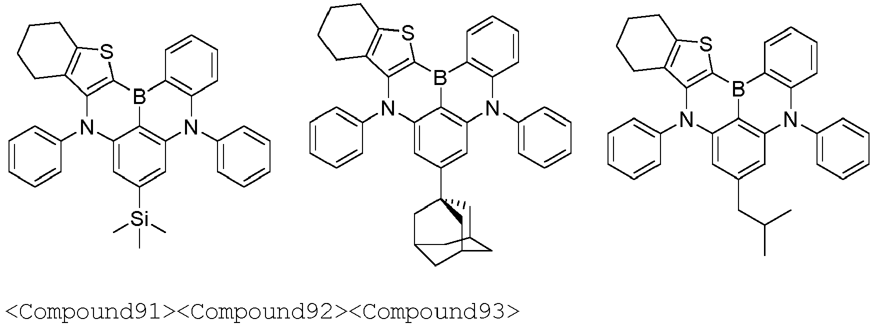

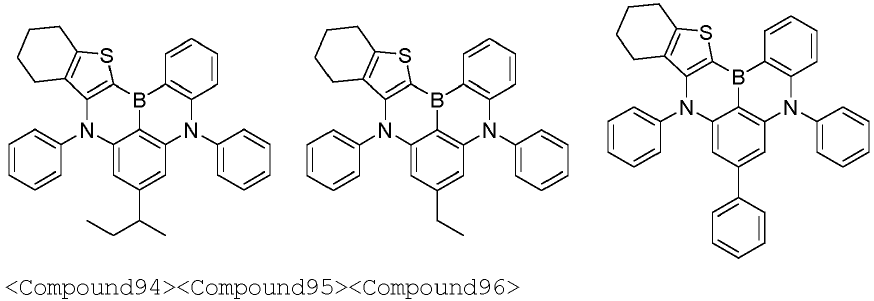

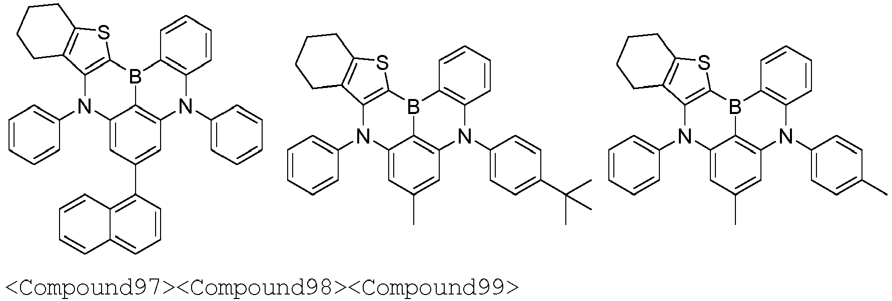

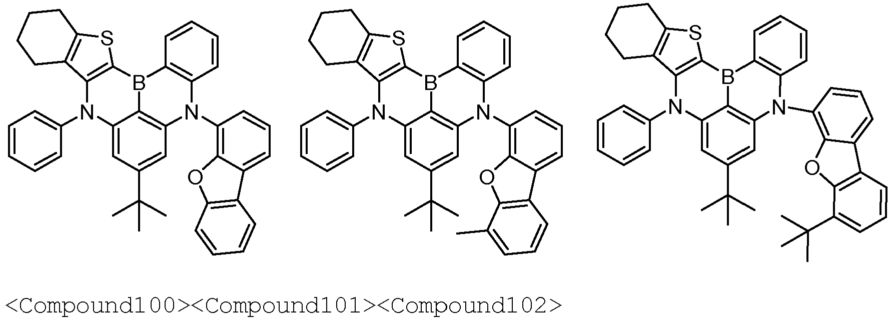

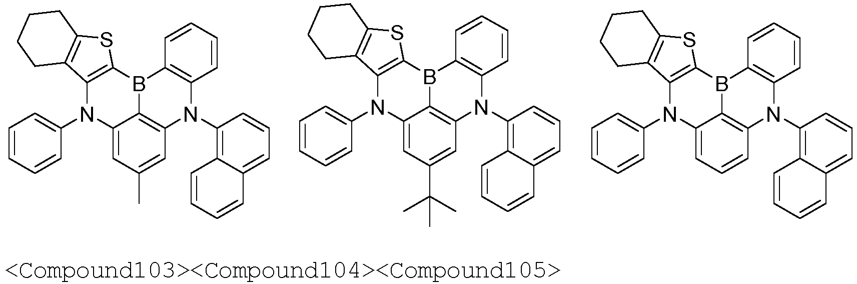

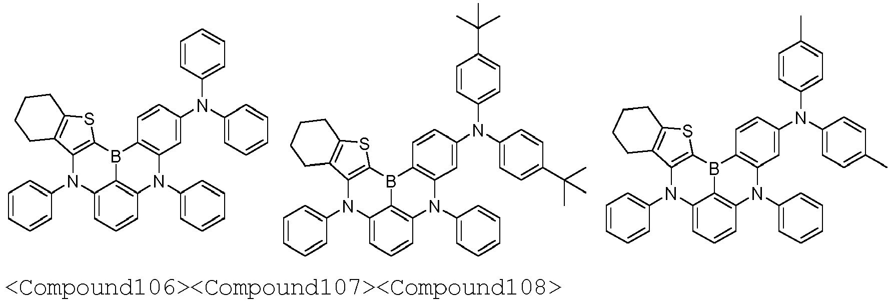

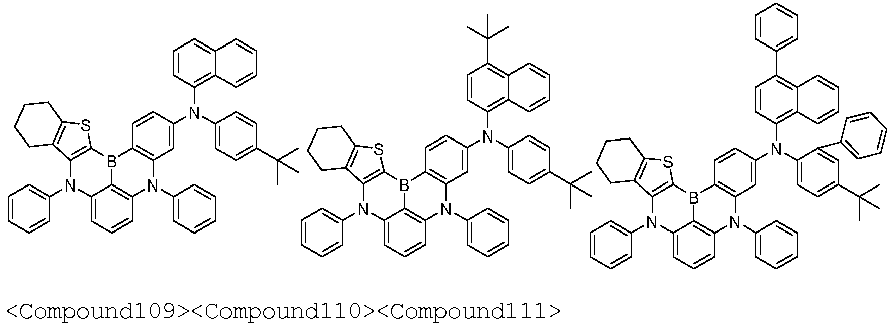

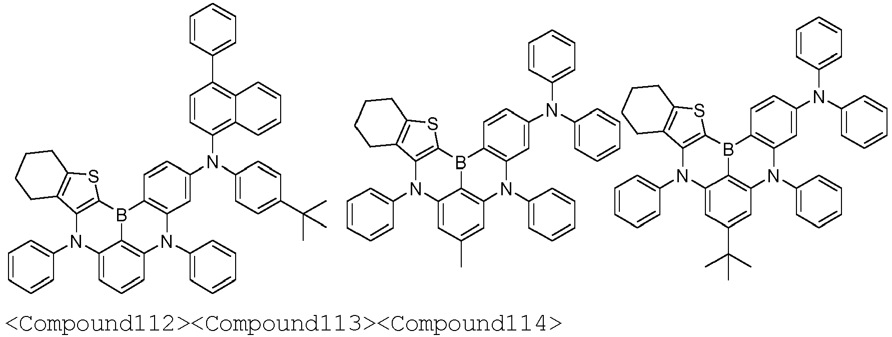

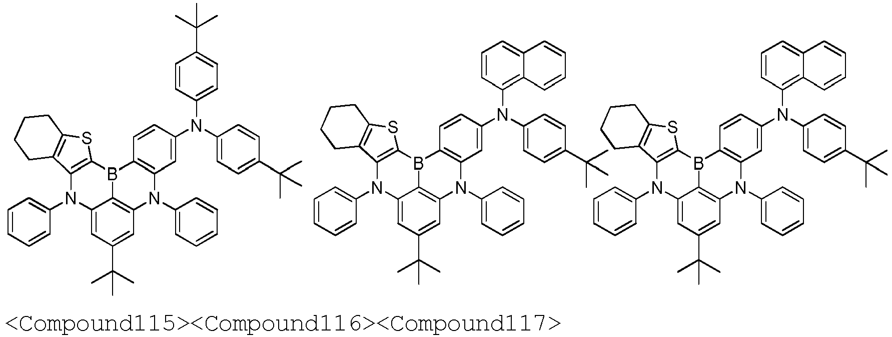

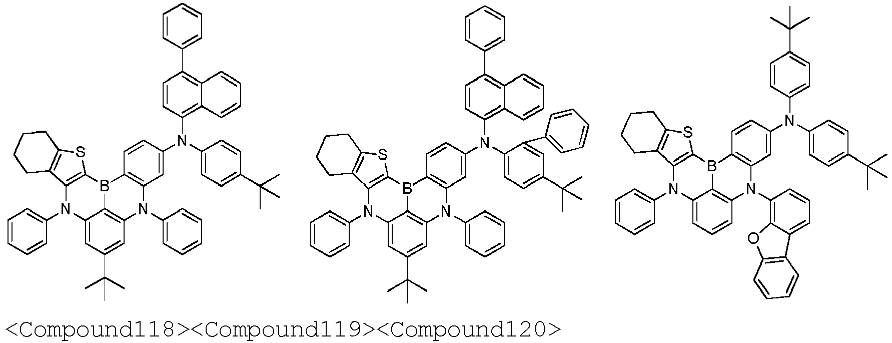

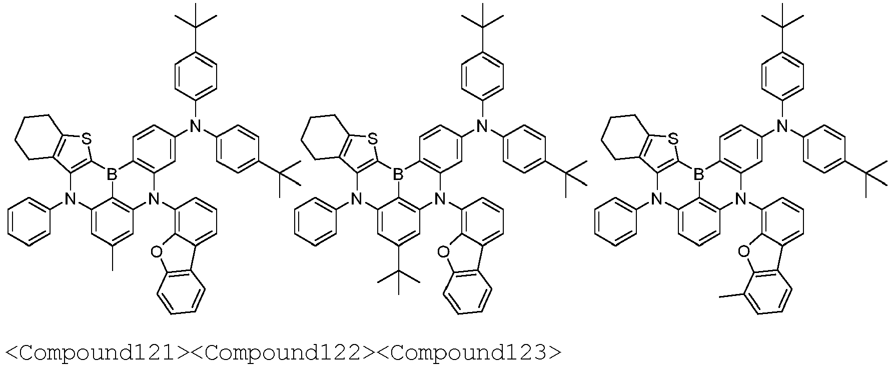

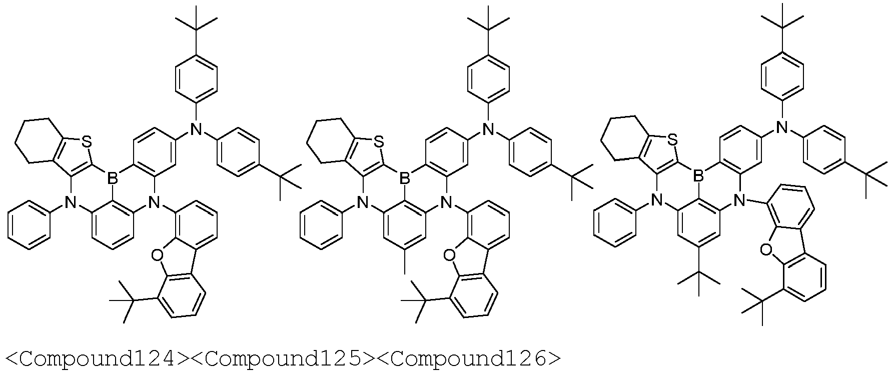

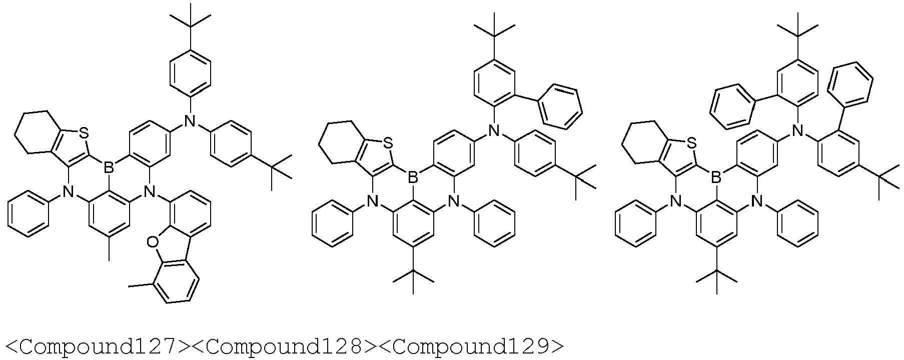

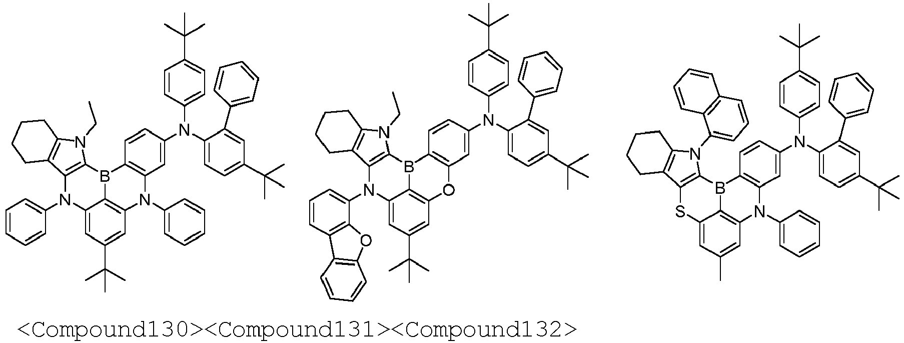

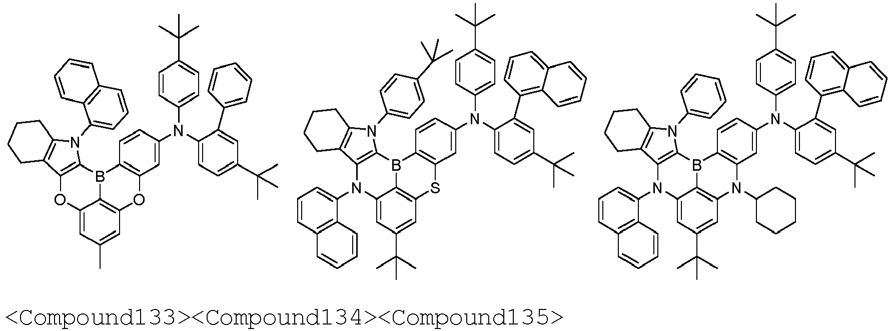

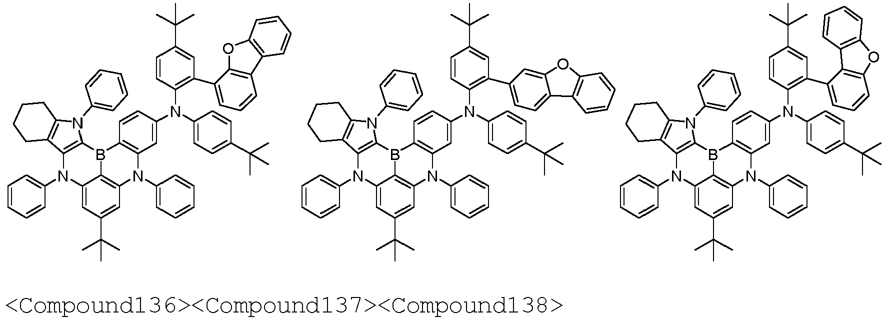

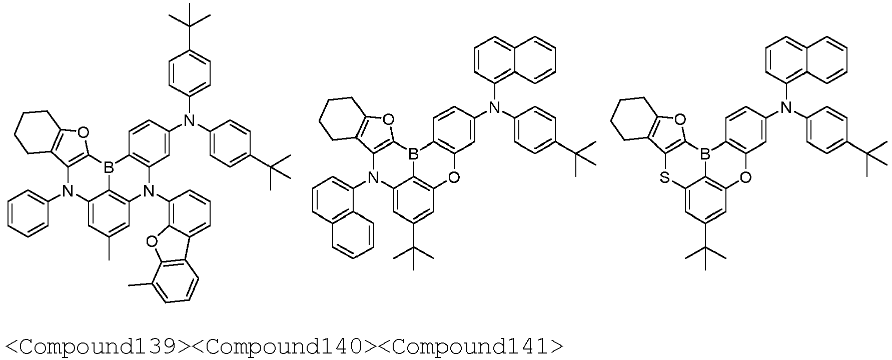

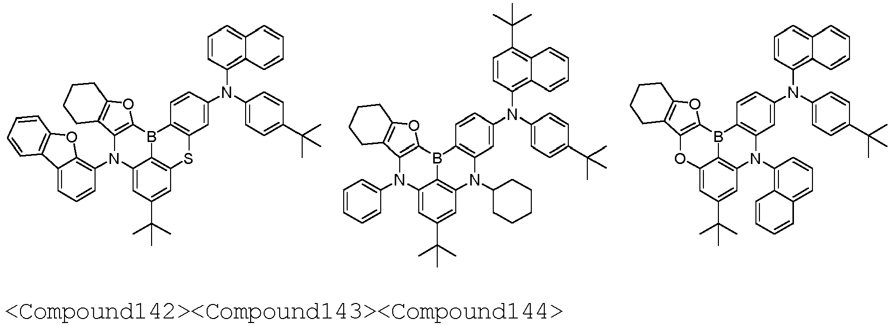

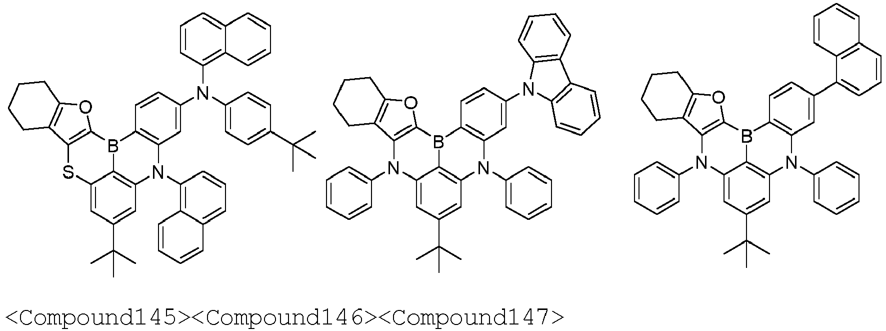

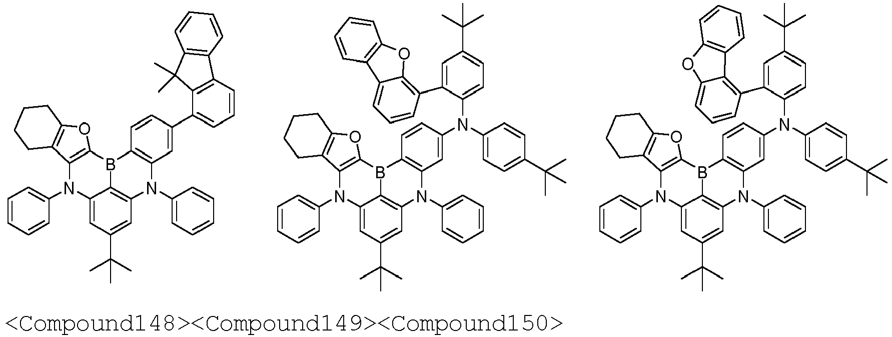

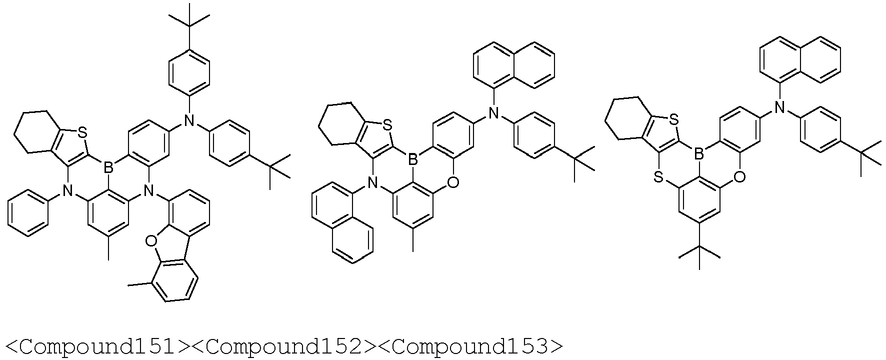

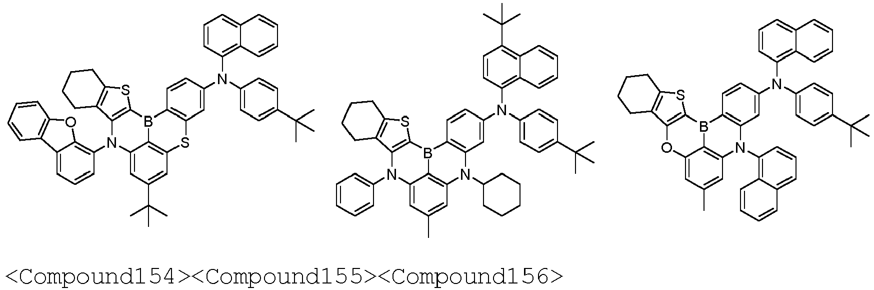

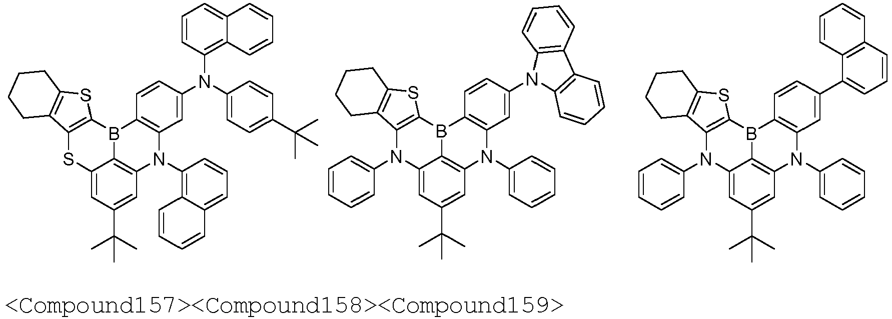

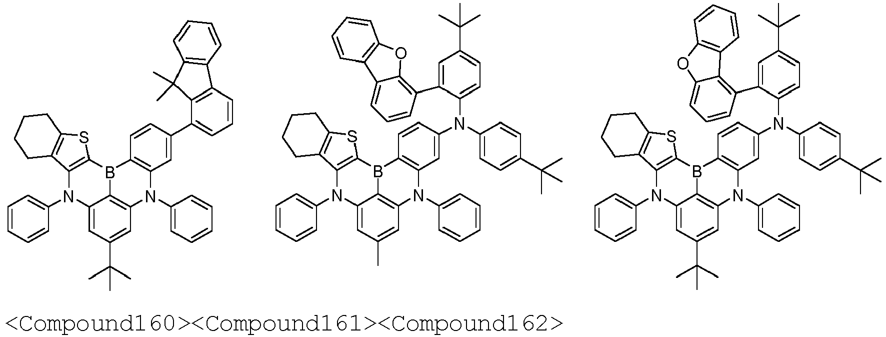

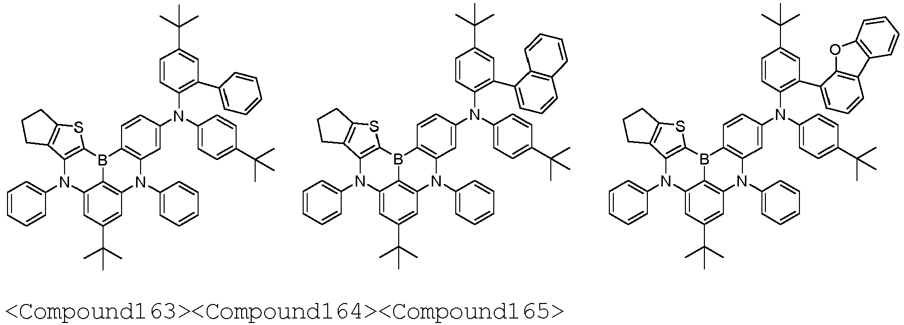

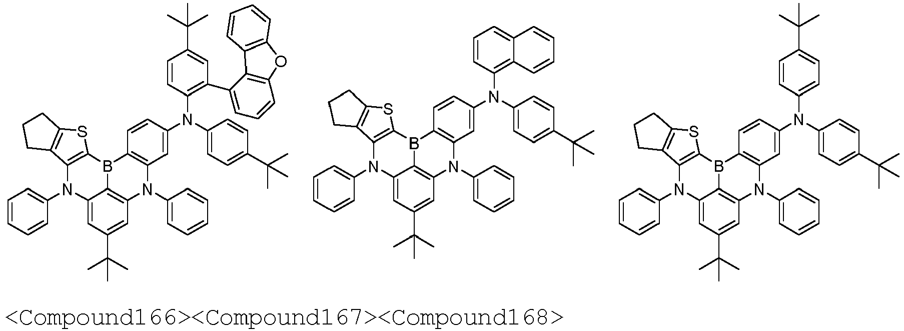

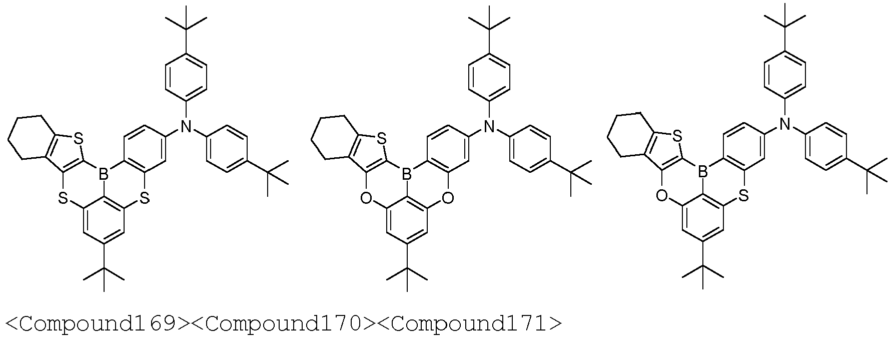

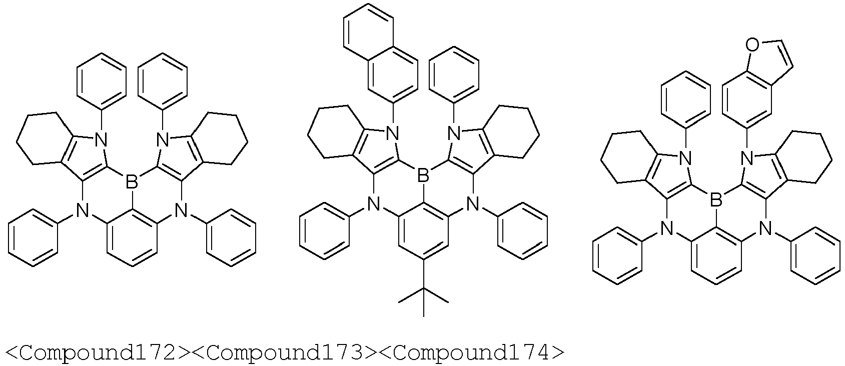

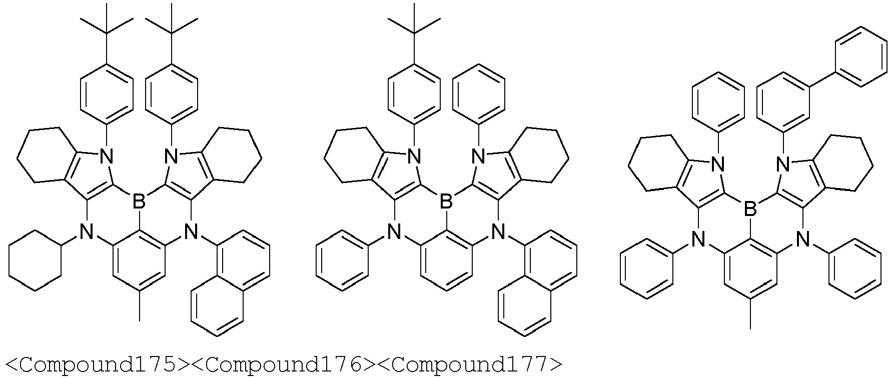

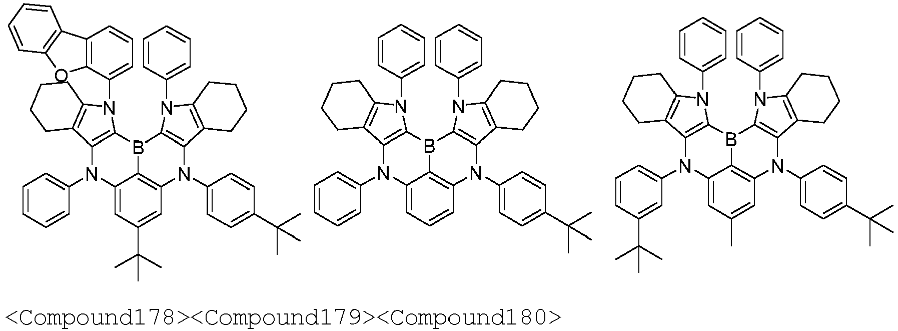

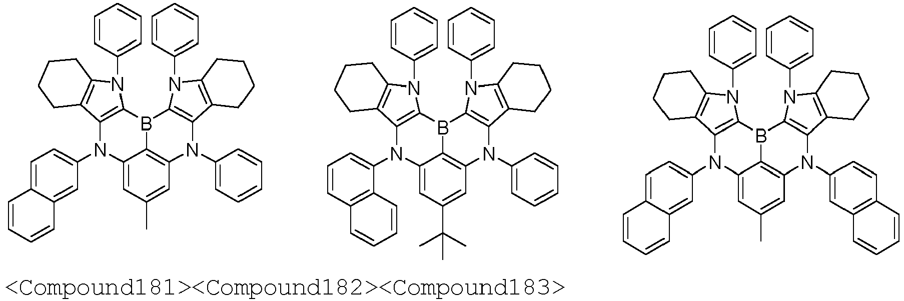

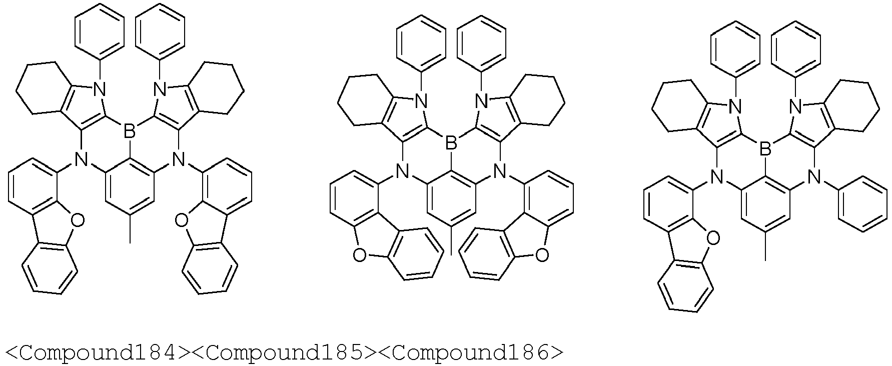

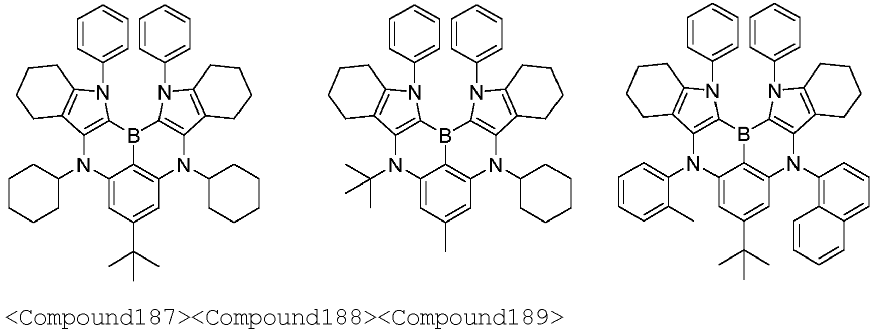

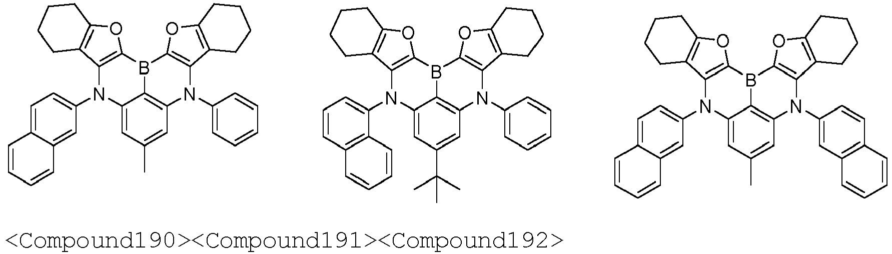

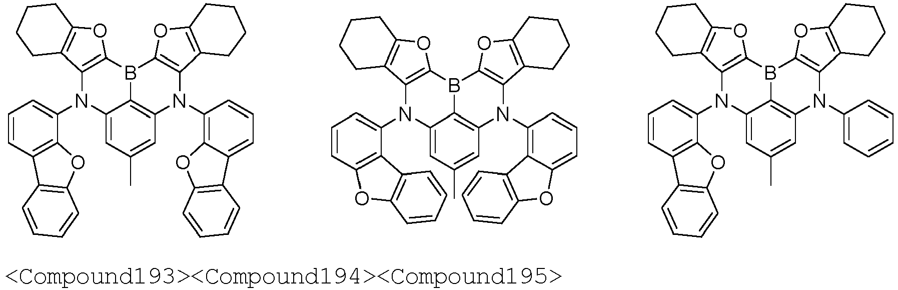

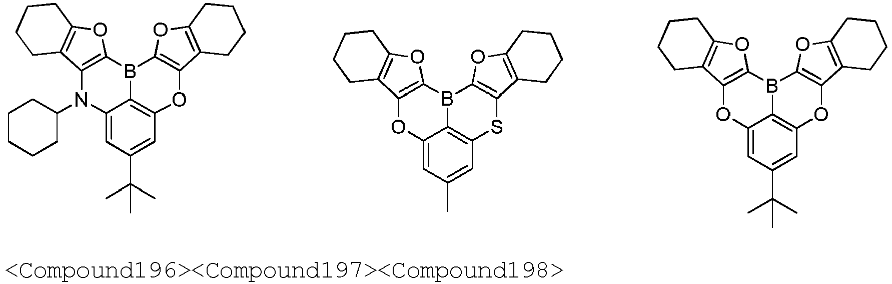

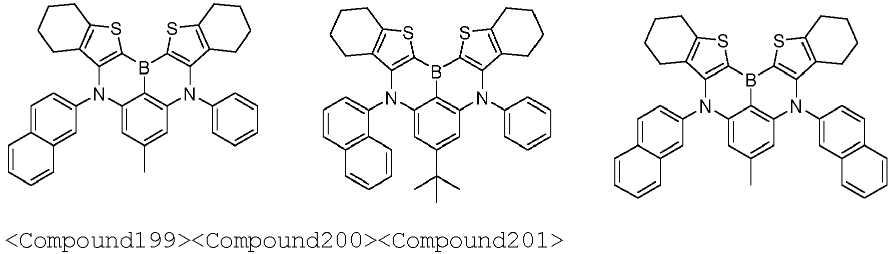

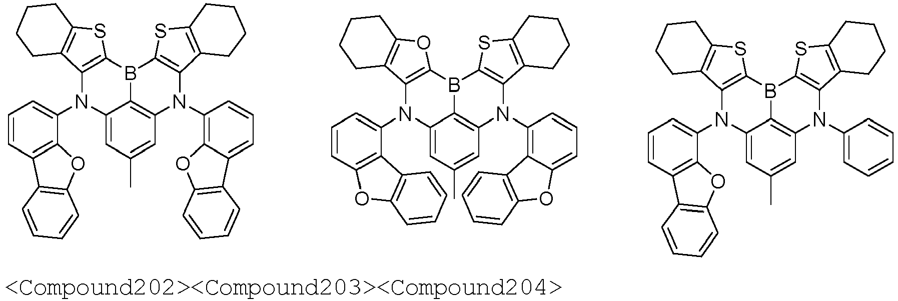

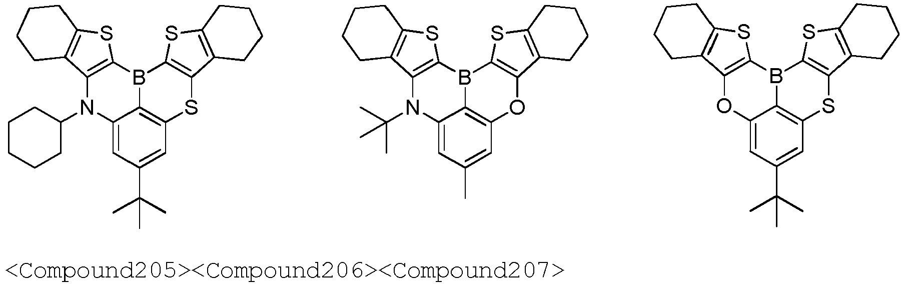

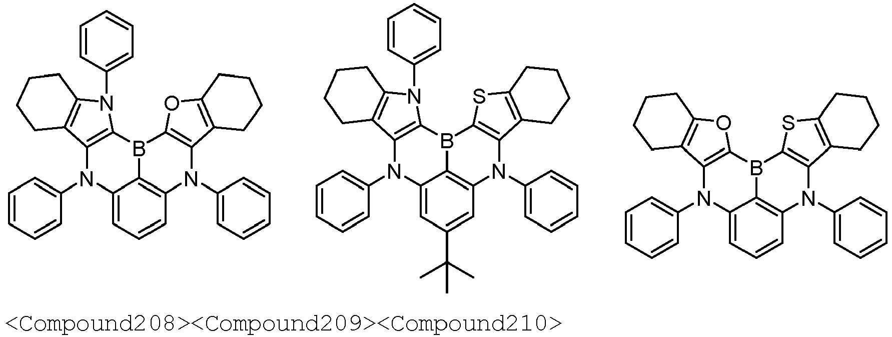

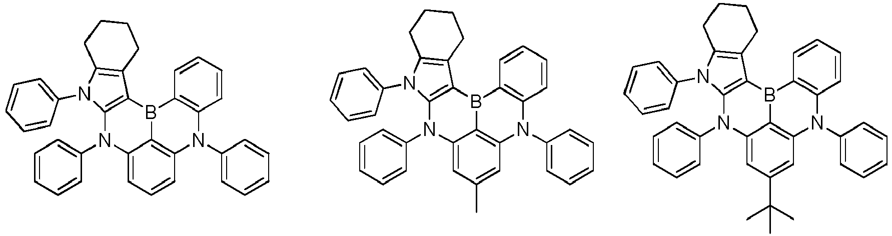

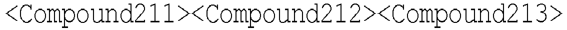

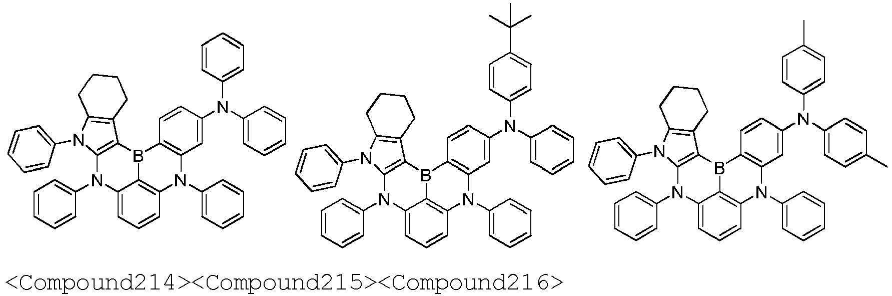

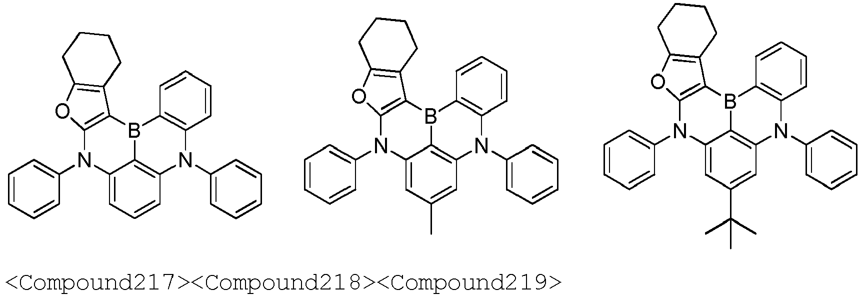

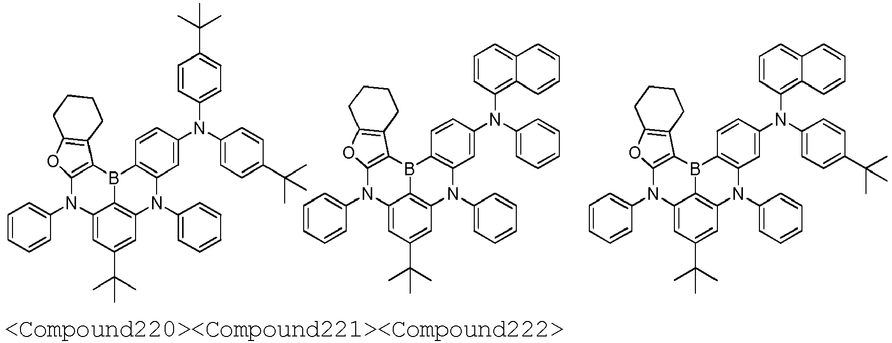

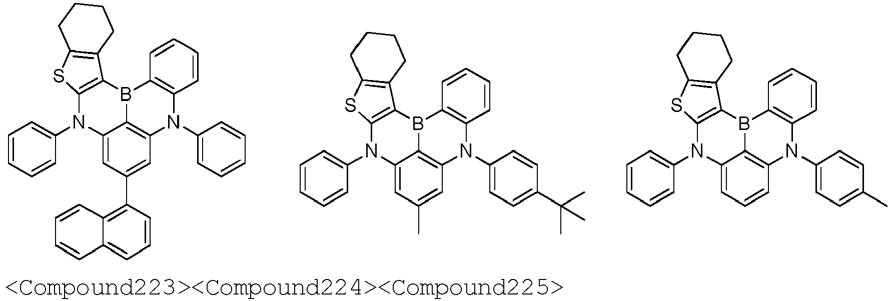

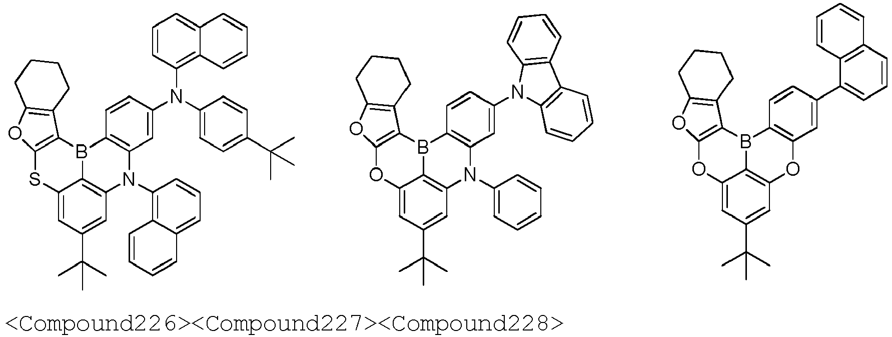

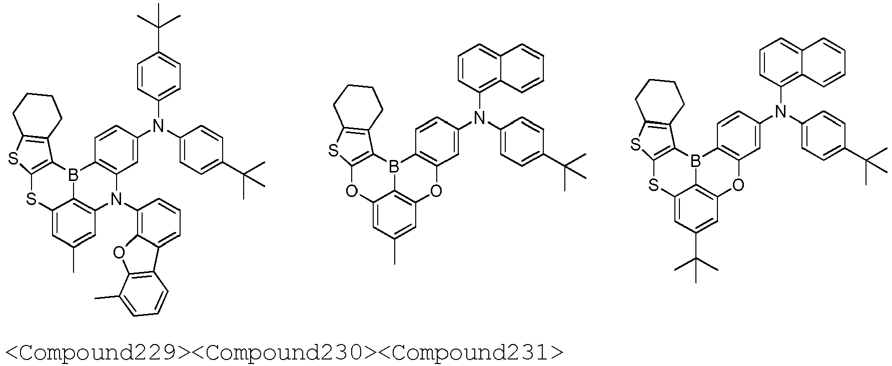

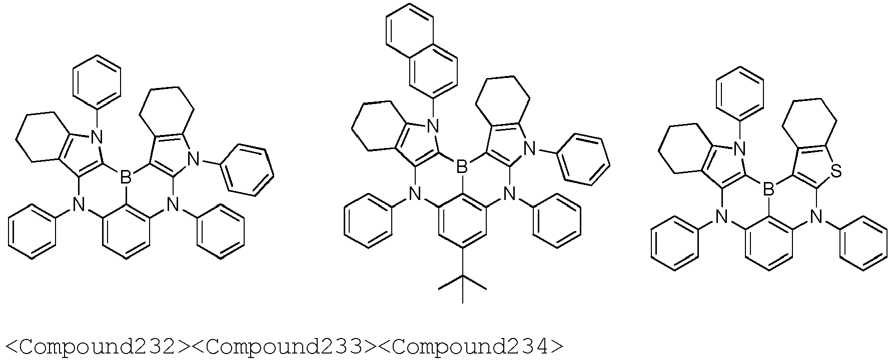

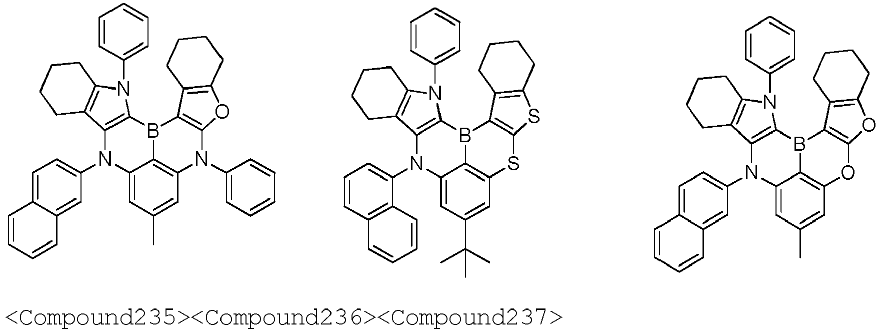

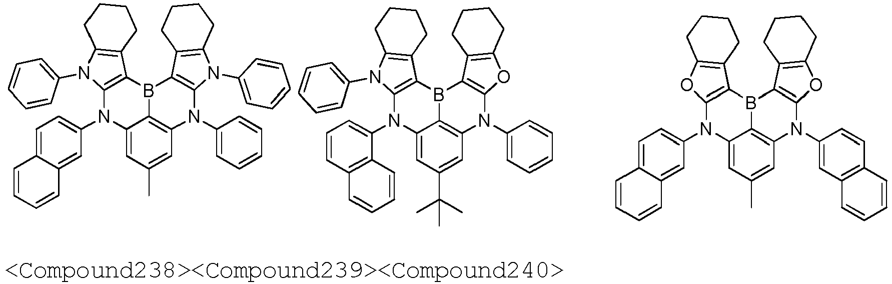

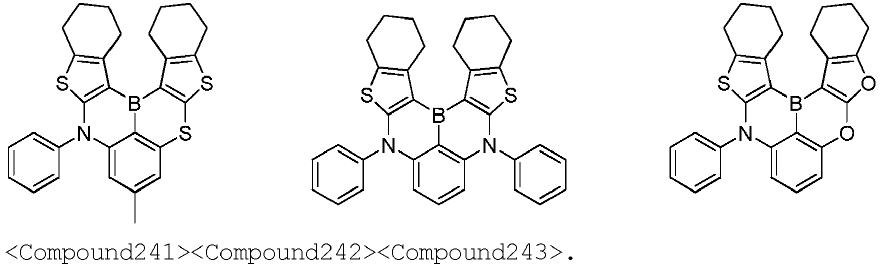

14. An organic light-emitting diode, comprising:
a first electrode;
a second electrode facing the second electrode; and
an organic layer interposed between the first electrode and the second electrode, wherein the organic layer includes a boron compound of any one of claims 1 to 13.

15. The organic light-emitting diode of claim 14, wherein the organic layer comprises at least one of a hole injection layer, a hole transport layer, a functional layer capable of both hole injection and hole transport, an electron blocking layer, a light-emitting layer, an electron transport layer, an electron injection layer, and a capping layer.

16. The organic light-emitting diode of claim 14, wherein the organic layer disposed between the first electrode and the second electrode includes a light-emitting layer composed of a host and a dopant, the boron compound represented by any one of Chemical Formulas A to E servings as the dopant.

17. The organic light-emitting diode of claim 16, wherein the light-emitting layer uses an anthracene derivative represented by the following Chemical Formula F as the host: 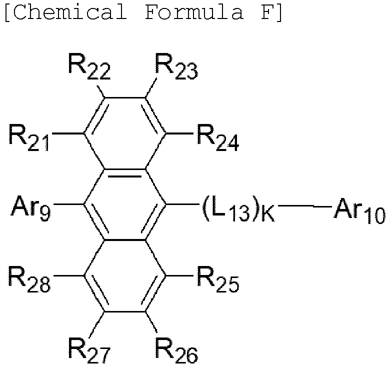 wherein,
R₂₁ to R₂₈, which are same or different, are each as defined for R₁ to R₈ in claim 1;
Ar₉ and Ar₁₀, which are same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl 2 to 20 carbon atoms, a substituted or unsubstituted cycloalkyl of 3 to 30 carbon atoms, a substituted or unsubstituted cycloalkenyl 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted alkoxy of 1 to 30 carbon atoms, a substituted or unsubstituted aryloxy of 6 to 30 carbon atoms, a substituted or unsubstituted alkylthio of 1 to 30 carbon atoms, a substituted or unsubstituted arylthioxy of 6 to 30 carbon atoms, a substituted or unsubstituted alkylamine of 1 to 30 carbon atoms, a diarylamino of 12 to 24 carbon atoms, a diheteroarylamino of 2 to 24 carbon atoms, an aryl(heteroaryl)amino of 7 to 24 carbon atoms, a substituted or unsubstituted alkylsilyl of 1 to 30 carbon atoms, and a substituted or unsubstituted arylsilyl of 6 to 30 carbon atoms;
L₁₃, which functions as a linker, is a single bond or is selected from a substituted or unsubstituted arylene of 6 to 20 carbon atoms, and a substituted or unsubstituted heteroarylene of 2 to 20 carbon atoms; and
k is an integer of 1 to 3, wherein when k is 2 or greater, the corresponding L₁₃'s are same or different.

18. The organic light-emitting diode of claim 15, wherein at least one selected from among the layers is deposited using a single-molecule deposition process or a solution process.

19. The organic light-emitting diode of claim 14, wherein the organic light-emitting diode is used for a device selected from among a flat display device; a flexible display device; a monochrome or grayscale flat illumination; and a monochrome or grayscale flexible illumination.
